(19) Europäisches Patentamt
European Patent Office
Office européen des brevets

(11) EP 4 063 953 A1

(12) **EUROPEAN PATENT APPLICATION**
published in accordance with Art. 153(4) EPC

(43) Date of publication:
**28.09.2022 Bulletin 2022/39**

(21) Application number: **20889625.8**

(22) Date of filing: **18.11.2020**

(51) International Patent Classification (IPC):
***G03F 7/004*** (2006.01) ***G03F 7/027*** (2006.01)
***G03F 7/028*** (2006.01) ***G03F 7/038*** (2006.01)
***G03F 7/20*** (2006.01) ***G03F 7/40*** (2006.01)

(52) Cooperative Patent Classification (CPC):
**G03F 7/004; G03F 7/027; G03F 7/028; G03F 7/038; G03F 7/20; G03F 7/40**

(86) International application number:
**PCT/JP2020/043021**

(87) International publication number:
**WO 2021/100768 (27.05.2021 Gazette 2021/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **21.11.2019 JP 2019210748**

(71) Applicant: **FUJIFILM Corporation**
**Tokyo 106-8620 (JP)**

(72) Inventors:
- **INOUE Kazuomi**
  **Haibara-gun, Shizuoka 421-0396 (JP)**
- **SHIMADA Kazuto**
  **Haibara-gun, Shizuoka 421-0396 (JP)**
- **ENOMOTO Yuichiro**
  **Haibara-gun, Shizuoka 421-0396 (JP)**
- **SATO Naoki**
  **Haibara-gun, Shizuoka 421-0396 (JP)**

(74) Representative: **HGF**
**HGF Limited**
**1 City Walk**
**Leeds LS11 9DX (GB)**

# (54) PATTERN FORMING METHOD, PHOTOCURABLE RESIN COMPOSITION, LAYERED BODY MANUFACTURING METHOD, AND ELECTRONIC DEVICE MANUFACTURING METHOD

(57) There is provided a pattern forming method including a first exposure step of exposing a part of a photocurable film formed from a photocurable resin composition; a development step of developing the photocurable film after the exposure with the developer to obtain a developed pattern; and a second exposure step of exposing the developed pattern to obtain a pattern, in which the photocurable resin composition has a specific composition. There are also provided a photocurable resin composition that is used in the pattern forming method, a method of manufacturing a laminate including the pattern forming method, and a method of manufacturing an electronic device including the pattern forming method, or a photocurable resin composition.

EP 4 063 953 A1

## Description

## BACKGROUND OF THE INVENTION

1. Field of the Invention

The present invention relates to a pattern forming method, a photocurable resin composition, a method of manufacturing laminate, and a method of manufacturing an electronic device.

2. Description of the Related Art

Resins such as polyimide and polybenzoxazole are applied to various use applications since they have excellent heat resistance and insulating properties. The above use applications are not particularly limited, and examples thereof in the electronic device for mounting include using a pattern containing such a resin as a material for an insulating film or a sealing material, or as a protective film. In addition, a pattern containing such a resin can also be used as a base film or a cover lay for a flexible substrate.

For example, in the above-described use applications, a resin such as a polyimide or a polybenzoxazole is used in the form of a photocurable resin composition containing this resin.

Such a photocurable resin composition is applied onto a base material by coating or the like, and then, as necessary, subjected to exposure, development, or heating, whereby a cured resin can be formed on the base material.

Since the photocurable resin composition can be applied by a known coating method or the like, it can be said that the photocurable resin composition is excellent in the manufacturing adaptability, for example, a high degree of freedom in designing the shape, size, application position of the photocurable resin composition to be applied. From the viewpoint of the excellent manufacturing adaptability described above in addition to the high performance of polyimide, polybenzoxazole, and the like, the industrial application spreading of photocurable resin compositions containing such a resin is expected increasingly.

For example, JP2006-189591A discloses a photosensitive resin composition containing a polyimide precursor having a specific structure, a photobase generator that generates a base by irradiation with an actinic ray, and a solvent, where the photosensitive resin composition is characterized in that the photobase generator generates a secondary amine having at least one substituent at the $\alpha$-position is by irradiation with an actinic ray.

## SUMMARY OF THE INVENTION

In the related art, a pattern has been obtained by applying a photocurable resin composition containing polyimide or polybenzoxazole onto a base material, forming a developed pattern by exposure development, and then carrying out heating.

By the way, the pattern after heating may shrink with respect to the developed pattern that is obtained after development.

An object of the present invention is to provide a pattern forming method by which shrinkage of a pattern to be formed is suppressed, a photocurable resin composition that is used in the pattern forming method, a method of manufacturing a laminate including the pattern forming method, and a method of manufacturing an electronic device including the pattern forming method.

Further, another object of the present invention is to provide a novel photocurable resin composition.

Examples of representative aspects of the present invention are described below.

<1> A pattern forming method comprising:

a first exposure step of exposing a part of a photocurable film formed from a photocurable resin composition;
a development step of developing the photocurable film after the exposure with a developer to obtain a developed pattern; and
a second exposure step of exposing the developed pattern to obtain a pattern,
in which the photocurable resin composition contains
at least one resin selected from the group consisting of a polyimide precursor and a polybenzoxazole precursor,
a photosensitive compound A having sensitivity to an exposure wavelength in the first exposure step, and
a photosensitive compound B having sensitivity to an exposure wavelength in the second exposure step, and
the photosensitive compound A is a compound that changes a solubility of the photocurable film in the developer in the first exposure step, and
at least one in the group consisting of the photosensitive compound A and the photosensitive compound B is

a photobase generator.

<2> The pattern forming method according to <1>, in which the photosensitive compound A is a compound that generates a radical in the first exposure step.
<3> The pattern forming method according to <1> or <2>, in which the photosensitive compound A is a compound that generates an acid in the first exposure step.
<4> The pattern forming method according to any one of <1> to <3>, in which the photosensitive compound B is a compound that generates a base in the second exposure step.
<5> The pattern forming method according to any one of <1> to <4>, in which the second exposure step includes exposure with light including light having a wavelength different from a wavelength of light used in the first exposure step.
<6> The pattern forming method according to any one of <1> to <5>, in which a temperature in the second exposure step is 50°C to 200°C.
<7> A photocurable resin composition, wherein the photocurable resin composition is used in the pattern forming method according to any one of <1> to <6>.
<8> A photocurable resin composition comprising:

at least one resin selected from the group consisting of a polyimide precursor and a polybenzoxazole precursor;
a photosensitive compound A; and
a photosensitive compound B,
in which the photosensitive compound A is a compound capable of changing a solubility of the resin by photosensitization,
at least one in the group consisting of the photosensitive compound A and the photosensitive compound B is a photobase generator, and
a difference between a maximal absorption wavelength of the photosensitive compound A and a maximal absorption wavelength of the photosensitive compound B is 100 nm or more.

<9> A method of manufacturing a laminate, comprising the pattern forming method according to any one of <1> to <6>.
<10> A method of manufacturing an electronic device, comprising:

the pattern forming method according to any one of <1> to <6>; or
the method of manufacturing a laminate according to <9>.

According to the present invention, there are provided a pattern forming method by which shrinkage of a pattern to be formed is suppressed, a photocurable resin composition that is used in the pattern forming method, a method of manufacturing a laminate including the pattern forming method, and a method of manufacturing an electronic device including the pattern forming method.
Further, according to the present invention, a novel photocurable resin composition is provided.

## DESCRIPTION OF THE PREFERRED EMBODIMENTS

Hereinafter, the main embodiments of the present invention will be described. However, the present invention is not limited to the specified embodiments.
In the present specification, a numerical range described by using "to" means a range including numerical values described before and after the preposition "to" as a lower limit value and an upper limit value, respectively.
In the present specification, the term "step" means not only an independent step but also a step that cannot be clearly distinguished from other steps as long as the desired action of the step can be achieved.
In describing a group (an atomic group) in the present specification, in a case where a description about substitution and non-substitution is not provided, the description means the group includes a group (an atomic group) having a substituent as well as a group (an atomic group) having no substituent. For example, the "alkyl group" includes not only an alkyl group that does not have a substituent (an unsubstituted alkyl group) but also an alkyl group that has a substituent (a substituted alkyl group).
In the present specification, the "exposure" includes not only exposure using light but also exposure using particle beams such as an electron beam and an ion beam, unless otherwise specified. In addition, examples of the light that is used for exposure include an actinic ray such as an emission line spectrum of a mercury lamp, a far ultraviolet ray represented by an excimer laser, an extreme ultraviolet ray (an EUV ray), an X-ray, or an electron beam, and a radioactive ray.
In the present specification, "(meth)acrylate" means one or both of "acrylate" and "methacrylate", "(meth)acryl"

means one or both of "acryl" and "methacryl", and "(meth)acryloyl" means one or both of "acryloyl" and "methacryloyl".

In the structural formulae of the present specification, Me represents a methyl group, Et represents an ethyl group, Bu represents a butyl group, and Ph represents a phenyl group.

In the present specification, the total solid content refers to the total mass of components excluding a solvent from the entire components of the composition. In addition, in the present specification, the solid content concentration is a mass percentage of other components excluding a solvent with respect to the total mass of the composition.

In the present specification, weight-average molecular weight (Mw) and number-average molecular weight (Mn) are defined as polystyrene equivalent values according to gel permeation chromatography (GPC) measurement unless otherwise specified. In the present specification, the weight-average molecular weight (Mw) and the number-average molecular weight (Mn) can be determined, for example, by using HLC-8220 GPC(manufactured by Tosoh Corporation) and using, as a column, GUARD COLUMN HZ-L, TSKgel Super HZM-M, TSK gel Super HZ4000, TSK gel Super HZ3000, and TSK gel Super HZ2000 (manufactured by Tosoh Corporation). The measurements of the above molecular weights are carried out using tetrahydrofuran (THF) as an eluent unless otherwise specified. In addition, the detection in GPC measurement is carried out using a detector with an ultraviolet ray (a UV ray) of a wavelength of 254 nm unless otherwise specified.

However, N-methyl-2-pyrrolidone (NMP) can also be used in a case where THF is not suitable as the eluent, for example, in a case where the solubility is low. In addition, the detection in GPC measurement is carried out using a detector with an ultraviolet ray (a UV ray) of a wavelength of 254 nm unless otherwise specified.

In the present specification, in a case where the positional relationship of respective layers constituting the laminate is described as "upper" or "lower", another layer may be on the upper side or the lower side of the reference layer among the plurality of layers of interest. That is, a third layer or element may be further interposed between the reference layer and the other layer, and the reference layer and the other layer need not be in contact with each other. In addition, unless otherwise specified, the direction in which the layers are laminated on the base material is referred to as "upward", or in a case where a photocurable film is present, the direction from the base material to the photocurable film is referred to as "upper". The opposite direction thereof is referred to as "downward". Furthermore, such setting of upward and downward directions is for convenience in the present specification, and in a practical aspect, the "upward" direction in the present specification may be different from a vertically upward direction.

In the present specification, a composition may contain, as each component contained in the composition, two or more compounds corresponding to the component unless otherwise particularly specified. The content of each component in the composition means the total content of all the compounds corresponding to the component unless otherwise particularly specified.

In the present specification, unless otherwise specified, the temperature is 23°C, the atmospheric pressure is 101,325 Pa (1 atm), and the relative humidity is 50%RH.

In addition, in the present specification, a combination of preferred aspects is a more preferred aspect.

(Pattern Forming Method)

A pattern forming method according to the embodiment of the present invention includes a first exposure step of exposing a part of a photocurable film formed from a photocurable resin composition; a development step of developing the photocurable film after the exposure with the developer to obtain a developed pattern; and a second exposure step of exposing the developed pattern to obtain a pattern, in which the photocurable resin composition contains at least one resin selected from the group consisting of a polyimide precursor and a polybenzoxazole precursor, a photosensitive compound A having sensitivity to an exposure wavelength in the first exposure step, and a photosensitive compound B having sensitivity to an exposure wavelength in the second exposure step, where the photosensitive compound A is a compound that changes a solubility of the photocurable film in the developer in the first exposure step, and at least one in the group consisting of the photosensitive compound A and the photosensitive compound B is a photobase generator.

Hereinafter, at least one resin selected from the group consisting of a polyimide precursor and a polybenzoxazole precursor is also referred to as a "specific resin".

According to the pattern forming method according to the embodiment of the present invention, the shrinkage of the pattern to be obtained is suppressed with respect to the developed pattern.

The mechanism by which the above effect is obtained is unknown; however, it is presumed as follows.

In the pattern forming method in the related art, the cyclization of the above precursor has been carried out, for example, by subjecting a film consisting of a photocurable resin composition containing a precursor such as a polyimide precursor or a polybenzoxazole precursor to one time of exposure, subsequently developing the exposed film to form a developing pattern, and then heating the formed developed pattern.

Further, JP2006-189591A discloses a method of obtaining a pattern by subjecting a film consisting of a composition containing, in addition to the above precursor, a photopolymerization initiator and a photobase generator to one time of exposure, photosensitizing both the photopolymerization initiator and the photobase generator, and then carrying

out heating and development to cyclize the precursor.

The inventors of the present invention found that in a case where a developed pattern is subjected to one time of exposure as described above and then cyclization due to heating is carried out, the film shrinkage may occur before and/or after heating.

Then, the inventors of the present invention have found that in a case of subjecting a photosensitive film formed from two kinds of photosensitive compounds, at least one of which is a photobase generator, to a first exposure step, a development step, and a second exposure step in order so that the curing by the photobase generator and the chemical changes by the photoacid generator, the radical polymerization initiator, and the like were carried out different exposures, that shrinkage before and/or after cyclization of the pattern to be obtained is suppressed, and completed the present invention.

This is presumed to be because at least two times of exposure in total, one time of exposure for cyclization of the specific resin by a photobase generator and one time of exposure for the above-described chemical changes, are carried, and thus the cyclization of the specific resin proceeds by at least one time of exposure among the two times of exposure. It is presumed that shrinkage due to heating is suppressed since the shrinkage due to heating does not occur, for example, in a case of an aspect in which heating is not carried out after the second exposure step, and the cyclization has already occurred in the film even in a case of an aspect in which heating is carried out after the second exposure step. In a case of an aspect in which heating is carried out after the second exposure step, the shrinkage of the pattern due to heating can also be suppressed by setting the heating temperature at the time of heating to lower temperature as compared with a case of curing the pattern only by heating.

According to the pattern forming method according to the embodiment of the present invention, it is presumed that the deformation, for example, the warping of the pattern may be suppressed by suppressing pattern shrinkage.

The photocurable film that is used in the pattern forming method according to the embodiment of the present invention may be a negative type photocurable film or a positive type photocurable film.

The positive type photocurable film refers to a photocurable film in which parts (exposed portions) exposed in the first exposure step are removed by the developer, and the negative type photocurable film refers to a photocurable film in which parts (unexposed portions) unexposed in the first exposure step are removed by the developer.

Here, in a case where the photocurable film is a negative type photocurable film and crosslinking of a crosslinking agent described later is carried out in the first exposure step, the crosslinking reaction of the crosslinking agent is difficult to be inhibited by the cyclization as compared with a case where the crosslinking of the crosslinking agent and the cyclization of the specific resin are simultaneously carried out by one time of exposure, for example, as described in JP2006-189591A described above, and thus it is presumed that there is an advantageous effect the final crosslinking density in the pattern is increased. A pattern having such a high crosslinking density is conceived to be excellent in chemical resistance, for example, since it is difficult for the chemical liquid to permeate.

Specifically, it is conceived that it is possible to obtain a pattern in which the solubility or dispersibility in a polar solvent such as dimethyl sulfoxide (DMSO) or N-methylpyrrolidone (NMP), an alkaline aqueous solution such as a tetramethylammonium hydroxide (TMAH) aqueous solution, or a mixed solution of the polar solvent and the alkaline aqueous solution is suppressed.

As described above, since the pattern has excellent chemical resistance, it is conceived there are advantages that the dissolution of the pattern is suppressed even in a case where the pattern is in contact with a developer or the other composition, and that the dissolution, dispersion, or modification of the pattern is suppressed even in a case where the pattern is used under the conditions in which the pattern is in contact with a chemical such as a solvent or in an atmosphere in which a chemical such as a solvent is present, for example, in a case where another composition containing a solvent is further applied and cured onto the pattern formed by the pattern forming method according to the embodiment of the present invention to prepare a laminate.

Further, in a case where the photocurable film is a positive type photocurable film, it is not possible to carry out pattern formation since the precursor is cyclized in an aspect in which a photobase generator and another photosensitive compound are simultaneously exposed, for example, as described in JP2006-189591A described above. That is, according to the aspect of the present invention, it is possible to form a positive type pattern.

Further, it suffices that the pattern forming method according to the embodiment of the present invention includes at least the first exposure step, the development step, and the second exposure step in the above order. For example, the pattern forming method according to the embodiment of the present invention shall also include aspects such as an aspect in which the first exposure step is carried out a plurality of times before the development step, an aspect in which exposure (for example, entire surface exposure) with the same light source as that in the first exposure step is further carried out during the second exposure step after the development step, or after the second exposure step, and an aspect in which the second exposure step is carried out a plurality of times after the development step.

Hereinafter, the pattern forming method of the embodiment of the present invention will be described in detail.

«First exposure step»

The pattern forming method according to the embodiment of the present invention includes a first exposure step of exposing a part of a photocurable film formed from a photocurable resin composition.
In the first exposure step, the photosensitive compound A is photosensitized, and the solubility of the photocurable film in a developer is changed.
Specifically, for example, in a case where the photosensitive compound A is a photopolymerization initiator or a photoacid generator described later, and in a case where the specific resin contains a crosslinkable group or the photocurable film contains a crosslinking agent, or the specific resin contains a crosslinkable group and the photocurable film contains a crosslinking agent, crosslinking proceeds in the photocurable film, and the solubility of the photocurable film in the developer after the first exposure step is decreased.
For example, in a case where the photosensitive compound A is a photoacid generator described later and the developer is an alkaline developer described later, an acid is generated in the photocurable film and, the solubility thereof in the developer is increased.
For example, in a case where the photosensitive compound A is a photoacid generator described later and the developer is an organic solvent described later, an acid is generated in the photocurable film and, the solubility thereof in the developer is decreased.
For example, in a case where the photosensitive compound A is a photobase generator described later, the cyclization of the specific resin proceeds in the photocurable film, and the solubility in the developer is decreased.
In this manner, in the first exposure step, the solubility of the photocurable film in the developer may be changed by the promotion of the bonding reaction between the crosslinkable group contained in the specific resin or the crosslinking agent and another group, for example, due to the photosensitization of the photosensitive compound A, or the solubility of the photocurable film in the developer may be changed by the product generated by the chemical change due to the photosensitization of the photosensitive compound A, and the solubility of the photocurable film in the developer may change due to the cyclization of the specific resin.
The exposure wavelength in the first exposure step may be appropriately set as a wavelength at which the photosensitive compound A described later has sensitivity; however, it is preferably 190 to 1,000 nm, more preferably 200 to 550 nm, and still more preferably 200 to 450 nm.
Examples of the exposure wavelength, which are mentioned in relation to the light source, include (1) a semiconductor laser (wavelength: 830 nm, 532 nm, 488 nm, 405 nm, or the like); (2) a metal halide lamp; (3) a high-pressure mercury lamp, a g-line (wavelength: 436 nm), an h-line (wavelength: 405 nm), an i-line (wavelength: 365 nm), or broad (three wavelengths of the g-line, the h-line, and the i-line); (4) an excimer laser, a KrF excimer laser (wavelength: 248 nm), an ArF excimer laser (wavelength: 193 nm), or an F2 excimer laser (wavelength: 157 nm); (5) an extreme ultraviolet (EUV) ray (wavelength: 13.6 nm); and (6) an electron beam.
Among these, the light source in the first exposure step is preferably an excimer laser, an i-line, or an h-line. In this case, particularly high exposure sensitivity can be obtained.
In a case where the maximal absorption wavelengths of the photosensitive compound A and the photosensitive compound B are different from each other, an optical filter or the like that removes a specific wavelength from these light sources may be used in order to suppress the photosensitization of the photosensitive compound B.
Examples of the method of exposing a part of a photocurable film in the first exposure step include an exposure method using a known photomask and an exposure method of exposing a part of a photocurable film with laser exposure or the like.
In the pattern forming method according to the embodiment of the present invention, the exposure amount in the first exposure step is preferably 100 to 10,000 mJ/$cm^2$ and more preferably 200 to 8,000 mJ/$cm^2$ in terms of exposure energy at the wavelength at which the photosensitive compound A has a sensitivity.

<Heating step after exposure>

The pattern forming method according to the embodiment of the present invention may include a step of heating the photocurable film after the exposure (a heating step after the exposure) after the first exposure step and before the development step.
The heating temperature in the heating step after the exposure is preferably 50°C to 140°C and more preferably 60°C to 120°C.
The heating time in the heating step after the exposure is preferably 1 minute to 300 minutes and more preferably 5 minutes to 120 minutes.
In the heating step after the exposure, the temperature elevation rate from the temperature at the start of heating to the maximum heating temperature is preferably 1 to 12 °C/min, more preferably 2 to 10 °C/min, and still more preferably 3 to 10 °C/min.

In addition, the temperature elevation rate may be appropriately changed during heating.
The heating unit in the heating step after the exposure is not particularly limited, and a known hot plate, oven, infrared heater, or the like can be used.
In addition, it is also preferable to carry out the heating in an atmosphere having a low oxygen concentration by allowing an inert gas such as nitrogen, helium, argon, or the like to flow.

<Film forming step>

The pattern forming method according to the embodiment of the present invention may include a film forming step of forming a photocurable film from a photocurable resin composition.
The photocurable film in the first exposure step may be a photocurable film formed in the film forming step or may be a photocurable film obtained by means such as a purchase.
The film forming step is preferably a step of applying a photocurable resin composition onto a base material to form a (layered) film to obtain a photocurable film.

<Preparation of resin composition>

The resin composition according to the embodiment of the present invention can be prepared by mixing the above-described components. The mixing method is not particularly limited, and mixing can be carried out by methods conventionally known in the related art.
For mixing, it is possible to employ mixing with a stirring blade, mixing with a ball mill, mixing by rotating the tank itself, or the like.
The temperature during the mixing is preferably 10°C to 30°C, and more preferably 15°C to 25°C.
In addition, for the intended purpose of removing foreign substances such as dust and fine particles in the resin composition according to the embodiment of the present invention, it is preferable to carry out filtration using a filter. Examples of the pore diameter of the filter include, for example, an aspect of 5 μm or less, and the pore diameter thereof is preferably 1 μm or less, more preferably 0.5 μm or less, and still more preferably 0.1 μm or less. The material of the filter is preferably polytetrafluoroethylene, polyethylene, or nylon. In a case where the material of the filter is polyethylene, it is more preferable to use high density polyethylene (HDPE). As the filter, a filter which has been washed with an organic solvent in advance may be used. In the filtration step using the filter, a plurality of kinds of filters may be connected in series or in parallel and used. In a case where a plurality of kinds of filters are used, filters having different pore sizes or different materials may be used in combination. Examples of the connection aspect include an aspect in which an HDPE filter having a pore diameter of 1 μm is connected in series as the first stage and an HDPE filter having a pore diameter of 0.2 μm is connected in series as the second stage. In addition, various materials may be filtered a plurality of times. In a case of being filtered a plurality of times, circulation filtration may be used. In addition, filtration may be carried out under pressure. In a case where filtration is carried out under pressure, an aspect in which the pressure to be applied is, for example, 0.01 MPa or more and 1.0 MPa or less is mentioned, and the pressure is preferably 0.03 MPa or more and 0.9 MPa or less, more preferably 0.05 MPa or more and 0.7 MPa or less, and still more preferably 0.05 MPa or more and 0.5 MPa or less.
In addition to filtration using a filter, impurity removal treatment using an adsorption material may be carried out. The filtration using a filter and the impurity removal treatment using an adsorption material may be combined. As the adsorption material, a conventionally known adsorption material can be used. Examples thereof include an inorganic adsorption material such as silica gel and zeolite and an organic adsorption material such as activated carbon.
Furthermore, after filtration using a filter, a step of placing a bottle filled with the resin composition under reduced pressure to carry out degassing may be provided.

[Base material]

The kind of base material can be appropriately determined depending on the use application, and examples thereof are a base material for semiconductor manufacturing, such as silicon, silicon nitride, polysilicon, silicon oxide, or amorphous silicon, quartz, glass, an optical film, a ceramic material, a vapor-deposited film, a magnetic film, a reflective film, metal base materials such as Ni, Cu, Cr, and Fe, paper, spin-on-glass (SOG), a thin film transistor (TFT) array base material, and an electrode plate of a plasma display panel (PDP), and are not particularly limited thereto. In the present invention, in particular, a base material for semiconductor manufacturing is preferable, and a silicon base material is more preferable.
Further, a layer such as an adhesion layer or an oxide layer may be provided on the surface of these base materials.
Further, as the base material, for example, a plate-shaped base material (substrate) is used.

In addition, the shape of the base material is not particularly limited, and it may be a circular shape (a disk shape) or a rectangular shape (a rectangular plate shape).
Regarding the size of the base material, for example in a case of a circular shape, the diameter thereof is 100 to 450 mm and preferably 200 to 450 mm. In a case where the shape is rectangular, for example, the length of the short side is 100 to 1,000 mm and preferably 200 to 700 mm.
In a case where the photocurable film is formed on a surface of a resin layer or a surface of the metal layer, the resin layer or the metal layer is the base material.
The means for applying a photocurable resin composition to a base material is preferably coating.
Specifically, as means for application, a dip coating method, an air knife coating method, a curtain coating method, a wire bar coating method, a gravure coating method, an extrusion coating method, a spray coating method, a spin coating method, a slit coating method, and an inkjet method are exemplified. From the viewpoint of uniformity of the thickness of the photocurable film, the spin coating method, the slit coating method, the spray coating method, or the inkjet method is more preferable, and from the viewpoint that the effects of the present invention are easily obtained, the slit coating method is preferable. A photocurable film having a desired thickness can be obtained by appropriately adjusting the solid content concentration and application conditions according to the method. In addition, the coating method can be appropriately selected depending on the shape of the base material. In a case where a circular base material such as a wafer is used, the spin coating method, the spray coating method, the inkjet method, and the like are preferable, and in a case where a rectangular base material is used, the slit coating method, the spray coating method, the inkjet method, and the like are preferable. For example, the spin coating method can be applied at a rotation speed of 500 to 2,000 rpm for about 10 seconds to 1 minute.
In addition, it is also possible to apply a method of transferring a coating film formed in advance on a temporary support by the above-described coating method, onto a base material.
Regarding the transfer method, the production methods disclosed in paragraphs 0023, and 0036 to 0051 of JP2006-023696A and paragraphs 0096 to 0108 of JP2006-047592A can also be suitably used in the present invention.
In addition, a step of removing an unnecessary film at the edge of the base material may be carried out. Examples of such a step include edge bead rinsing (EBR) and air knifing.

<Drying Step>

The pattern forming method according to the embodiment of the present invention may include a step (a drying step) of drying the film (or the layer) formed for removing the solvent, after the film forming step (the layer forming step).
The preferred drying temperature is 50°C to 150°C, more preferably 70°C to 130°C, and still more preferably 90°C to 110°C. Examples of the drying time include 30 seconds to 20 minutes, and the drying time is preferably 1 minute to 10 minutes and more preferably 3 minutes to 7 minutes.

<Development Step>

The pattern forming method according to the embodiment of the present invention includes a development step of developing the photocurable film after the first exposure step with a developer to obtain a developed pattern.
By the development, either exposed portions or unexposed portions are removed. The developing method is not particularly limited as long as a desired pattern can be formed, and examples thereof include ejecting from a nozzle, carrying out spraying, and immersing of a base material in a developer, and ejecting from a nozzle is preferably used. In the development step, a step of continuously supplying a developer to a base material, a step of keeping a developer in a substantially stationary state on a base material, a step of vibrating a developer by ultrasonic waves or the like, and a step obtained by combining these steps can be adopted.
Development is carried out using a developer. As the developer, one with which unexposed parts (unexposed portions) are removed in a case of negative type development can be used and one with which exposed parts (exposed portions) are removed in a case of positive type development can be used without any particular limitation.
In the present invention, a case where an alkaline developer is used is as the developer is referred to as alkaline development, and a case where a developer containing 50% by mass or more of an organic solvent is used as the developer is referred to as solvent development.
In the alkaline development, the developer is preferably a developer in which the content of the organic solvent is 10% by mass or less, more preferably a developer in which the content thereof is 5% by mass or less, and still more preferably a developer in which the content thereof is 1% by mass or less, with respect to the total mass of the developer. It is particularly preferably a developer in which no organic solvent is contained.
The developer in the alkaline development is more preferably an aqueous solution having a pH of 10 to 15.
Examples of the alkaline compound contained in the developer in the alkaline development include sodium hydroxide, potassium hydroxide, sodium carbonate, potassium carbonate, sodium hydrogen carbonate, potassium hydrogen carbonate, sodium silicate, potassium silicate, sodium metasilicate, potassium metasilicate, ammonia, and an amine. Examples of the amine include ethylamine, n-propylamine, diethylamine, di-n-propylamine, triethylamine, methyldiethylamine, alkanolamine, dimethylethanolamine, triethanolamine, a quaternary ammonium hydroxide, a tetramethylammonium hydroxide (TMAH), and tetraethylammonium hydroxide. Among them, an alkaline compound containing no metal is preferable, and an ammonium compound is more preferable.

For, example, in a case where TMAH is used, the content of the basic compound in the developer is preferably 0.01% to 10% by mass, more preferably 0.1% to 5% by mass, and still more preferably 0.3% to 3% by mass in the total amount of the developer.

One kind of alkaline compound may be used, or two or more kinds thereof may be used. In a case where two or more kinds of alkaline compounds are used, the total thereof is preferably within the above-described range.

In solvent development, the developer more preferably contains 90% or more of an organic solvent. In the present invention, the developer preferably contains an organic solvent having a ClogP value of -1 to 5 and more preferably an organic solvent having a ClogP value of 0 to 3. The ClogP value can be determined as a calculated value by inputting a structural formula in ChemBioDraw.

Suitable examples of the organic solvent include esters such as ethyl acetate, n-butyl acetate, amyl formate, isoamyl acetate, isobutyl acetate, butyl propionate, isopropyl butyrate, ethyl butyrate, butyl butyrate, methyl lactate, ethyl lactate, γ-butyrolactone, ε-caprolactone, δ-valerolactone, an alkyl alkyloxyacetate (example: a methyl alkyloxyacetate, an ethyl alkyloxyacetate, and a butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (example: a methyl 3-alkyloxypropionate and an ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (example: a methyl 2-alkyloxypropionate, an ethyl 2-alkyloxypropionate, and a propyl 2-alkyl oxypropionate (for example, methyl 2-methoxypropionate, ethyl 2-methoxypropionate, propyl 2-methoxypropionate, methyl 2-ethoxypropionate, and ethyl 2-ethoxypropionate)), a methyl 2-alkyloxy-2-methylpropionate and an ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, and ethyl 2-oxobutanoate; ethers such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, and propylene glycol monopropyl ether acetate; ketones such as methyl ethyl ketone, cyclohexanone, cyclopentanone, 2-heptanone, 3-heptanone, and N-methyl-2-pyrrolidone; aromatic hydrocarbons such as toluene, xylene, anisole, and limonene; and sulfoxides such as dimethyl sulfoxide.

In the present invention, cyclopentanone or γ-butyrolactone is particularly preferable, and cyclopentanone is more preferable.

The development time is preferably 10 seconds to 5 minutes. The temperature of the developer at the time of development is not particularly limited, and the development can usually be carried out at 20°C to 40°C.

In the development step, rinsing may be further carried out after the treatment with the developer.

In the case of the solvent development, rinsing is preferably carried out with an organic solvent different from the developer.

In the case of the alkaline development, rinsing is preferably carried out using pure water.

The rinsing time is preferably 5 seconds to 1 minute.

«Second exposure step»

The pattern forming method according to the embodiment of the present invention includes a second exposure step of exposing the developed pattern to obtain a pattern.

In the second exposure step, the photosensitive compound B is photosensitized, and then a pattern is obtained.

For example, in a case where the photosensitive compound B is a photobase generator described later, the cyclization of the specific resin proceeds, and then a pattern is obtained.

For example, in a case where the photosensitive compound B is a photopolymerization initiator or a photoacid generator described later, and in a case where the specific resin contains a crosslinkable group or the photocurable film contains a crosslinking agent, or the specific resin contains a crosslinkable group and the photocurable film contains a crosslinking agent, crosslinking proceeds in the photocurable film, and then a pattern is obtained.

The second exposure step may be the exposure including only light having the same wavelength as the light used in the first exposure step; however, it preferably includes exposure with light including light having a wavelength different from the wavelength of the light used in the first exposure step.

That is, in the second exposure step, the photosensitive compound A may be photosensitized or may not be photosensitized.

For example, in a case where the first exposure step is carried out with an i-line (wavelength: 365 nm), the second exposure step may be carried out with the i-line; however, a method of carrying out the second exposure step by using a high-pressure mercury lamp (including exposure light of an i-line and other wavelengths) which includes broadband light or carrying out the second exposure step by using an h-line (405 nm).

In a case where the photocurable film is a negative type photocurable film, from the viewpoint of chemical resistance or the like of the pattern to be obtained, the exposure light in the second exposure step preferably includes light having a wavelength at which the photosensitive compound B is photosensitized, and more preferably includes light having a wavelength at which the photosensitive compound A and light having a wavelength different from the wavelength at which the photosensitive compound A is photosensitized.

For example, in a case where the photosensitive compound A is a photoradical polymerization initiator, the photosensitive compound B is a photobase generator, and the photosensitive compound A is photosensitized in addition to the photosensitive compound B in the second exposure step, not only the cyclization but also the radical polymerization further proceeds, and thus it is conceived that the chemical resistance of the pattern to be obtained are further improved.

As described above, in a case where the exposure light in the second exposure step further includes light having a wavelength by which the photosensitive compound A is photosensitized, a pattern having excellent film hardness and solvent resistance may be obtained.

Further, as one of the preferred aspects, for example, in a case where the photocurable film contains a crosslinking agent and the crosslinking of the crosslinking agent is carried out in the first exposure step, an aspect in which the crosslinking agent is not completely crosslinked in the first exposure step and the crosslinking of the crosslinking agent is further allowed to proceed by using the exposure light further including the light having a wave length at which the photosensitive compound A is photosensitized, in the second exposure step after development, is also mentioned.

The light having a wavelength at which the photosensitive compound B has a sensitivity and which is included in the exposure light in the second exposure step may be appropriately set in consideration of the sensitivity of photosensitive compound B described later; however, it is preferably 190 to 1,000 nm, more preferably 200 to 550 nm, and still more preferably 200 to 450 nm.

Examples of the exposure wavelength, which are mentioned in relation to the light source, include (1) a semiconductor laser (wavelength: 830 nm, 532 nm, 488 nm, 405 nm, or the like); (2) a metal halide lamp; (3) a high-pressure mercury lamp, a g-line (wavelength: 436 nm), an h-line (wavelength: 405 nm), an i-line (wavelength: 365 nm), or broadband light (light including light at least two wavelengths selected from the group consisting of three wavelengths of the g-line, the h-line, and the i-line, and light having a wavelength shorter than the i-line); (4) an excimer laser, a KrF excimer laser (wavelength: 248 nm), an ArF excimer laser (wavelength: 193 nm), or an F2 excimer laser (wavelength: 157 nm); (5) an extreme ultraviolet (EUV) ray (wavelength: 13.6 nm); and (6) an electron beam.

Among these, the light source in the first exposure step is preferably an i-line, an h-line, or broadband light. In this case, particularly high exposure sensitivity can be obtained.

An optical filter or the like that removes specific wavelengths in these light sources may be used. However, for example, in order to promote the photosensitization of the photosensitive compound A in the second exposure step, it is preferable to use, for example, the above high-pressure mercury lamp or the like, which is a light source including light having various wavelengths within a wavelength range of 200 to 600 nm, without using a particular optical filter or the like.

In the second exposure step, it is sufficient that at least a part of the developed pattern obtained in the development step is exposed; however, it is preferable that the whole of the above pattern is exposed.

The exposure amount in the second exposure step is preferably 100 to 20,000 $mJ/cm^2$ and more preferably 200 to 15,000 $mJ/cm^2$ in terms of exposure energy at the wavelength at which the photosensitive compound B has a sensitivity.

From the viewpoint of the shrinkage of the pattern to be obtained, the temperature in the second exposure step is preferably 20°C to 300°C, more preferably 50°C to 200°C, and still more preferably 50°C to 150°C.

Here, the temperature in the second exposure step is a temperature to be set in an exposure device that performs the second exposure step, and it can be set, for example, by carrying out the second exposure step using an exposure device having a temperature control function.

The exposed portion of the photocurable film becomes hot due to exposure. As a result, in a case where the temperature to be set in the exposure device is set, for example, within the above range, it is possible to expose the photocurable film while cooling it, and thus it is conceived that the shrinkage of the pattern is suppressed.

The thickness of the pattern to be obtained in the second exposure step can be set to, for example, 0.5 μm or more, and can be set to 1 μm or more. In addition, the upper limit value thereof can be set to 100 μm or less or can be set to 40 μm or less.

<Heating step>

The pattern forming method according to the embodiment of the present invention may further include a heating step of heating the pattern after the second exposure step.

In the heating step, the cyclization reaction of the specific resin proceeds.

Further, although the photocurable film may contain a crosslinking agent or the like other than the specific resin, the crosslinking of unreacted crosslinking groups in compounds such as this crosslinking agent also proceeds.

The heating temperature (the maximum heating temperature) in the heating step is preferably 50°C to 450°C, more preferably 140°C to 400°C, and still more preferably 160°C to 350°C.

In the heating step, the temperature elevation rate from the temperature at the start of heating to the maximum heating temperature is preferably 1 to 12 °C/min, more preferably 2 to 10 °C/min, and still more preferably 3 to 10 °C/min. In a case where the above temperature elevation rate is set to 1 °C/min or higher, it is possible to secure productivity, and in a case where the above temperature elevation rate is to 12 °C/min or lower, residual stress of the pattern can be relieved.

The heating time (the heating time at the maximum heating temperature) is preferably 10 to 360 minutes, more preferably 20 to 300 minutes, and particularly preferably 30 to 240 minutes.

Particularly, in the case of forming a multilayer laminate, the heating is preferably carried out at a heating temperature of 180°C to 320°C and more preferably 180°C to 260°C from the viewpoint of the adhesiveness between layers of the pattern. Although the reason is not clear, a conceivable reason is that, in a case where the temperature is set to the above range, for example, crosslinkable groups in the specific resin or crosslinking agent between layers undergo a crosslinking reaction with each other.

The heating may be carried out stepwise. For example, a pretreatment step in which the temperature is raised from 25°C to 180°C at 3 °C/min, held at 180°C for 60 minutes, raised from 180°C to 200°C at 2 °C/min, and held at 200°C for 120 minutes, may be carried out. The heating temperature as the pretreatment step is preferably 100°C to 200°C, more preferably 110°C to 190°C, and still more preferably 120°C to 185°C. In the pretreatment step, it is also preferable to carry out the treatment while irradiating with ultraviolet rays as described in US9159547B. By such a pretreatment step, it is possible to improve the properties of the film. The pretreatment step may be carried out for a short time of about 10 seconds to 2 hours and more preferably 15 seconds to 30 minutes. The pretreatment may be carried out in two or more stages, for example, a first stage pretreatment step may be carried out in a range of 100°C to 150°C, and then a second stage pretreatment step may be carried out in a range of 150°C to 200°C.

Further, cooling may be carried out after heating, and the cooling rate, in this case, is preferably 1 to 5 °C/min.

It is preferable that the heating step is carried out in an atmosphere of low oxygen concentration by causing an inert gas such as nitrogen, helium, argon, or the like to flow, from the viewpoint of preventing the decomposition of the polymer precursor. The oxygen concentration is preferably 50 ppm (volume ratio) or lower, and more preferably 20 ppm (volume ratio) or lower.

The heating unit that is used in the heating step is not particularly limited, and examples thereof include a hot plate, an infrared furnace, an electric heating oven, and a hot air oven.

From the viewpoint of pattern shrinkage, the pattern forming method according to the embodiment of the present invention can also adopt an aspect which does not include a step (a heating step) of heating the developed pattern obtained by the development step, after the development step and before the second exposure step.

In particular, in a case where the photosensitive compound B is a photobase generator, it is preferable not to include a step of heating the pattern at 200°C or higher before the second exposure step, and it is more preferable not to include a step of heating the pattern at 160°C or higher, from the viewpoint of pattern shrinkage.

<Metal layer forming step>

The pattern forming method according to the embodiment of the present invention preferably includes a metal layer forming step of forming a metal layer on the surface of the pattern after the second exposure step (or may be after the heating step in a case where the heating step is included).

For the metal layer, existing metal kinds can be used without particular limitations. Examples thereof include copper, aluminum, nickel, vanadium, titanium, chromium, cobalt, gold, tungsten, and alloys including these metals, preferred examples thereof are copper and aluminum, and a more preferred example thereof is copper.

The method of forming the metal layer is not particularly limited, and the existing method can be applied. For example, the methods disclosed in JP2007-157879A, JP2001-521288A, JP2004-214501A, and JP2004-101850A can be used. For example, photolithography, lift-off, electrolytic plating, electroless plating, etching, printing, and a method obtained by combining these may be conceivable. More specific examples of the method of forming the metal layer include a patterning method obtained by combining sputtering, photolithography, and etching, and a patterning method combining photolithography and electrolytic plating.

The thickness of the metal layer at the thickest portion is preferably 0.1 to 50 μm and more preferably 1 to 10 μm.

<Application>

As a field to which the pattern that is obtained by the pattern forming method according to the embodiment of the present invention can be applied, an insulating film of an electronic device, an interlayer insulating film for a re-distribution layer, a stress buffer film, and the like are mentioned. In addition, a sealing film, a base material (a base film or cover lay of a flexible print substrate, an interlayer insulating film), or an insulating film applicable for mounting as described above, which is patterned by etching is mentioned. For these use applications, for example, Science & Technology Co., Ltd., "High functionality and applied technology of polyimide" April 2008, CMC Technical library "Basics and development of polyimide materials" supervised by Masaaki Kakimoto, published in November 2011, "Latest Polyimide Basics and Applications" edited by Japan Polyimide & Aromatic Polymers Study Group, NTS Inc, August 2010, or the like can be referred to.

In addition, the pattern that is obtained by the pattern forming method according to the embodiment of the present invention can also be used for the production of board surfaces such as an offset board surface or a screen board surface, for etching of molded parts, for the production of protective lacquers and dielectric layers in electronics, in particular, microelectronics.

(Method of manufacturing Laminate)

The method of manufacturing a laminate according to the embodiment of the present invention preferably includes a pattern forming method according to the embodiment of the present invention.

The laminate obtained by the method of manufacturing a laminate according to the embodiment of the present invention is a laminate including two or more patterns, and it may be a laminate in which 3 to 7 layers are laminated.

At least one of the two or more layers of the patterns included in the laminate are patterns that are obtained by the pattern forming method according to the embodiment of the present invention, and from the viewpoint of suppressing the shrinkage of the pattern or the deformation of the pattern due to the shrinkage, It is also preferable that all the patterns included in the laminate are patterns obtained by the pattern forming method according to the embodiment of the present invention.

In the above laminate, an aspect in which two or more layers of the patterns are included and a metal layer is provided between any patterns is preferable. The metal layer is preferably formed in the metal layer forming step.

Examples of the preferred laminate include a laminate including at least a layer structure in which three layers of a first pattern, a metal layer, and a second pattern are laminated in order.

Both the first pattern and the second pattern are preferably patterns obtained by the pattern forming method according to the embodiment of the present invention. The photocurable resin composition according to the embodiment of the present invention that is used for forming the first pattern and the photocurable resin composition according to the embodiment of the present invention that is used for forming the second pattern may have the same composition or may have compositions different from each other. The metal layer in the laminate according to the embodiment of the present invention is preferably used as the metal wire of the re-distribution layer or the like.

<Laminating step>

The method of manufacturing a laminate according to the embodiment of the present invention preferably further includes a laminating step.

The laminating step is a series of steps including carrying out again the following steps in order on the surface of the pattern (the resin layer) or the metal layer; (a) film forming step (layer forming step), (b) first exposure step, (c) development step, and (d) second exposure step. However, the aspect may be such that only the (a) film forming step is repeated. Further, at least one of a heating step or (e) metal layer forming step may be included after the (d) second exposure step. Further, a heating step may be carried out after repeating the above (a) to (d) and (e) a plurality of times as necessary. Needless to say, the laminating step may further include appropriately the above-described drying step and the like.

In a case where another laminating step is further carried out after the laminating step, a surface activation treatment step may be further carried out after the first exposure step, after the second exposure step, or after the metal layer forming step. Examples of the surface activation treatment include plasma treatment.

In a case of giving priority to the durability of the laminate, the method of manufacturing a laminate according to the embodiment of the present invention preferably includes a surface activation treatment step of subjecting at least a part of the metal layer or a part of the resin composition layer to surface activation treatment.

The surface activation treatment step is usually carried out after the metal layer forming step. However, after

the development step, the metal layer forming step may be carried out after the resin composition layer is subjected to the surface activation treatment step.

At least a part of the metal layer may be subjected to the surface activation treatment, at least a part of the resin composition layer after the exposure may be subjected to the surface activation treatment, or both at least a part of the metal layer and at least a part of the resin composition layer after the exposure may be subjected to the surface activation treatment. It is preferable to carry out the surface activation treatment on at least a part of the metal layer, and it is preferable to carry out the surface activation treatment on a part or whole of the region of the metal layer having a surface on which the resin composition layer is formed. In a case where a surface of the metal layer is subjected to the surface activation treatment in this manner, it is possible to improve the adhesiveness to the resin composition layer (film) to be provided on the surface thereof.

In addition, it is preferable that the surface activation treatment is carried out on a part or whole of the resin composition layer (the resin layer) after the exposure. In a case where a surface of the resin composition layer is subjected to the surface activation treatment in this manner, it is possible to improve the adhesiveness to the metal layer or resin layer to be provided on the surface that has been subjected to the surface activation treatment. In particular, in a case where the resin composition layer is cured, such as in a case where negative type development is carried out, it is less likely to be damaged by the surface treatment, and thus the adhesiveness is likely to be improved.

Specifically, the surface activation treatment is selected from plasma treatment of various raw material gases (oxygen, hydrogen, argon, nitrogen, nitrogen/hydrogen mixed gas, argon/oxygen mixed gas, and the like), corona discharge treatment, etching treatment with $CF_4/O_2$, $NF_3/O_2$, $SF_6$, $NF_3$, or $NF_3/O_2$, surface treatment with an ultraviolet ray (UV) ozone method, immersion treatment in an organic surface-treating agent including a compound having at least one of an amino group or a thiol group after immersion in a hydrochloric acid aqueous solution to remove the oxide film, and mechanical roughening treatment using a brush. It is preferably plasma treatment and particularly preferably oxygen plasma treatment using oxygen as the raw material gas. In a case of corona discharge treatment, the energy is preferably 500 to 200,000 $J/m^2$, more preferably 1,000 to 100,000 $J/m^2$, and most preferably 10,000 to 50,000 $J/m^2$.

The laminating step is preferably carried out 2 to 5 times and more preferably 3 to 5 times.

For example, a configuration having resin layers of 3 or more and 7 or less, such as a resin layer/a metal layer/a resin layer/a metal layer/a resin layer/a metal layer, is preferable, and a configuration having resin layers of 3 or more and 5 or less is more preferable.

In the above layers, the compositions, shapes, film thicknesses, and the likes may be the same or may be different from each other.

In the present invention, an aspect in which after a metal layer is provided, further a pattern (a resin layer) of the photocurable resin composition is formed to cover the metal layer is particularly preferable. Specific examples thereof include an aspect in which the (a) film forming step, the (b) first exposure step, the (c) development step, the (d) second exposure step, and the (e) metal layer forming step are repeated in this order. In a case where the steps (a) to (d), which are steps for forming a pattern, and the metal layer forming step are carried out alternately, it is possible to alternately laminate the pattern and the metal layer.

(Manufacturing method for electronic device)

The present invention also discloses a method of manufacturing an electronic device, which includes the pattern forming method according to the embodiment of the present invention or the method of manufacturing a laminate according to the embodiment of the present invention. As the specific example of the electronic device using the photocurable resin composition according to the embodiment of the present invention for forming an interlayer insulating film for a re-distribution layer, the description in paragraphs 0213 to 0218 and the description of Fig. 1 of JP2016-027357A can be referred to, the content of which is incorporated in the present specification.

Hereinafter, the details of the photocurable resin composition that is used in the pattern forming method according to the embodiment of the present invention, the method of manufacturing a laminate according to the embodiment of the present invention, or the method of manufacturing an electronic device according to the embodiment of the present invention will be described.

(Photocurable resin composition)

The first aspect of the photocurable resin composition according to the embodiment of the present invention is a photocurable resin composition that is used in the pattern forming method according to the embodiment of the present invention, the method of manufacturing a laminate according to the embodiment of the present invention, or the method of manufacturing an electronic device according to the embodiment of the present invention will be described. That is, the first aspect of the photocurable resin composition according to the embodiment of the present invention contains at least one resin selected from the group consisting of a polyimide precursor and a polybenzoxazole precursor,

a photosensitive compound A having a sensitivity to an exposure wavelength in the first exposure step, and a photosensitive compound B having a sensitivity to an exposure wavelength in the second exposure step, where the photosensitive compound A is a compound that changes a solubility of the photocurable film in the developer in the first exposure step, and at least one in the group consisting of the photosensitive compound A and the photosensitive compound B is a photobase generator.

In addition, the second aspect of the photocurable resin composition according to the embodiment of the present invention contains at least one resin selected from the group consisting of a polyimide precursor and a polybenzoxazole precursor, a photosensitive compound A, and a photosensitive compound B, where the photosensitive compound A is a compound capable of changing a solubility of the resin by photosensitization, at least one in the group consisting of the photosensitive compound A and the photosensitive compound B is a photobase generator, and a difference between a maximal absorption wavelength of the photosensitive compound A and a maximal absorption wavelength of the photosensitive compound B is 100 nm or more.

According to the photocurable resin composition according to the second aspect, it is conceived that the shrinkage of the pattern to be obtained is suppressed with respect to the developed pattern after development, for example, in a case where the photocurable film formed from the above composition is used in the pattern forming method including the above-described first exposure step, the above-described development step, and the above-described second exposure step.

Each component contained in the photocurable resin composition according to the first aspect and each component contained in the photocurable resin composition according to the second aspect are the same except that in the second aspect, the difference between the maximal absorption wavelength of the photocurable resin composition A and the maximal absorption wavelength of the photosensitive compound B is limited to 100 nm or more.

In the present invention, the photosensitive compound A is preferably a compound that generates a radical in the first exposure step and more preferably a photoradical polymerization initiator.

According to the above aspect, radical polymerization is promoted in the photocurable film in the first exposure step, and development becomes possible.

In the present invention, the photosensitive compound A is preferably a compound that generates an acid in the first exposure step and more preferably a photoacid generator.

According to the above aspect, in the first exposure step, crosslinking by an acid is promoted in the photocurable film, or an acid is generated in the photocurable film and the solubility in the alkaline developer is increased, whereby development becomes possible.

In the present invention, the photosensitive compound B is preferably a compound that generates a base in the second exposure step and more preferably a photobase generator.

According to the above aspect, the cyclization of the specific resin is promoted in the developed pattern in the second exposure step, whereby a pattern is obtained.

The combination of the photosensitive compound A and the photosensitive compound B in the photocurable resin composition according to the embodiment of the present invention is preferably any of the following aspects 1 to 5.

The aspect 1: The photosensitive compound A is a photopolymerization initiator, and the photosensitive compound B is a photobase generator.

The aspect 2: The photosensitive compound A is a photoacid generator, and the photosensitive compound B is a photobase generator.

The aspect 3: The photosensitive compound A is a photobase generator, and the photosensitive compound B is a photopolymerization initiator.

The aspect 4: The photosensitive compound A is a photobase generator, and the photosensitive compound B is a photoacid generator.

The aspect 5: both the photosensitive compound A and the photosensitive compound B are a photobase generator.

According to the above aspect 1, aspect 3, or aspect 4, a negative type photocurable film can be obtained.

In the above aspects 2 and 5, a negative type or positive type photocurable film can be obtained.

Among these, any one of the aspects 1 to 4 is preferable from the viewpoint of pattern resolution.

The aspect 1 or the aspect 2 is preferable from the viewpoint of improving the chemical resistance of the pattern.

The aspect 2 is preferable from the viewpoint of obtaining a positive type photocurable film.

<Aspect 1>

In the aspect 1, it is preferable that the photocurable resin composition further contains a radical crosslinking agent described later.

For example, in a case where the photocurable resin composition according to the aspect 1 is used in the pattern forming method according to the embodiment of the present invention, the crosslinking of the crosslinking agent

is promoted in the exposed portion in the first exposure step, and the cyclization of the specific resin is promoted in the exposed portion in the second exposure step as well.

<Aspect 2>

In the aspect 2, in a case of forming a negative type photocurable film, the photocurable resin composition preferably further contains another crosslinking agent described later.

For example, in the pattern forming method according to the embodiment of the present invention, in a case where the photocurable resin composition according to the aspect 2 is used to form a negative type photocurable film, the crosslinking of the cross-linking agent is promoted in the exposed portion in the first exposure step, and the cyclization of the specific resin is promoted in the exposed portion in the second exposure step.

In the aspect 2, in a case of forming a positive type photocurable film, the photocurable resin composition may further contain another crosslinking agent described later, or may not contain a crosslinking agent.

For example, in the pattern forming method according to the embodiment of the present invention, in a case where the photocurable resin composition according to the aspect 2 is used to form a positive type photocurable film, an acid is generated in the exposed portion in the first exposure step, which increases the solubility in the developer such as an alkaline developer, and the cyclization of the specific resin is promoted in the exposed portion in the second exposure step.

<Aspect 3>

In the aspect 3, it is preferable that the photocurable resin composition further contains a radical crosslinking agent described later.

For example, in a case where the photocurable resin composition according to the aspect 3 is used in the pattern forming method according to the embodiment of the present invention, the cyclization of the specific resin is promoted in the exposed portion in the first exposure step, and the crosslinking of the crosslinking agent is promoted in the exposed portion in the second exposure step as well.

<Aspect 4>

In the aspect 4, it is preferable that the photocurable resin composition further contains another crosslinking agent described later.

For example, in a case where the photocurable resin composition according to the aspect 4 is used in the pattern forming method according to the embodiment of the present invention, the cyclization of the specific resin is promoted in the exposed portion in the first exposure step, and the crosslinking of the crosslinking agent is promoted in the exposed portion in the second exposure step as well.

<Aspect 5>

In the aspect 5, it is preferable that the photocurable resin composition further contains another crosslinking agent described later.

For example, in a case where the photocurable resin composition according to the aspect 5 is used in the pattern forming method according to the embodiment of the present invention, at least one of the cyclization of the specific resin or the crosslinking of the crosslinking agent is promoted in the exposed portion in the first exposure step, and at least one of the cyclization of the specific resin or the crosslinking of the crosslinking agent is promoted also in the exposed portion in the second exposure step.

Hereinafter, details of each component contained in the photocurable resin composition according to the embodiment of the present invention will be described.

<Specific resin>

The photocurable resin composition according to the embodiment of the present invention contains at least one resin (a specific resin) selected from the group consisting of a polyimide precursor and a polybenzoxazole precursor.

The photocurable resin composition according to the embodiment of the present invention preferably contains a polyimide precursor as the specific resin.

The specific resin may have a crosslinkable group. Examples of the crosslinkable group include crosslinkable groups mentioned in the explanations of $R^{113}$ and $R^{114}$ described later.

[Polyimide precursor]

From the viewpoint of the film hardness of the pattern to be obtained, the polyimide precursor preferably has a repeating unit represented by Formula (1).

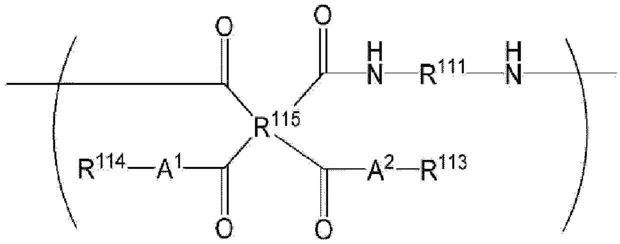

(1)

in Formula (1), $A^1$ and $A^2$ each independently represent an oxygen atom or -NH-, $R^{111}$ represents a divalent organic group, $R^{115}$ represents a tetravalent organic group, and $R^{113}$ and $R^{114}$ each independently represent a hydrogen atom or a monovalent organic group.

-$A^1$ and $A^2$ -

$A^1$ and $A^2$ in Formula (1) each independently represent an oxygen atom or -NH-, and an oxygen atom is preferable.

- $R^{111}$ -

$R^{111}$ in Formula (1) represents a divalent organic group. Examples of the divalent organic group include a group having a linear or branched aliphatic group, a cyclic aliphatic group, an aromatic group, and a heteroaromatic group, or a group obtained by combining two or more these groups. The divalent organic group is preferably a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more these groups, and more preferably an aromatic group having 6 to 20 carbon atoms.

$R^{111}$ in Formula (1) is preferably derived from a diamine. Examples of the diamine that is used for producing the polyimide precursor include a linear aliphatic or branched aliphatic diamine, a cyclic aliphatic diamine, or an aromatic diamine. One kind of diamine may be used alone, or two or more kinds thereof may be used.

Specifically, the diamine is preferably a diamine containing a linear aliphatic group having 2 to 20 carbon atoms, a branched or cyclic aliphatic group having 3 to 20 carbon atoms, an aromatic group having 6 to 20 carbon atoms, or a group obtained by combining two or more these groups, and more preferably a diamine containing an aromatic group having 6 to 20 carbon atoms. Examples of the aromatic group include the followings. In the following formulae, *'s each independently represent a bonding site to another structure.

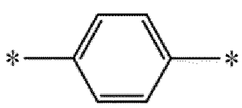

AR-1

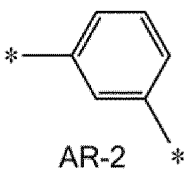

AR-2

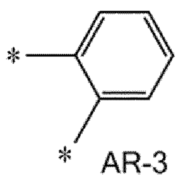

AR-3

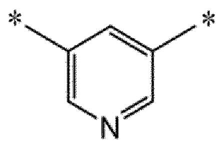

AR-4

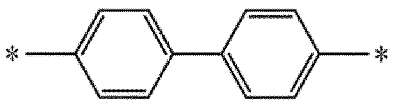

AR-5

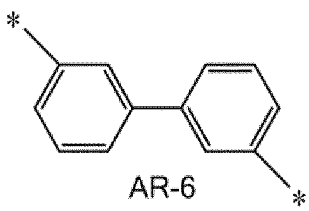

AR-6

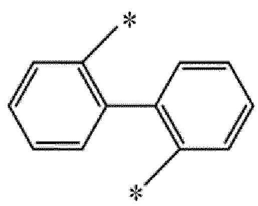

AR-7

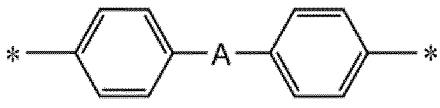

AR-8

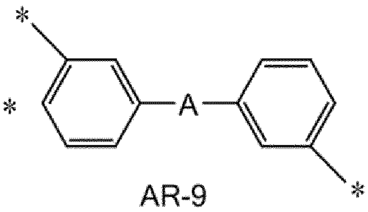

AR-9

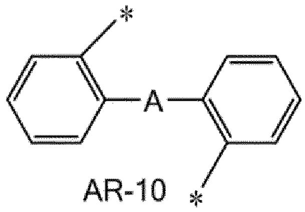

AR-10

In the formulae, A is preferably a single bond, or an aliphatic hydrocarbon group having 1 to 10 carbon atoms, which may be substituted with a fluorine atom, -O-, -C(=O)-, -S-, $-S(=O)_2-$, -NHC(=O)-, or a group obtained by combining two or more thereof, more preferably a single bond, or a group selected from an alkylene group having 1 to 3 carbon atoms, which may be substituted with a fluorine atom, -O-, -C(=O)-, -S-, and $-S(=O)_2-$, and still more preferably a divalent group selected from the group consisting of $-CH_2-$, -O-, -S-, $-S(=O)_2-$, $-C(CF_3)_2-$, and $-C(CH_3)_2-$.

Specific examples of the diamine include at least one diamine selected from 1,2-diaminoethane, 1,2-diaminopropane, 1,3-diaminopropane, 1,4-diaminobutane, or 1,6-diaminohexane; 1,2- or 1,3-diaminocyclopentane, 1,2-, 1,3-, or 1,4-diaminocyclohexane, 1,2-, 1,3-, or 1,4-bis(aminomethyl)cyclohexane, bis-(4-aminocyclohexyl)methane, bis-(3-aminocyclohexyl)methane, 4,4'-diamino-3,3'-dimethylcyclohexylmethane, or isophorone diamine; meta or paraphenylene diamine, diaminotoluene, 4,4'- or 3,3'-diaminobiphenyl, 4,4'-diaminodiphenyl ether, 3,3-diaminodiphenyl ether, 4,4'- or 3,3'-diaminodiphenylmethane, 4,4'- or 3,3'-diaminodiphenyl sulfone, 4,4'- or 3,3'-diaminodiphenyl sulfide, 4,4'- or 3,3'-diaminobenzophenone, 3,3'-dimethyl-4,4'-diaminobiphenyl, 2,2'-dimethyl-4,4'-diaminobiphenyl (4,4'-diamino-2,2'-dimethylbiphenyl), 3,3'-dimethoxy-4,4'-diaminobiphenyl, 2,2-bis(4-aminophenyl)propane, 2,2-bis(4-aminophenyl)hexafluoropropane, 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, bis(3-amino-4-hydroxyphenyl)sulfone, bis(4-amino-3-hydroxyphenyl)sulfone, 4,4'-diaminoparaterphenyl, 4,4-bis(4-aminophenoxy)biphenyl, bis[4-(4-aminophenoxy)phenyl]sulfone, bis [4-(3 -aminophenoxy)phenyl] sulfone, bis[4-(2-aminophenoxy)phenyl] sulfone, 1,4-bis(4-aminophenoxy)benzene, 9,10-bis(4-aminophenyl)anthracene, 3,3'-dimethyl-4,4'-diaminodiphenyl sulfone, 1,3-bis(4-aminophenoxy)benzene, 1,3 -bis(3 -aminophenoxy)benzene, 1,3 -bis(4-aminophenyl)benzene, 3,3'-diethyl-4,4'-diaminodiphenylmethane, 3,3'-dimethyl-4,4'-diaminodiphenylmethane, 4,4'-diaminooctafluorobiphenyl, 2,2-bis[4-(4-aminophenoxy)phenyl]propane, 2,2-bis[4-(4-aminophenoxy)phenyl]hexafluoropropane, 9,9-bis(4-aminophenyl)-10-hydroanthracene, 3,3',4,4'-tetraaminobiphenyl, 3,3',4,4'-tetraaminodiphenyl ether, 1,4-diaminoanthraquinone, 1,5-diaminoanthraquinone, 3,3-dihydroxy-4,4'-diaminobiphenyl, 9,9'-bis(4-aminophenyl)fluorene, 4,4'-dimethyl-3,3'-diaminodiphenyl sulfone, 3,3',5,5'-tetramethyl-4,4'-diaminodiphenylmethane, 2-(3',5'-diaminobenzoyloxy)ethylmethacrylate, 2,4- or, 2,5-diaminocumene, 2,5-dimethyl-paraphenylene diamine, acetoguanamine, 2,3,5,6-tetramethyl-paraphenylene diamine, 2,4,6-trimethyl-metaphenylene diamine, bis(3-aminopropyl)tetramethyl disiloxane, 2,7-diaminofluorene, 2,5-diaminopyridine, 1,2-bis(4-aminophenyl)ethane, diaminobenzanilide, esters of diaminobenzoic acid, 1,5-diaminonaphthalene, diaminobenzotrifluoride, 1,3 -bis(4-aminophenyl)hexafluoropropane, 1,4-bis(4-aminophenyl)octafluorobutane, 1,5-bis(4-aminophenyl)decafluoropentane, 1,7-bis(4-aminophenyl)tetradecafluoroheptane, 2,2-bis[4-(3-aminophenoxy)phenyl]hexafluoropropane, 2,2-bis[4-(2-aminophenoxy)phenyl]hexafluoropropane, 2,2-bis[4-(4-aminophenoxy)-3,5-dimethylphenyl]hexafluoropropane, 2,2-bis[4-(4-aminophenoxy)-3,5-bis(trifluoromethyl)phenyl]hexafluoropropane, parabis(4-amino-2-trifluoromethylphenoxy)benzene, 4,4'-bis(4-amino-2-trifluoromethylphenoxy)biphenyl, 4,4'-bis(4-amino-3 -trifluoromethylphenoxy)biphenyl, 4,4'-bis(4-amino-2-trifluoromethylphenoxy)diphenyl sulfone, 4,4'-bis(3-amino-5-trifluoromethylphenoxy)diphenyl sulfone, 2,2-bis[4-(4-amino-3-trifluoromethylphenoxy)phenyl]hexafluoropropane, 3,3',5,5'-tetramethyl-4,4'-diaminobiphenyl, 4,4'-diamino-2,2'-bis(trifluoromethyl)biphenyl, 2,2',5,5',6,6'-hexafluorotolidine, or 4,4'-diaminoquaterphenyl.

Further, the diamines (DA-1) to (DA-18) described in paragraphs 0030 to 0031 of WO2017/038598A are also preferable.

Further, the diamine having two or more alkylene glycol units in the main chain, described in paragraphs 0032 to 0034 of WO2017/038598A, is also preferably used.

$R^{111}$ in Formula (1) is preferably represented by $-Ar^0-L^0-Ar^0-$ from the viewpoint of the flexibility of the pattern to be obtained. $Ar^0$'s are each independently an aromatic hydrocarbon group (preferably having 6 to 22 carbon atoms, more preferably 6 to 18 carbon atoms, and particularly preferably 6 to 10 carbon atoms) and are preferably a phenylene group. L° represents a single bond, or an aliphatic hydrocarbon group having 1 to 10 carbon atoms which may be substituted with a fluorine atom, -O-, -C(=O)-, -S-, $-S(=O)_2-$, -NHCO-, or a group obtained by combining two or more thereof. The preferred range of $L^0$ is the same as that of A described above.

From the viewpoint of the i-line transmittance, $R^{111}$ in Formula (1) is preferably a divalent organic group represented by Formula (51) or Formula (61) below. In particular, from the viewpoint of the i-line transmittance and ease of availability, a divalent organic group represented by Formula (61) is more preferable.

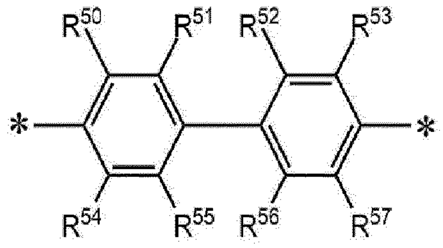 (51)

In Formula (51), $R^{50}$ to $R^{57}$ each independently represent a hydrogen atom, a fluorine atom, or a monovalent organic group, and at least one of $R^{50}$, ..., or $R^{57}$ represents a fluorine atom, a methyl group, a fluoromethyl group, a difluoromethyl group, or a trifluoromethyl group, and *'s each independently represent a bonding site to another structure.

Examples of the monovalent organic group as $R^{50}$ to $R^{57}$ include an unsubstituted alkyl group having 1 to 10 (preferably 1 to 6) carbon atoms and a fluorinated alkyl group having 1 to 10 (preferably 1 to 6) carbon atoms.

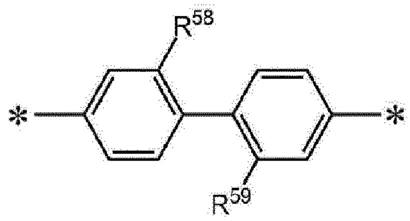 (61)

In Formula (61), $R^{58}$ and $R^{59}$ each independently represent a fluorine atom, a fluoromethyl group, a difluoromethyl group, or a trifluoromethyl group.

Examples of the diamine compound that provides a structure of Formula (51) or (61), dimethyl-4,4'-diaminobiphenyl, 2,2'-bis(trifluoromethyl)-4,4'-diaminobiphenyl, and 2,2'-bis(fluoro)-4,4'-diaminobiphenyl, 4,4'-diaminooctafluorobiphenyl. One kind among them may be used, or two or more kinds among them may be used in combination.

- $R^{115}$ -

$R^{115}$ in Formula (1) represents a tetravalent organic group. The tetravalent organic group is preferably a tetravalent organic group containing an aromatic ring and more preferably a group represented by Formula (5) or Formula (6).

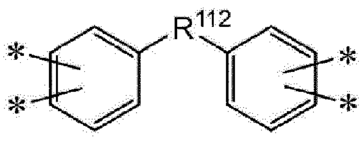 (5) 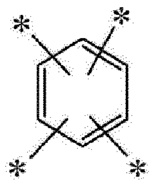 (6)

$R^{112}$ is synonymous with A, and the same applies to the preferred range. *'s each independently represent a bonding site to another structure.

Specific examples of the tetravalent organic group represented by $R^{115}$ in Formula (1) include a tetracarboxylic acid residue that remains after removing an acid dianhydride group from tetracarboxylic acid dianhydride. The tetracarboxylic dianhydride may be used singly or two or more kinds thereof may be used. The tetracarboxylic acid dianhydride is preferably a compound represented by Formula (7).

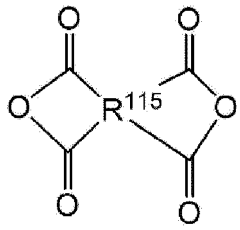 (7)

$R^{115}$ represents a tetravalent organic group. $R^{115}$ is synonymous with $R^{115}$ in Formula (1).

Specific examples of the tetracarboxylic acid dianhydride include at least one selected from pyromellitic acid, pyromellitic acid dianhydride (PMDA), 3,3',4,4'-biphenyltetracarboxylic acid dianhydride, 3,3',4,4'-diphenylsulfide tetracarboxylic acid dianhydride, 3,3',4,4'-diphenylsulfone tetracarboxylic acid dianhydride, 3,3',4,4'-benzophenone tetracarboxylic acid dianhydride, 3,3',4,4'-diphenylmethane tetracarboxylic acid dianhydride, 2,2',3,3'-diphenylmethane tetracarboxylic acid dianhydride, 2,3,3',4'-biphenyltetracarboxylic acid dianhydride (4,4'-biphthalic acid anhydride), 2,3,3',4'-benzophenone tetracarboxylic acid dianhydride, 4,4'-oxydiphthalic acid dianhydride, 2,3,6,7-naphthalene tetracarboxylic acid dianhydride, 1,4,5,7-naphthalene tetracarboxylic acid dianhydride, 2,2-bis(3,4-dicarboxyphenyl)propane dianhydride, 2,2-bis(2,3-dicarboxyphenyl)propane dianhydride, 2,2-bis(3,4-dicarboxyphenyl) hexafluoropropane dianhydride, 1,3-diphenylhexafluoropropane-3,3,4,4-tetracarboxylic acid dianhydride, 1,4,5,6-naphthalene tetracarboxylic acid dianhydride, 2,2',3,3'-diphenyl tetracarboxylic acid dianhydride, 3,4,9,10-perylene tetracarboxylic acid dianhydride, 1,2,4,5-naphthalene tetracarboxylic acid dianhydride, 1,4,5,8-naphthalene tetracarboxylic acid dianhydride, 1,8,9,10-phenanthrene tetracarboxylic acid dianhydride, 1,1-bis(2,3-dicarboxyphenyl)ethane dianhydride, 1,1-bis(3,4-dicarboxyphenyl)ethane dianhydride, 1,2,3,4-benzene tetracarboxylic acid dianhydride, and alkyl derivatives having 1 to 6 carbon atoms and alkoxy derivatives having 1 to 6 carbon atoms thereof.

In addition, preferred examples thereof include the tetracarboxylic acid dianhydrides (DAA-1) to (DAA-5) described in paragraph 0038 of WO2017/038598A.

It is also preferable that at least one of $R^{111}$ or $R^{115}$ has an OH group. More specifically, as $R^{111}$, a residue of a bisaminophenol derivative can be mentioned.

- $R^{113}$ and $R^{114}$ -

$R^{113}$ and $R^{114}$ in Formula (1) each independently represent a hydrogen atom or a monovalent organic group. At least one of $R^{113}$ or $R^{114}$ preferably contains a crosslinkable group, and more preferably both contain a crosslinkable group. The crosslinkable group is preferably a group capable of undergoing a crosslinking reaction by the action of a radical, an acid, a base, or the like, and examples thereof include a group having an ethylenically unsaturated bond, an alkoxymethyl group, a hydroxymethyl group, an acyloxymethyl group, an epoxy group, a cyclic ether group such as anoxetanyl group, a benzoxazolyl group, a blocked isocyanate group, a methylol group, and an amino group, where a group having an ethylenically unsaturated bond, a cyclic ether group, an alkoxymethyl group, or a methylol group is preferable. The group having an ethylenically unsaturated bond is preferably a group having radical polymerizability.

Examples of the group having an ethylenically unsaturated bond include a group having a vinyl group which may be substituted, which is directly bonded to an aromatic ring such as a vinyl group, an allyl group, or a vinylphenyl group, a (meth)acryloyl group, and a group represented by Formula (III).

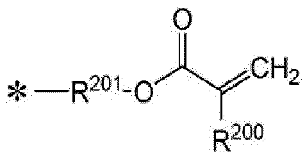 (III)

In Formula (III), $R^{200}$ represents a hydrogen atom or a methyl group and is preferably a hydrogen atom.

It is preferably a methyl group in a case of giving priority to chemical liquid resistance.

In Formula (III), * represents a bonding site with another structure.

In Formula (III), $R^{201}$ represents an alkylene group having 2 to 12 carbon atoms, $-CH_2CH(OH)CH_2-$, or a polyalkyleneoxy group.

Suitable examples of $R^{201}$ include an ethylene group, a propylene group, a trimethylene group, a tetramethylene group, a 1,2-butanediyl group, a 1,3-butanediyl group, a pentamethylene group, a hexamethylene group, an octamethylene group, a dodecamethylene group, $-CH_2CH(OH)CH_2-$, and a polyalkyleneoxy group, where an ethylene group, a propylene group, a trimethylene group, $-CH_2CH(OH)CH_2-$, or a polyalkyleneoxy group is more preferable, and a polyalkylene oxy group is more preferable from the viewpoint of easily satisfying Formula (1) or Formula (2) in the organic film.

In the present invention, the polyalkyleneoxy group refers to a group to which two or more alkyleneoxy groups are directly bonded. The alkylene group in the plurality of alkyleneoxy groups contained in the polyalkyleneoxy group may be the same or different from each other.

In a case where the polyalkyleneoxy group contains a plurality of kinds of alkyleneoxy groups having different alkylene groups, the sequence of the alkyleneoxy groups in the polyalkyleneoxy group may be a random sequence, may be a sequence having a block, or may be a sequence having an alternating pattern or the like.

The number of carbon atoms of the alkylene group (including the number of carbon atoms of the substituent in a case where the alkylene group has a substituent) is preferably 2 or more, more preferably 2 to 10, still more preferably

2 to 6, even still more preferably 2 to 5, even further still more preferably 2 to 4, particularly preferably 2 or 3, and most preferably 2.

Furthermore, the alkylene group may have a substituent. Examples of the preferred substituent include an alkyl group, an aryl group, and a halogen atom.

In addition, the number of alkyleneoxy groups contained in the polyalkyleneoxy group (the number of repetitions of the polyalkyleneoxy group) is preferably 2 to 20, more preferably 2 to 10, and still more preferably 2 to 6.

The polyalkyleneoxy group is preferably a polyethyleneoxy group, a polypropyleneoxy group, a polytrimethyleneoxy group, a polytetramethyleneoxy group, or a group obtained by bonding a plurality of ethyleneoxy groups with a plurality of propyleneoxy groups, more preferably a polypropyleneoxy group or a polyethyleneoxy group, and still more preferably an polyethyleneoxy group, from the viewpoint of solvent solubility and solvent resistance. In the group obtained by bonding a plurality of ethyleneoxy groups with a plurality of propyleneoxy groups, the ethyleneoxy groups and the propyleneoxy groups may be randomly arranged, may be arranged by forming a block, or may be arranged in an alternately patterned manner or the like. The preferred aspect of the number of repetitions of the ethyleneoxy group and the like in these groups is as described above.

$R^{113}$ or $R^{114}$ is more preferably a hydrogen atom, a benzyl group, a 2-hydroxybenzyl group, a 3-hydroxybenzyl group, or a 4-hydroxybenzyl group, from the viewpoint of solubility in an aqueous developer.

From the viewpoint of solubility in an organic solvent, $R^{113}$ or $R^{114}$ is preferably a monovalent organic group. The monovalent organic group is preferably a linear or branched alkyl group, a cyclic alkyl group, or an aromatic group, and more preferably an alkyl group substituted with an aromatic group.

The alkyl group preferably has 1 to 30 carbon atoms (3 or more carbon atoms in the case of the cyclic group). The alkyl group may be linear, branched, or cyclic. Examples of the linear or branched alkyl group include a methyl group, an ethyl group, a propyl group, a butyl group, a pentyl group, a hexyl group, a heptyl group, an octyl group, a nonyl group, a decyl group, a dodecyl group, a tetradecyl group, an octadecyl group, an isopropyl group, an isobutyl group, a sec-butyl group, a t-butyl group, a 1-ethylpentyl group, and a 2-ethylhexyl group. The cyclic alkyl group may be a monocyclic cyclic alkyl group or a polycyclic cyclic alkyl group. Examples of the monocyclic cyclic alkyl group include a cyclopropyl group, a cyclobutyl group, a cyclopentyl group, a cyclohexyl group, a cycloheptyl group, and a cyclooctyl group. Examples of the polycyclic cyclic alkyl group include an adamantyl group, a norbornyl group, a bornyl group, a camphenyl group, a decahydronaphthyl group, a tricyclodecanyl group, a tetracyclodecanyl group, a camphoroyl group, a dicyclohexyl group, and a pinenyl group. In addition, the alkyl group substituted with an aromatic group is preferably a linear alkyl group substituted with an aromatic group as described next.

Specifically, the aromatic group is a substituted or unsubstituted aromatic hydrocarbon group (examples of the cyclic structure constituting the group include a benzene ring, a naphthalene ring, a biphenyl ring, a fluorene ring, a pentalene ring, an indene ring, an azulene ring, a heptalene ring, an indacene ring, a perylene ring, a pentacene ring, an acenaphthene ring, a phenanthrene ring, an anthracene ring, a naphthacene ring, a chrysene ring, and a triphenylene ring) or a substituted or unsubstituted aromatic heterocyclic group (examples of the cyclic structure constituting the group include fluorene ring, a pyrrole ring, a furan ring, a thiophene ring, an imidazole ring, an oxazole ring, a thiazole ring, a pyridine ring, a pyrazine ring, a pyrimidine ring, a pyridazine ring, an indolizine ring, an indole ring, a benzofuran ring, a benzothiophene ring, an isobenzofuran ring, a quinolizine ring, a quinoline ring, a phthalazine ring, a naphthyridine ring, a quinoxaline ring, a quinoxazoline ring, an isoquinoline ring, a carbazole ring, a phenanthridine ring, an acridine ring, a phenanthroline ring, a thianthrene ring, a chromene ring, a xanthene ring, a phenoxathiin ring, a phenothiazine ring, and a phenazine ring).

In addition, it is also preferable that the polyimide precursor has a fluorine atom in the repeating unit. The content of fluorine atoms in the polyimide precursor is preferably 10% by mass or more and more preferably 20% by mass or more. The upper limit is not particularly limited, but it is practically 50% by mass or less.

In addition, for the intended purpose of improving adhesiveness to a base material, an aliphatic group having a siloxane structure may be copolymerized to a repeating unit represented by Formula (1). Specific examples of the diamine component include bis(3-aminopropyl)tetramethyldisiloxane and bis(paraaminophenyl)octamethyl pentasiloxane.

The repeating unit represented by Formula (1) is preferably a repeating unit represented by Formula (1-A) or a repeating unit represented by Formula (1-B).

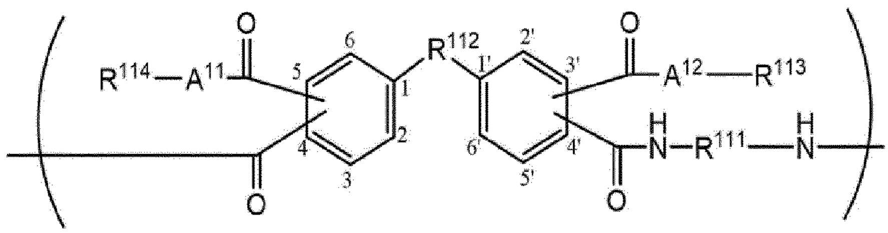

(1-A)

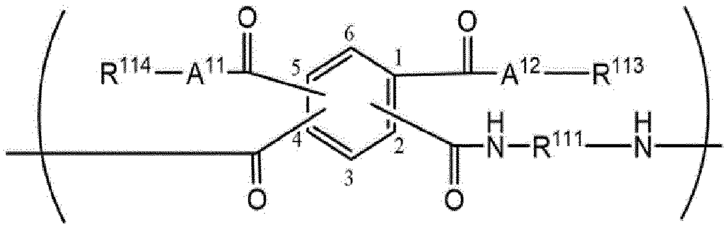

(1-B)

$A^{11}$ and $A^{12}$ represent an oxygen atom or -NH-, $R^{111}$ and $R^{112}$ each independently represent a divalent organic group, $R^{113}$ and $R^{114}$ each independently represent a hydrogen atom or a monovalent organic group, and at least one of $R^{113}$ or $R^{114}$ is more preferably a crosslinkable group.

The preferred ranges of $A^{11}$, $A^{12}$, $R^{111}$, $R^{113}$, and $R^{114}$ are respectively synonymous with $A^1$, $A^2$, $R^{111}$, $R^{113}$, and $R^{114}$, in Formula (1).

The preferred range of $R^{112}$ is the same as that of $R^{112}$ in Formula (5) and is more preferably an oxygen atom among the above.

The bonding position of the carbonyl group to the benzene ring in the formula is preferably 4, 5, 3', or 4' in Formula (1-A). In Formula (1-B), the bonding position is preferably 1, 2, 4, or 5.

In the polyimide precursor, the repeating unit represented by Formula (1) may be one kind or two or more kinds. In addition, the polyimide precursor may contain structural isomers of the repeating unit represented by Formula (1). In addition, the polyimide precursor may also contain another kind of repeating unit in addition to the above repeating unit represented by Formula (1).

As one embodiment of the polyimide precursor in the present invention, a polyimide precursor in which the repeating unit represented by Formula (1) accounts for 50% by mole or more, further 70% by mole or more, and particularly 90% by mole or more in the entirety of the repeating units is exemplified. The upper limit is practically 100% by mole or less.

The weight-average molecular weight (Mw) of the polyimide precursor is preferably 2,000 to 500,000, more preferably 5,000 to 100,000, and still more preferably 10,000 to 50,000. In addition, the number-average molecular weight (Mn) thereof is preferably 800 to 250,000, more preferably 2,000 to 50,000, and still more preferably 4,000 to 25,000.

The dispersivity of the molecular weight of the polyimide precursor is preferably 1.5 to 3.5 and more preferably 2 to 3.

In the present specification, the dispersity of molecular weight refers to a value (the weight-average molecular weight/the number-average molecular weight) obtained by dividing the weight-average molecular weight by the number-average molecular weight.

In addition, in a case where the resin composition contains a plurality of kinds of polyimide precursors as the specific resin, it is preferable that the weight-average molecular weight, the number-average molecular weight, and the dispersivity of at least one kind of polyimide precursor are in the above ranges. Further, it is also preferable that the weight-average molecular weight, the number-average molecular weight, and the dispersivity, calculated by using the plurality of kinds of polyimide precursors as one resin, are within the above ranges.

The polyimide precursor is obtained by reacting a dicarboxylic acid or a dicarboxylic acid derivative with a diamine. For example, the polyimide precursor is obtained by halogenating a dicarboxylic acid or a dicarboxylic acid derivative with a halogenating agent and then causing the resultant to be reacted with a diamine.

More specifically, it can be obtained by a method of reacting a tetracarboxylic acid dianhydride with a diamine at a low temperature, a method of reacting a tetracarboxylic acid dianhydride with a diamine at a low temperature to obtain a polyamic acid and subjecting the polyamic acid to esterification by using a condensing agent or an alkylating agent, a method of obtaining a diester with a tetracarboxylic acid dianhydride and alcohol and then reacting the diester with a diamine in the presence of a condensing agent, and a method of obtaining a diester with a tetracarboxylic acid dianhydride and alcohol, subsequently subjecting the rest dicarboxylic acid to acid-halogenation using a halogenating agent, and carrying out reaction with a diamine. Among the above production method, a method of obtaining a diester

with a tetracarboxylic acid dianhydride and alcohol, subsequently subjecting the rest dicarboxylic acid to acid-halogenation using a halogenating agent, and carrying out reaction with a diamine is more preferable.

Examples of the condensing agent include dicyclohexylcarbodiimide, diisopropylcarbodiimide, 1-ethoxycarbonyl-2-ethoxy-1,2-dihydroquinoline, 1,1-carbonyldioxy-di-1,2,3-benzotriazole, N,N'-disuccinimidyl carbonate, and trifluoroacetic anhydride.

Examples of the alkylating agent include N,N-dimethylformamide dimethyl acetal, N,N-dimethylformamide diethyl acetal, N,N-dialkylformamide dialkyl acetal, trimethyl orthoformate, triethyl orthoformate.

Examples of the halogenating agent include thionyl chloride, oxalyl chloride, and phosphorus oxychloride.

Further, in the production of the polyimide precursor, it is also preferable to carry out synthesis using a non-halogen catalyst. As the non-halogen catalyst, a known amidation catalyst containing no halogen atom can be used without particular limitation. Examples thereof include a boroxine compound, an N-hydroxy compound, a tertiary amine, a phosphoric acid ester, an amine salt, a urea compound, and a carbodiimide compound. Examples of the carbodiimide compound include N,N'-diisopropylcarbodiimide and N,N'-dicyclohexylcarbodiimide.

In the method for manufacturing the polyimide precursor, it is preferable to use an organic solvent at the time of reaction. One kind of organic solvent may be used, or two or more kinds thereof may be used.

The organic solvent can be appropriately determined according to raw materials, and examples thereof include pyridine, diethylene glycol dimethyl ether (diglyme), N-methyl-2-pyrrolidone, and N-ethyl-2-pyrrolidone.

Further, examples thereof include ethyl propionate, dimethylacetamide, dimethylformamide, tetrahydrofuran, and $\gamma$-butyrolactone.

In the method of producing a polyimide precursor or the like, it is preferable to add a basic compound during the reaction. One kind of organic solvent may be used, or two or more kinds thereof may be used.

The basic compound can be appropriately determined depending on the raw material; however, examples thereof include triethylamine, diisopropylethylamine, pyridine, 1,8-diazabicyclo[5.4.0]undec-7-ene, and N,N-dimethyl-4-aminopyridine.

In a case of producing the polyimide precursor, it is preferable to include a step of depositing a solid. Specifically, the polyimide precursor in the reaction solution is deposited as a solid in water and dissolved in a solvent in which the polyimide precursor such as tetrahydrofuran or the like can be solubilized, and then the solid can be deposited.

More specifically, it is possible to obtain a polyimide precursor by filtering out a water-absorbing by-product of the dehydration condensing agent that is present together in the reaction solution as necessary, subsequently putting the obtained polymer component in a poor solvent such as water, an aliphatic lower alcohol, or a mixed solution thereof, precipitating the polymer component to be precipitated as a solid, and then carrying out drying. In order to improve the degree of purification, operations such as redissolution, reprecipitation, and drying of the polyimide precursor may be repeated. Further, a step of removing ionic impurities using an ion exchange resin may be included.

- Terminal blocking agent -

In the method of producing a polyimide precursor or the like, it is preferable to block the carboxylic acid anhydride, the acid anhydride derivative, or the amino group, remaining at the resin terminal of the polyimide precursor or the like, in order to further improve the storage stability. In a case of blocking the carboxylic acid anhydride and the acid anhydride derivative, remaining at the resin terminal, examples of the terminal blocking agent include a monoalcohol, phenol, thiol, thiophenol, and a monoamine. It is more preferable to use a monoalcohol, phenols, or a monoamine from the viewpoint of reactivity and film stability. Examples of the preferred monoalcohol compound include primary alcohol such as methanol, ethanol, propanol, butanol, hexanol, octanol, dodecynol, benzyl alcohol, 2-phenylethanol, 2-methoxyethanol, 2-chloromethanol, and furfuryl alcohol; secondary alcohol such as isopropanol, 2-butanol, cyclohexyl alcohol, cyclopentanol, and 1-methoxy-2-propanol; and tertiary alcohol such as t-butyl alcohol and adamantane alcohol. Examples of the preferred compounds of phenols include phenols such as phenol, methoxyphenol, methylphenol, naphthalene-1-ol, naphthalene-2-ol, and hydroxystyrene. In addition, examples of the preferred monoamine compound include aniline, 2-ethynyl aniline, 3-ethynyl aniline, 4-ethynyl aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.

In addition, in a case of blocking the amino group at the terminal of the resin, it is possible to carry out blocking with a compound having a functional group capable of reacting with the amino group. The preferred blocking agent for

the amino group is preferably a carboxylic acid anhydride, a carboxylic acid chloride, a carboxylic acid bromide, a sulfonic acid chloride, sulfonic anhydride, or a sulfonic acid carboxylic acid anhydride, and more preferably a carboxylic acid anhydride or a carboxylic acid chloride. Examples of the preferred carboxylic acid anhydride compound include acetic anhydride, propionic anhydride, oxalic anhydride, succinic anhydride, maleic anhydride, phthalic anhydride, and benzoic anhydride, 5-norbornen-2,3-dicarboxylic acid anhydride. Examples of the preferred carboxylic acid chloride compound include acetyl chloride, acrylic acid chloride, propionyl chloride, methacrylic acid chloride, pivaloyl chloride, cyclohexanecarbonyl chloride, 2-ethylhexanoyl chloride, cinnamoyl chloride, 1-adamantanecarbonyl chloride, heptafluorobutyryl chloride, stearic acid chloride, and benzoyl chloride.

[Polybenzoxazole precursor]

The polybenzoxazole precursor preferably contains a repeating unit represented by Formula (2).

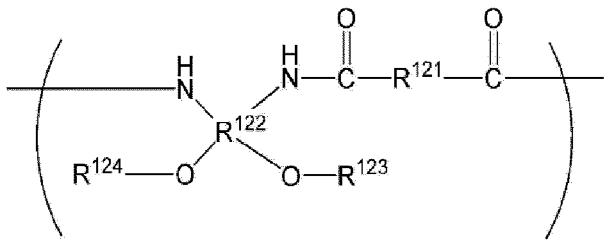

(2)

In Formula (2), $R^{121}$ represents a divalent organic group, $R^{122}$ represents a tetravalent organic group, and $R^{123}$ and $R^{124}$ each independently represent a hydrogen atom or a monovalent organic group.

-$R^{121}$ -

In Formula (2), $R^{121}$ represents a divalent organic group. The divalent organic group is preferably a group including at least one of an aliphatic group (having preferably 1 to 24 carbon atoms, more preferably 1 to 12 carbon atoms, and particularly preferably 1 to 6 carbon atoms) or an aromatic group (having preferably 6 to 22 carbon atoms, more preferably 6 to 14 carbon atoms, and particularly preferably having 6 to 12 carbon atoms). Examples of the aromatic group constituting $R^{121}$ include the examples of $R^{111}$ of Formula (1). The above aliphatic group is preferably a linear aliphatic group. $R^{121}$ is preferably derived from 4,4'-oxydibenzoyl chloride.

- $R^{122}$ -

In Formula (2), $R^{122}$ represents a tetravalent organic group. The tetravalent organic group is synonymous with $R^{115}$ in Formula (1) described above, and the same applies to the preferred range. $R^{122}$ is preferably derived from 2,2'-bis (3-amino-4-hydroxyphenyl) hexafluoropropane.

- $R^{123}$ and $R^{124}$ -

$R^{123}$ and $R^{124}$ each independently represent a hydrogen atom or a monovalent organic group, are respectively synonymous with $R^{113}$ and $R^{114}$ in Formula (1) described above, and the same applies to the preferred range.
The polybenzoxazole precursor may contain another kind of repeating unit in addition to the repeating unit of Formula (2).
From the viewpoint that occurrence of warping of a pattern due to ring closure can be suppressed, the polybenzoxazole precursor preferably further contains a diamine residue represented by Formula (SL) as another kind of repeating unit.

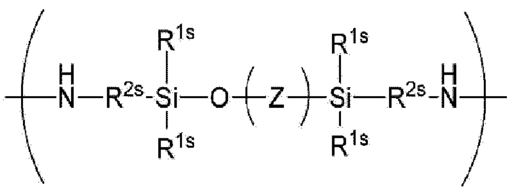

(SL)

a: 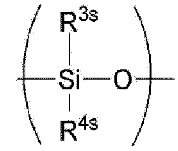 b: 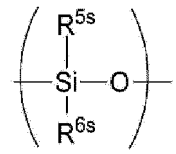

Z has an a structure and a b structure; $R^{1s}$ is a hydrogen atom or a hydrocarbon group having 1 to 10 carbon atoms (preferably 1 to 6 carbon atoms and more preferably 1 to 3 carbon atoms); $R^{2s}$ is a hydrocarbon group having 1 to 10 carbon atoms (preferably 1 to 6 carbon atoms and more preferably 1 to 3 carbon atoms); and at least one of $R^{3s}$, $R^{4s}$, $R^{5s}$, or $R^{6s}$ is an aromatic group (preferably having 6 to 22 carbon atoms, more preferably 6 to 18 carbon atoms, and particularly preferably 6 to 10 carbon atoms), and the rest are hydrogen atoms or organic groups having 1 to 30 carbon atoms (preferably 1 to 18 carbon atoms, more preferably 1 to 12 carbon atoms, and particularly preferably 1 to 6 carbon atoms), where the organic groups may be the same or different from each other. The polymerization of the a structure and the b structure may be block polymerization or random polymerization. In the Z portion, it is preferable that the a structure is 5% to 95% by mole, the b structure is 95% to 5% by mole, where a + b is 100% by mole.

In Formula (SL), examples of the preferred Z include one in which $R^{5s}$ and $R^{6s}$ in the b structure are a phenyl group. In addition, the molecular weight of the a structure represented by Formula (SL) is preferably 400 to 4,000 and more preferably 500 to 3,000. The molecular weight can be determined by gel permeation chromatography, which is generally used. In a case where the molecular weight is within the above-described range, it is possible to decrease a modulus of elasticity of a polybenzoxazole precursor after the dehydration ring closure and to achieve both effects of suppressing warping and improving solubility.

In a case where the polybenzoxazole precursor contains a diamine residue represented by Formula (SL) as another kind of repeating unit, it is preferable that a tetracarboxylic acid residue that remains after removing an acid dianhydride group from the tetracarboxylic acid dianhydride is further contained as a repeating unit from the viewpoint of improving the alkaline solubility of the photocurable resin composition. Examples of such a tetracarboxylic acid residue include the examples of $R^{115}$ in Formula (1).

The weight-average molecular weight (Mw) of the polybenzoxazole precursor is preferably 2,000 to 500,000, more preferably 5,000 to 100,000, and still more preferably 10,000 to 50,000. In addition, the number-average molecular weight (Mn) thereof is preferably 800 to 250,000, more preferably 2,000 to 50,000, and still more preferably 4,000 to 25,000.

The dispersivity of the molecular weight of the polybenzoxazole precursor is preferably 1.5 to 3.5 and more preferably 2 to 3.

-Acid value-

From the viewpoint of the film hardness of the pattern to be obtained, the acid value of the specific resin is preferably 80 mgKOH/g or less, more preferably 50 mgKOH/g or less, still more preferably 30 mgKOH/g or less, and particularly preferably 20 mgKOH/g or less. In addition, the lower limit of the acid value is preferably 5 mgKOH/g or more, more preferably 8 mgKOH/g or more, and still more preferably 10 mgKOH/g or more.

It is conceived that in a case where the acid value is within the above range, the neutralization of the specific compound is suppressed by the acid group, and thus the cyclization of the specific resin is further promoted easily.

The acid value is measured by a known method, for example, by the method described in JIS K0070: 1992.

The content of the specific resin in the photocurable resin composition according to the embodiment of the present invention is preferably 20% by mass or more, more preferably 30% by mass or more, still more preferably 40% by mass or more, even more preferably 50% by mass or more, even still more preferably 60% by mass or more, and even further still more preferably 70% by mass or more, with respect to the total solid content of the photocurable resin composition. In addition, the content of the specific resin in the photocurable resin composition according to the embodiment of the present invention is preferably 99.5% by mass or less, more preferably 99% by mass or less, still more preferably 98% by mass or less, still more preferably 97% by mass or less, and even still more preferably 95% by mass or less, with respect to the total solid content of the photocurable resin composition.

The photocurable resin composition according to the embodiment of the present invention may contain only one kind of specific resin or may contain two or more kinds thereof. In a case where two or more kinds thereof are contained, the total amount thereof is preferably within the above range.

<Another resin>

The photocurable resin composition according to the embodiment of the present invention may contain another resin (hereinafter, also simply referred to as "another resin") that is different from the specific resin.

Examples of the other resin include polyamideimide, a polyamideimide precursor, a phenol resin, polyamide, an epoxy resin, polysiloxane, a resin containing a siloxane structure, and an acrylic resin.

Further examples of the other resin include a (meth)acrylamide resin, a urethane resin, a butyral resin, a styryl resin, a polyether resin, and a polyester resin.

For example, in a case where an acrylic resin is further added, it is possible to a composition having excellent coatability, and it is possible to obtain an organic film having excellent solvent resistance.

For example, in a case where an acrylic resin having a high polymerizable base value and having a weight-average molecular weight of 20,000 or less is added to the composition instead of a polymerizable compound described later or in addition to a polymerizable compound described later, it is possible to improve the coatability of the composition, the solvent resistance of the organic film.

In a case where the photocurable resin composition according to the embodiment of the present invention contains the other resin, the content of the other resin is preferably 0.01% by mass or more, more preferably 0.05% by mass or more, still more preferably 1% by mass or more, even still more preferably 2% by mass or more, even still more preferably 5% by mass or more, and even further still more preferably 10% by mass or more, with respect to the total solid content of the composition.

In addition, the content of the other resin in the photocurable resin composition according to the embodiment of the present invention is preferably 80% by mass or less, more preferably 75% by mass or less, still more preferably 70% by mass or less, still more preferably 60% by mass or less, and even still more preferably 50% by mass or less, with respect to the total solid content of the composition.

In addition, as the preferred aspect of the photocurable resin composition according to the embodiment of the present invention, an aspect in which the content of the other resin is a low content can be adopted. In the above aspect, the content of the other resin is preferably 20% by mass or less, more preferably 15% by mass or less, still more preferably 10% by mass or less, still more preferably 5% by mass or less, and even still more preferably 1% by mass or less, with respect to the total solid content of the composition. The lower limit of the content is not particularly limited, and it may be 0% by mass or more.

The photocurable resin composition according to the embodiment of the present invention may contain only one kind of the other resin or may contain two or more kinds thereof. In a case where two or more kinds thereof are contained, the total amount thereof is preferably within the above range.

<Photosensitive compound A>

The photocurable resin composition according to the embodiment of the present invention contains the photosensitive compound A having a sensitivity to the exposure wavelength in the first exposure step.

Whether or not a photosensitive compound has a sensitivity to the exposure wavelength in the first exposure step is determined by the following method.

A photosensitive compound and polymethylmethacrylate (PMMA) are dissolved in methyl ethyl ketone to prepare a composition for forming a model film. The content of the photosensitive compound with respect to the total mass of the photosensitive compound A and PMMA in the composition for forming a model film is set to 0.5 mmol/g. In addition, the using amount of methyl ethyl ketone with respect to the total mass of the photosensitive compound A and PMMA in the composition for forming a model film may be appropriately set depending on the film thickness of the model film described later.

In a case where the photocurable resin composition contains a sensitizing agent described later, the sensitizing agent is also added to the model film so that the content mass ratio of the photosensitive compound to the sensitizing agent in the photocurable resin composition and the content mass ratio of the photosensitive compound to the sensitizing agent in the model film are the same content mass ratio.

The weight-average molecular weight of PMMA is set to 10,000.

Then, the obtained composition for forming a model film is applied onto glass and subjected to heat drying at 80°C for 1 minute to obtain a model film. The film thickness of the model film is set to be 10 μm. Then, the composition film is exposed with the same wavelength and the same irradiation amount as the those of the above exposure using the same light source as the exposure in the first exposure step.

After the exposure, the model film and the glass on which the model film has been formed are immersed in a solution of methanol/THF = 50/50 (mass ratio) for 10 minutes while applying ultrasonic waves thereto. An extract extracted into the above solution is analyzed by high performance liquid chromatography (HPLC), and then the residual rate of the photosensitive compound is calculated according to the following expression.

Residual rate of photosensitive compound (%) = amount (mol) of photosensitive compound contained in model film after exposure/content (mol) of photosensitive compound contained in model film before exposure $\times$ 100

In addition, in a case where the residual rate of the photosensitive compound is less than 80%, it is determined that the photosensitive compound is a compound having a sensitivity to the exposure wavelength in the first exposure

step. The residual rate is preferably 70% or less, more preferably 60% or less, and still more preferably 50% or less. The lower limit of the residual rate is not particularly limited, and it may be 0%.

In a case where the residual rate of the photosensitive compound is 80% or more, it is determined that the photosensitive compound is a compound having no sensitivity to the exposure wavelength in the first exposure step. The above residual rate is preferably 85% or more, more preferably 90% or more, and still more preferably 95% or more. The upper limit of the residual rate is not particularly limited, and it may be 100%.

The photosensitive compound A may have or may not have a sensitivity to the exposure wavelength in the second exposure step; however, it preferably has a sensitivity to the exposure wavelength in the second exposure step from the viewpoint of the film hardness and the solvent resistance of the pattern to be obtained.

Whether or not having a sensitivity to the exposure wavelength in the second exposure step can be determined according to a determination method of which the description of "first exposure step" is replaced with "second exposure step" in the method of determining whether or not having a sensitivity to the exposure wavelength in the first exposure step.

In the second aspect of the photocurable resin composition according to the embodiment of the present invention, the difference between the maximal absorption wavelength of the photosensitive compound A and the maximal absorption wavelength of the photosensitive compound B is 100 nm or more, and it is preferably 100 to 300 nm and more preferably 100 to 200 nm.

The maximal absorption wavelength of the photosensitive compound A is preferably 190 to 450 nm and more preferably 200 to 450 nm.

In addition, the maximal absorption wavelength of the photosensitive compound A is preferably larger than the maximal absorption wavelength of the photosensitive compound B.

The maximal absorption wavelength of the photosensitive compound is defined as the wavelength that is present on the side of the longest wavelength among the maximal absorption wavelengths in a wavelength range of 190 to450 nm.

The photosensitive compound A is a compound that changes the solubility of the photocurable film in the developer in the first exposure step.

Specifically, the photosensitive compound A is preferably a compound that undergoes a chemical change such as generation of a radical, generation of an acid, or generation of a base in the first exposure step and, in association with this structural change, has a function of changing the solubility of the photocurable film in the developer, and it is more preferably a compound that generates a radical from the first exposure step.

In addition, the photosensitive compound A is preferably a photopolymerization initiator, a photoacid generator, or a photobase generator.

[Photopolymerization initiator]

Examples of the photopolymerization initiator include a photoradical polymerization initiator and a photocationic polymerization initiator, and a photoradical polymerization initiator is preferable.

The photoradical polymerization initiator is a compound corresponding to a compound that generates a radical in the first exposure step described above.

- Photoradical polymerization initiator -

The photocurable resin composition according to the embodiment of the present invention preferably contains a photoradical polymerization initiator as the photosensitive compound A.

For example, in a case where the photocurable resin composition contains a photoradical polymerization initiator and at least one of a specific resin having an ethylenically unsaturated bond having radical polymerizability or a radical crosslinking agent described later, the radical polymerization proceeds, the solubility of the exposed portions of the photocurable film in the developer is decreased, and thus it is possible to form a negative type pattern.

The photoradical polymerization initiator is not particularly limited and can be appropriately selected, for example, from the known compounds. For example, a photoradical polymerization initiator having photosensitivity to rays ranging from an ultraviolet light range to a visible light range is preferable. In addition, the photoradical polymerization initiator may be an activator that produces an active radical by any action with a photo-excited sensitizing agent.

The photoradical polymerization initiator preferably contains at least one compound having a molar absorption coefficient of at least about 50 $L \cdot mol^{-1} \cdot cm^{-1}$ with respect to light having a wavelength within a range of about 300 to 800 nm (preferably 330 to 500 nm). The molar absorption coefficient of a compound can be measured using a well-known method. For example, it is preferable to carry out a measurement at a concentration of 0.01 g/L using an ethyl acetate solvent with an ultraviolet-visible spectrophotometer (Cary-5 spectrophotometer manufactured by Varian Medical Systems, Inc.).

As a photoradical polymerization initiator, well-known compounds can be optionally used. Examples thereof

include a halogenated hydrocarbon derivative (for example, a compound having a triazine skeleton, a compound having an oxadiazole skeleton, or a compound having a trihalomethyl group), an acylphosphine compound such as an acylphosphine oxide, hexaarylbiimidazole, an oxime compound such as an oxime derivative, an organic peroxide, a thio compound, a ketone compound, an aromatic onium salt, a keto oxime ether, an aminoacetophenone compound, hydroxyacetophenone, an azo-based compound, an azide compound, a metallocene compound, an organic boron compound, and an iron arene complex. Regarding the details thereof, the descriptions of paragraphs 0165 to 0182 of JP2016-027357A and paragraphs 0138 to 0151 of WO2015/199219A can be referenced, the contents of which are incorporated in the present specification.

Examples of the ketone compound include compounds described in paragraph 0087 of JP2015-087611A, the content of which is incorporated in the present specification. As a commercially available product thereof, KAYACURE DETX(manufactured by Nippon Kayaku Co., Ltd.) is also suitably used.

As the photoradical polymerization initiator, a hydroxyacetophenone compound, an aminoacetophenone compound, and an acylphosphine compound can also be suitably used. More specifically, for example, the aminoacetophenone-based initiator described in JP1998-291969A (JP-H10-291969A) and the acylphosphine oxide-based initiator described in JP4225898B can also be used.

As a hydroxyacetophenone-based initiator, IRGACURE 184 (IRGACURE is a registered trade name), IRGACURE 1173, DAROCUR 1173, IRGACURE 500, IRGACURE-2959, IRGACURE 127 (trade names: all manufactured by BASF SE), Omnirad 184, Omnirad 1173, Omnirad 2959, Omnirad 127 (product names: all manufactured by IGM Resisns B.V.) can be used.

As the aminoacetophenone-based initiator, commercially available products such as IRGACURE 907, IRGACURE 369, and IRGACURE 379 (product names: all manufactured by BASF SE), and Omnirad 907, Omnirad 369, and Omnirad 379 (all manufactured by IGM Resins B.V.) can be used.

As the aminoacetophenone-based initiator, the compound described in JP2009-191179A, an absorption maximum wavelength of which is matched to a light source having a wavelength such as 365 nm or 405 nm, can also be used.

Examples of the acylphosphine-based initiator include 2,4,6-trimethylbenzoyl-diphenyl-phosphine oxide. In addition, commercially available products such as IRGACURE 819 and IRGACURE TPO (product names: all manufactured by BASF SE), and Omnirad 819 and Omnirad TPO (all manufactured by IGM Resins B.V.) can be used.

Examples of the metallocene compound include IRGACURE 784 (manufactured by BASF SE).

Examples of the more preferred photoradical polymerization initiator include an oxime compound. In a case where an oxime compound is used, exposure latitude can be more effectively improved. The oxime compound is particularly preferable since the oxime compound has a wide exposure latitude (a wide exposure margin) and also works as a photocuring accelerator.

As specific examples of the oxime compound, the compound described in JP2001-233842A, the compound described in JP2000-080068A, and the compound described in JP2006-342166A can be used.

Examples of the preferred oxime compound include compounds having the following structures, 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3 -(4-toluenesulfonyloxy)iminobutan-2-one, and 2-ethoxycarbonyloxyimino-1-phenylpropan-1-one. In the photocurable resin composition according to the embodiment of the present invention, it is particularly preferable to use an oxime compound (an oxime-based photoradical polymerization initiator) as the photoradical polymerization initiator. The oxime compound, which is a photoradical polymerization initiator, has a linking group represented by >C=N-O-C(=O)-in the molecule.

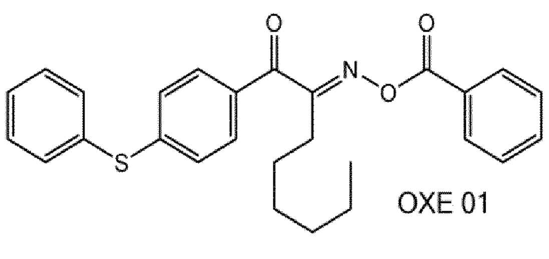
OXE 01

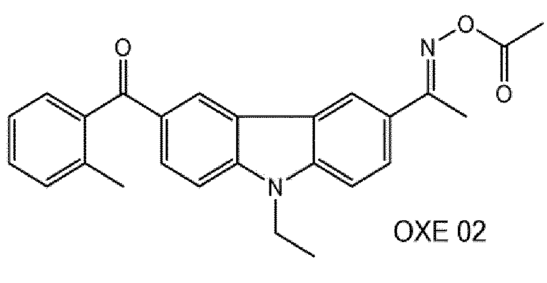
OXE 02

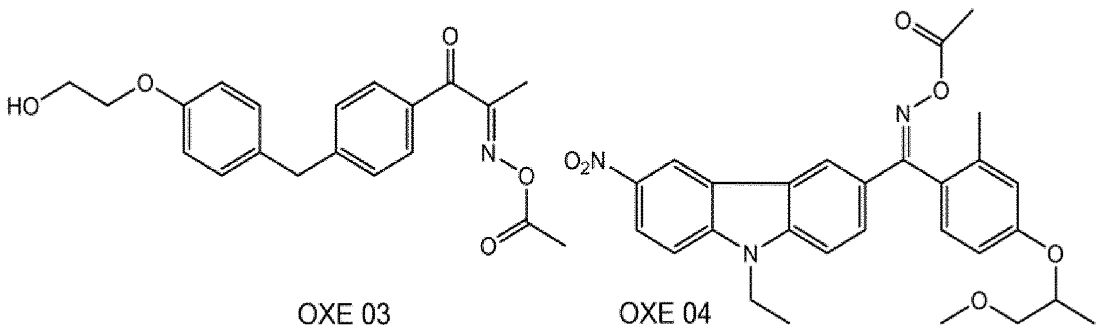

OXE 03 OXE 04

As commercially available products, IRGACURE OXE 01, IRGACURE OXE 02, IRGACURE OXE 03, IRGACURE OXE 04 (all manufactured by BASF SE), ADEKA OPTOMERN-1919 (manufactured by ADEKA Corporation, the photoradical polymerization initiator 2 described in JP2012-014052A) are also suitably used. In addition, TR-PBG-304 (manufactured by Changzhou Tronly New Electronic Materials Co., Ltd.), ADEKA ARKLS NCI-831, and ADEKA ARKLS NCI-930 (manufactured by ADEKA Corporation) can also be used. In addition, DFI-091 (manufactured by DAITO CHEMIX Co., Ltd.) can be used.

It is also possible to use an oxime compound having a fluorine atom. Specific examples of such oxime compounds include compounds described in JP2010-262028A, compounds 24, and 36 to 40 described in paragraph 0345 of JP2014-500852A, and a compound (C-3) described in paragraph 0101 of JP2013-164471A.

As the most preferable oxime compound, oxime compounds having a specific substituent described in JP2007-269779A or oxime compounds having a thioaryl group shown in JP2009-191061A, and the like are mentioned.

From the viewpoint of exposure sensitivity, the photoradical polymerization initiator is preferably a compound selected from the group consisting of a trihalomethyltriazine compound, a benzyl dimethyl ketal compound, an $\alpha$-hydroxy ketone compound, an a-aminoketone compound, an acylphosphine compound, a phosphine oxide compound, a metallocene compound, an oxime compound, a triaryl imidazole dimer, an onium salt compound, a benzothiazole compound, a benzophenone compound, an acetophenone compound and a derivative thereof, a cyclopentadiene-benzene-iron complex and a salt thereof, a halomethyl oxadiazole compound, and a 3-aryl substituted coumarin compound.

The photoradical polymerization initiator is more preferably a trihalomethyltriazine compound, an $\alpha$-aminoketone compound, an acylphosphine compound, a phosphine oxide compound, a metallocene compound, an oxime compound, a triaryl imidazole dimer, an onium salt compound, a benzophenone compound, or an acetophenone compound, still more preferably at least one compound selected from the group consisting of a trihalomethyltriazine compound, an $\alpha$-aminoketone compound, an oxime compound, a triaryl imidazole dimer, and a benzophenone compound. A metallocene compound or an oxime compound is still more preferably used, and an oxime compound is even still more preferable.

In addition, as the photoradical polymerization initiator, it is possible to use benzophenone, an N,N'-tetraalkyl-4,4'-diaminobenzophenone such as N,N'-tetramethyl-4,4'-diaminobenzophenone (Michler's ketone), an aromatic ketone such as 2-benzyl-2-dimethylamino-1-(4-morpholinophenyl)-butanone-1,2-methyl-1-[4-(methylthio)ph enyl]-2-morpholino-propanone-1, quinones fused with an aromatic ring such as an alkylanthraquinone, a benzoin ether compound such as a benzoin alkyl ether, a benzoin compound such as benzoin or an alkyl benzoin, a benzyl derivative such as benzyl dimethyl ketal, or the like. In addition, a compound represented by Formula (I) may also be used.

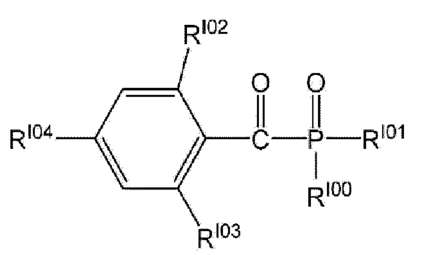

(I)

In Formula (I), $R^{I00}$ represents an alkyl group having 1 to 20 carbon atoms, an alkyl group having 2 to 20 carbon atoms, which is interrupted by one or more oxygen atoms, an alkoxy group having 1 to 12 carbon atoms, a phenyl group, an alkyl group having 1 to 20 carbon atoms, an alkoxy group having 1 to 12 carbon atoms, a halogen atom, a cyclopentyl group, a cyclohexyl group, an alkenyl group having 2 to 12 carbon atoms, a phenyl group substituted with at least one of an alkyl group having 2 to 18 carbon atoms, which is interrupted by one or more oxygen atoms or an alkyl group having 1 to 4 carbon atoms, or a biphenyl group, $R^{I01}$ is a group represented by Formula (II) or a group which is the same as $R^{I00}$, and $R^{I02}$ to $R^{I04}$ each independently represent an alkyl having 1 to 12 carbon atoms, an alkoxy group

having 1 to 12 carbon atoms, or a halogen.

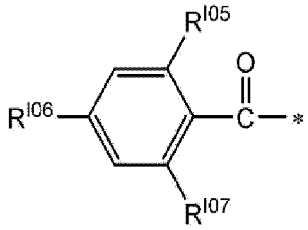

(II)

In the formula, $R^{I05}$ to $R^{I07}$ are respectively the same as $R^{I02}$ to $R^{I04}$ in Formula (I).

Further, as the photoradical polymerization initiator, the compounds described in paragraphs 0048 to 0055 of WO2015/125469A can also be used.

In a case where the photocurable resin composition contains a photoradical polymerization initiator, the content of the photoradical polymerization initiator is preferably 0.1% to 30% by mass, more preferably 0.1% to 20% by mass, still more preferably 0.5% to 15% by mass, and still more preferably 1.0% to 10% by mass, with respect to the total solid content of the photocurable resin composition according to the embodiment of the present invention. One kind of photoradical polymerization initiator may be contained alone, or two or more kinds thereof may be contained. In a case where two or more kinds of photoradical polymerization initiators are contained, the total thereof is preferably within the above-described range.

Since the photopolymerization initiator may also function as a thermal polymerization initiator, crosslinking with the photopolymerization initiator may be further promoted by heating an oven, a hot plate, or the like.

[Photoacid generator]

The photocurable resin composition according to the embodiment of the present invention preferably contains a photoacid generator as the photosensitive compound A.

In a case where a photoacid generator is contained, for example, an acid is generated in exposed portions of the photocurable film, the solubility of the exposed portions in the developer (for example, the alkaline aqueous solution) is increased, whereby it possible to obtain a positive type relief pattern in which the exposed portions are removed by the developer.

In addition, in a case where the photocurable resin composition contains a photoacid generator and a crosslinking agent described later, for example, an aspect in which the crosslinking reaction of the crosslinking agent is promoted by the acid generated in the exposed portions, and the exposed portions are difficult to be removed by the developer as compared with the unexposed portions can be adopted. According to such an aspect, a negative type relief pattern can be obtained.

The photoacid generator is not particularly limited as long as it generates an acid upon exposure; however, examples thereof include a quinone diazide compound, an onium salt compound such as a diazonium salt, a phosphonium salt, a sulfonium salt, or an iodonium salt, and a sulfonate compound such as an imide sulfonate, an oxime sulfonate, a diazodisulfone, a disulfone, or an o-nitrobenzyl sulfonate.

Examples of the quinone diazide compound include a compound in which sulfonic acid of quinone diazide is bonded to a polyhydroxy compound by an ester bond, a compound in which sulfonic acid of quinone diazide is bonded to a polyamino compound by an amide bond, and a compound in which sulfonic acid of quinone diazide is bonded to a polyhydroxypolyamino compound by at least one of an ester bond or a sulfonamide bond. In the present invention, for example, it is preferable that 50% by mole or more of all functional groups of this polyhydroxy compound or polyamino compound is substituted with quinone diazide.

In the present invention, as the quinone diazide, any one of a 5-naphthoquinonediazidosulfonyl group or a 4-naphthoquinonediazidosulfonyl group is preferably used. The 4-naphthoquinonediazidosulfonyl ester compound has an absorption in the i-line range of the mercury lamp and thus is suitable for the i-line exposure. The 5-naphthoquinonediazidosulfonyl ester compound has an absorption extending to the g-line range of the mercury lamp and thus is suitable for the g-line exposure. In the present invention, it is preferable to select a 4-naphthoquinonediazidosulfonyl ester compound or a 5-naphthoquinonediazidosulfonyl ester compound depending on the wavelength for exposure. In addition, in the same molecule, a naphthoquinonediazidosulfonyl ester compound having a 4-naphthoquinonediazidosulfonyl group or a 5-naphthoquinonediazidosulfonyl group may be contained, or a 4-naphthoquinonediazidosulfonyl ester compound and a 5-naphthoquinonediazidosulfonyl ester compound may be contained.

The naphthoquinone diazide compound can be synthesized by an esterification reaction between a compound having a phenolic hydroxy group and a quinone diazide sulfonic acid compound and can be synthesized by a known

method. In a case where this naphthoquinone diazide compound is used, it is possible to further improve resolution, sensitivity, and residual film rate.

Examples of the onium salt compound or the sulfonate compound include the compounds described in paragraphs 0064 to 0122 of JP2008-013646.

In addition, a commercially available product may be used as the photoacid generator. Examples of the commercially available product include WPAG-145, WPAG-149, WPAG-170, WPAG-199, WPAG-336, WPAG-367, WPAG-370, WPAG-469, WPAG-638, and WPAG-699 (all manufactured by FUJIFILM Wako Pure Chemical Corporation), Omnicat 250, and Omnicat 270 (all manufactured by IGM Resins B.V.), IRGACURE 250, IRGACURE 270, and IRGACURE 290 (all manufactured by BASF SE).

In a case where a photoacid generator is contained, the content thereof is preferably 0.1% to 30% by mass, more preferably 0.1% to 20% by mass, and still more preferably 2% to 15% by mass, with respect to the total solid content of the photocurable resin composition according to the embodiment of the present invention. One kind of photoacid generator may be contained, or two or more kinds thereof may be contained. In a case where two or more kinds of photoacid generators are contained, the total thereof is preferably within the above-described range.

<Photobase generator>

The photocurable resin composition according to the embodiment of the present invention may contain a photobase generator as the photosensitive compound A.

In a case where the photocurable resin composition contains a photobase generator and a crosslinking agent described later, for example, an aspect in which the base generated in the exposed portions promotes the cyclization of the specific resin, the crosslinking reaction of the crosslinking agent, and the like, and thus the exposed portions are difficult to be removed by the developer as compared with the unexposed portions can be adopted. According to such an aspect, a negative type relief pattern can be obtained.

The photobase generator is not particularly limited as long as it generates a base upon exposure, and a known one can be used.

Examples thereof include a transition metal compound complex, a compound having a structure such as an ammonium salt, an ionic compound that is neutralized by a base component forming a salt, like a compound that is made to be latent by an amidine portion forming a salt with a carboxylic acid, and a nonionic compound in which a base component is made to be latent by a urethane bond or an oxime bond, such as a carbamate derivative, an oxime ester derivative, or an acyl compound, as described in M. Shirai, and M. Tsunooka, Prog. Polym. Sci., 21, 1 (1996); Masahiro Tsunooka, Polymer application, 46, 2 (1997); C. Kutal, Coord. Chem. Rev., 211, 353 (2001); Y. Kaneko, A. Sarker, and D. Neckers, Chem. Mater., 11, 170 (1999); H. Tachi, M. Shirai, and M. Tsunooka, J. Photopolym. Sci. Technol., 13, 153 (2000); M. Winkle, and K. Graziano, J. Photopolym. Sci. Technol., 3, 419 (1990); M. Tsunooka, H. Tachi, and S. Yoshitaka, J. Photopolym. Sci. Technol, 9, 13 (1996); and K. Suyama, H. Araki, M. Shirai, J. Photopolym. Sci. Technol, 19, 81 (2006).

In the present invention, examples of the more preferred photobase generator include a carbamate derivative, an amide derivative, an imide derivative, α-cobalt complexes, an imidazole derivative, a cinnamic acid amide derivative, and an oxime derivative.

The basic substance that is generated from the photobase generator is not particularly limited, and examples thereof include a compound having an amino group, particularly a polyamine such as a monoamine or a diamine, and an amidine.

From the viewpoint of the imidization rate, it is preferable that the basic substance is such that the conjugate acid thereof has a large pKa in dimethyl sulfoxide (DMSO). The pKa is preferably 1 or more and more preferably 3 or more. The upper limit of the pKa is not particularly limited; however, it is preferably 20 g or less.

Here, pKa indicates the logarithm of the reciprocal of the first dissociation constant of acid, and the values described in the following documents can be referenced, Determination of Organic Structures by Physical Methods (authors: Brown, H. C, McDaniel, D. H., Hafliger, O., and Nachod, F. C.; edited by Braude, E. A., Nachod, F. C.; Academic Press, New York, 1955) and Data for Biochemical Research (authors: Dawson, R. M. C. et al; Oxford, Clarendon Press, 1959). Regarding a compound not described in these documents, a value calculated from the structural formula by using software of ACD/pKa (manufactured by ACD/Labs) shall be used as the pKa.

From the viewpoint of storage stability of the photocurable resin composition, the photobase generator is preferably a photobase generator that does not contain a salt in the structure thereof, and it is preferable that the nitrogen atom of the base portion that is generated in the photobase generator has no charge. In the photobase generator, it is preferable that the base to be generated is made to be latent using a covalent bond, and it is more preferable that the mechanism of base generation is such that the covalent bond between the nitrogen atom of the base portion to be generated and the adjacent atom is cleaved to generate the base. In a case of a photobase generator that contains no salt in the structure thereof, the photobase generator can be made to be neutral, and thus the solvent solubility is better, whereby the pot life is improved. Due to such reasons, the amine generated from the photobase generator that is used

in the present invention is preferably a primary amine or a secondary amine.

Further, from the viewpoint of chemical resistance of the pattern, the photobase generator is preferably a photobase generator containing a salt in the structure.

In addition, due to the above reason, in the photobase generator, the base to be generated as described above is preferably made to be latent by using a covalent bond, and the base to be generated is more preferably made to be latent by using an amide bond, a carbamate bond, or an oxime bond.

Examples of the photobase generator according to the embodiment of the present invention include photobase generators having a cinnamic acid amide structure, such as those as disclosed in JP2009-080452A and WO2009/123122A, photobase generators having a carbamate structure, such as those disclosed in JP2006-189591A and JP2008-247747A, photobase generators having an oxime structure or a carbamoyl oxime structure, such as those disclosed in JP2007-249013A and JP2008-003581A; however, the photobase generator is not limited to these, and other known photobase generator structures can be used.

In addition, examples of the photobase generator include the compounds described in paragraph numbers 0185 to 0188, 0199 to 0200, and 0202 of JP2012-093746A, the compounds described in paragraph numbers 0022 to 0069 of JP2013-194205A, the compounds described in paragraph numbers 0026 to 0074 of JP2013-204019A, and the compounds described in paragraph number 0052 of WO2010/064631A.

In addition, a commercially available product may be used as the photobase generator. Examples of the commercially available product thereof include WPBG-266, WPBG-300, WPGB-345, WPGB-140, WPBG-165, WPBG-027, WPBG-018, WPGB-015, WPBG-041, WPGB-172, WPGB-174, WPBG-166, WPGB-158, WPGB-025, WPGB-168, WPGB-167, and WPBG-082 (all manufactured by FUJIFILM Wako Pure Chemical Corporation), A2502, B5085, N0528, N1052, O0396, O0447, and O0448 (Tokyo Chemical Industry Co., Ltd.)

In a case where a photobase generator is contained, the content thereof is preferably 0.1% to 30% by mass, more preferably 0.1% to 20% by mass, and still more preferably 2% to 15% by mass, with respect to the total solid content of the photocurable resin composition according to the embodiment of the present invention. Only one kind of the photobase generator may be contained, or two or more kinds thereof may be contained. In a case where two or more kinds of photobase generators are contained, the total thereof is preferably within the above-described range.

<Photosensitive compound B>

In the pattern forming method according to the embodiment of the present invention, the photocurable resin composition contains the photosensitive compound B which is a compound having a sensitivity to the exposure wavelength in the second exposure step.

The fact that it has a sensitivity to the exposure wavelength in the second exposure step is determined by the same method as the method of determining whether or not having a sensitivity, described in the explanation of the photosensitive compound A described above.

In the first aspect, examples of the photosensitive compound B include the same photopolymerization initiator as the photosensitive compound A described above, a photoacid generator, and a photobase generator.

The photosensitive compound B may be a compound having a sensitivity to the same exposure wavelength as the compound selected as the photosensitive compound A; however, it is preferably a compound having a sensitivity to a different exposure wavelength.

As an example, in a case where a photoradical polymerization initiator having a sensitivity in the vicinity of 365 nm is used as the photosensitive compound A, a photobase generator having a sensitivity in the vicinity of 254 nm can be used as the photosensitive compound B.

In addition, as another example, in a case where a photobase generator having a sensitivity in the vicinity of 365 nm is used as the photosensitive compound A, a photoacid generator having a sensitivity in the vicinity of 216 nm can also be used as the photosensitive compound B.

In the second aspect of the photocurable resin composition according to the embodiment of the present invention, the difference between the maximal absorption wavelength of the photosensitive compound A and the maximal absorption wavelength of the photosensitive compound B is as described above.

The maximal absorption wavelength of the photosensitive compound B is preferably 190 to 550 nm, more preferably 200 to 550 nm, and still more preferably 200 to 450 nm.

The maximal absorption wavelength of the photosensitive compound B is measured by the method described above.

In the second aspect of the photocurable resin composition, examples of the photosensitive compound B includes a compound that is the photopolymerization initiator, the photoacid generator, or the photobase generator, which is the same as the photosensitive compound A described above, where the compound has a maximal absorption wavelength separated by 100 nm or more from that of a compound selected as the photosensitive compound A.

As an example, in a case where a photoradical polymerization initiator having a maximal absorption wavelength

in the vicinity of 365 nm is used as the photosensitive compound B, a photobase generator having a maximal absorption wavelength in the vicinity of 254 nm can be used as the photosensitive compound B.

In addition, as another example, in a case where a photobase generator having a sensitivity in the vicinity of 365 nm is used as the photosensitive compound A, a photoacid generator having a sensitivity in the vicinity of 216 nm can also be used as the photosensitive compound B.

In a case where a photopolymerization initiator, a photoacid generator, or a photobase generator is used as the photosensitive compound B, the preferred content of this compound is the same as the preferred content of this compound in a case of being used as the photosensitive compound A.

In addition, the preferred combination of the photosensitive compound A and the photosensitive compound B is as described in the aspect 1 to the aspect 5 described above.

<Solvent>

The photocurable resin composition according to the embodiment of the present invention preferably contains a solvent.

As the solvent, any known solvent can be used. The solvent is preferably an organic solvent. Examples of the organic solvent include compounds such as esters, ethers, ketones, aromatic hydrocarbons, sulfoxides, and amides.

Further, compounds such as cyclic hydrocarbons, ureas, and alcohols are also preferable.

Suitable examples of the esters include ethyl acetate, n-butyl acetate, isobutyl acetate, amyl formate, isoamyl acetate, butyl propionate, isopropyl butyrate, ethyl butyrate, butyl butyrate, methyl lactate, ethyl lactate, γ-butyrolactone, ε-caprolactone, δ-valerolactone, alkyl alkyloxyacetate (for example, methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (for example, methyl 3-alkyloxypropionate, and ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (for example, methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methylpropionate and ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, and ethyl 2-oxobutanoate.

Suitable examples of the ethers include diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, and propylene glycol monopropyl ether acetate.

Suitable examples of the ketones include methyl ethyl ketone, cyclohexanone, cyclopentanone, 2-heptanone, and 3-heptanone.

Suitable examples of the aromatic hydrocarbons include toluene, xylene, anisole, and limonene.

Suitable examples of the sulfoxides include dimethyl sulfoxide.

Suitable examples of the amides include N-methyl-2-pyrrolidone, N-ethyl-2-pyrrolidone, N,N-dimethylacetamide, and N,N-dimethylformamide.

Suitable examples of the urea include N,N,N',N'-tetramethylurea and 1,3-dimethyl-2-imidazolidinone.

Examples of the alcohols include methanol, ethanol, 1-propanol, 2-propanol, 1-butanol, 1-pentanol, 1-hexanol, benzyl alcohol, ethylene glycol monomethyl ether, 1-methoxy-2-propanol, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenyl carbinol, n-amyl alcohol, methylamyl alcohol, and diacetone alcohol.

From the viewpoint of improving the properties of a coated surface or the like, it is also preferable to mix two or more kinds of solvents.

In the present invention, the solvent is preferably one solvent selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ-butyrolactone, dimethyl sulfoxide, ethyl carbitol acetate, butyl carbitol acetate, N-methyl-2-pyrrolidone, propylene glycol methyl ether, and propylene glycol methyl ether acetate, or a mixed solvent composed of two or more solvents selected therefrom. A combined use of dimethyl sulfoxide and γ-butyrolactone is particularly preferable.

Alternatively, a combined use of N-methyl-2-pyrrolidone and ethyl lactate is particularly preferable.

From the viewpoint of coatability, the content of the solvent is such that the total solid content concentration of

the photocurable resin composition according to the embodiment of the present invention is preferably 5% to 80% by mass, more preferably 5% to 75% by mass, still more preferably 10% to 70% by mass, and even still more preferably 40% to 70% by mass. The content of the solvent may be adjusted depending on the desired thickness of the coating film and the coating method.

One kind of solvent may be contained, or two or more kinds thereof may be contained. In a case where two or more kinds of solvents are contained, the total thereof is preferably within the above-described range.

<Crosslinking Agent>

The photocurable resin composition according to the embodiment of the present invention preferably contains a crosslinking agent.

The crosslinking agent is preferably a crosslinking agent having a group in which a bonding reaction with another group is promoted by the photosensitization of the photosensitive compound B in the second exposure step under the condition 2 described above.

Examples of the crosslinking agent include a radical crosslinking agent and another crosslinking agent.

<Radical crosslinking agent>

The photocurable resin composition according to the embodiment of the present invention preferably further contains a radical crosslinking agent.

The radical crosslinking agent is a compound having a radically polymerizable group. The radically polymerizable group is preferably a group containing an ethylenically unsaturated bond. Examples of the group containing the ethylenically unsaturated bond include groups having an ethylenically unsaturated bond, such as a vinyl group, an allyl group, a vinylphenyl group, and a (meth)acryloyl group.

Among these, the (meth)acryloyl group is preferable as the group containing the ethylenically unsaturated bond, and a (meth)acryloxy group is more preferable from the viewpoint of reactivity.

It is sufficient that the radical crosslinking agent is a compound having one or more ethylenically unsaturated bonds; however, a compound having two or more ethylenically unsaturated bonds is more preferable.

The compound having two ethylenically unsaturated bonds is preferably a compound having two groups containing the above ethylenically unsaturated bond.

In addition, from the viewpoint of the film hardness of the pattern to be obtained, the photocurable resin composition according to the embodiment of the present invention preferably contains a compound having three or more ethylenically unsaturated bonds as the radical crosslinking agent. The compound having 3 or more ethylenically unsaturated bonds is preferably a compound having 3 to 15 ethylenically unsaturated bonds, more preferably a compound having 3 to 10 ethylenically unsaturated bonds, and still more preferably a compound having 3 to 6 ethylenically unsaturated bonds.

In addition, the compound having 3 or more ethylenically unsaturated bonds is preferably a compound having 3 or more groups containing the ethylenically unsaturated bond, more preferably a compound having 3 to 15 groups containing the ethylenically unsaturated bond, still more preferably a compound having 3 to 10 groups containing the ethylenically unsaturated bond, and particularly preferably a compound having 3 to 6 groups containing the ethylenically unsaturated bond.

In addition, from the viewpoint of the film hardness of the pattern to be obtained, the photocurable resin composition according to the embodiment of the present invention preferably contains a compound having two ethylenically unsaturated bonds and a compound having three or more ethylenically unsaturated bonds.

The molecular weight of the radical crosslinking agent is preferably 2,000 or less, more preferably 1,500 or less, and still more preferably 900 or less. The lower limit of the molecular weight of the radical crosslinking agent is preferably 100 or more.

Specific examples of the radical crosslinking agent include unsaturated carboxylic acids (for example, acrylic acid, methacrylic acid, itaconic acid, crotonic acid, isocrotonic acid, and maleic acid), and esters and amides thereof, and esters formed from unsaturated carboxylic acids and polyhydric alcohol compounds or amides formed from unsaturated carboxylic acids and polyvalent amine compounds are preferable. In addition, addition reaction products produced by reacting unsaturated carboxylic acid esters or amides, having a nucleophilic substituent such as a hydroxy group, an amino group, or a sulfanyl group, with monofunctional or polyfunctional isocyanates or epoxies, dehydration condensation reaction products produced by reacting the above esters or amides with a monofunctional or polyfunctional carboxylic acid, or the like are also suitably used. In addition, an addition reaction product produced by reacting unsaturated carboxylic acid esters or amides, having an electrophilic substituent such as an isocyanate group or an epoxy group, with monofunctional or polyfunctional alcohols, amines, or thiols, and further, a substitution reaction product produced by reacting unsaturated carboxylic acid esters or amides, having an eliminable substituent such as a halogen

group or a tosyloxy group, with monofunctional or polyfunctional alcohols, amines, or thiols are also suitable. In addition, as other examples, it is also possible to use a group of compounds in which the unsaturated carboxylic acid described above is replaced with an unsaturated phosphonic acid, a vinylbenzene derivative such as styrene, a vinyl ether, an allyl ether, or the like. Regarding the specific examples thereof, reference can be made to the description of paragraphs 0113 to 0122 of JP2016-027357A, the content of which is incorporated in the present specification.

In addition, the radical crosslinking agent is also preferably a compound having a boiling point of 100°C or higher under atmospheric pressure. Examples thereof include a compound obtained by adding ethylene oxide or propylene oxide to a polyfunctional alcohol such as polyethylene glycol di(meth)acrylate, trimethylolethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexanediol (meth)acrylate, trimethylolpropane tri(acryloyloxypropyl)ether, tri(acryloyloxyethyl)isocyanurate, glycerin, and trimethylolethane, and then being subjected to (meth)acrylation, urethane (meth)acrylates respectively described in JP1973-041708B (JP-S48-041708B), JP1975-006034B (JP-S50-006034B), and JP1976-037193A (JP-S51-037193A), polyester acrylates respectively described in JP1973-064183A (JP-S48-064183A), JP1974-043191B (JP-S49-043191B), and JP1977-030490B (JP-S52-030490B), polyfunctional acrylates or methacrylates such as epoxy acrylates which are reaction products of epoxy resins and (meth)acrylic acid, and mixtures thereof. In addition, the compounds described in paragraphs 0254 to 0257 of JP2008-292970A are also suitable. Further, the polyfunctional (meth)acrylate or the like obtained by reacting a compound having a cyclic ether group with an ethylenically unsaturated bond, such as glycidyl (meth)acrylate, with polyfunctional carboxylic acid can also be mentioned.

In addition, as the preferred radical crosslinking agent other than those described above, a compound having two or more groups containing a fluorene ring and an ethylenically unsaturated bond and a cardo resin, which are described in JP2010-160418A, JP2010-129825A, and JP4364216B, can also be used.

Further, other examples thereof include the specific unsaturated compounds described in JP1971-043946B (JP-S46-043946B), JP1989-040337B (JP-H01-040337B), and JP1989-040336B (JP-H01-040336B), and the vinylphosphonic acid-based compound described in JP1990-025493A (JP-H02-025493A). In addition, the compounds containing a perfluoroalkyl group described in JP1986-022048A (JP-S61-022048A) can also be used. Furthermore, photopolymerizable monomers and oligomers which are described in Journal of the Adhesion Society of Japan, Vol. 20, No. 7, pages 300 to 308 (1984) can also be used.

In addition to the above, the compounds described in paragraphs 0048 to 0051 of JP2015-034964A and the compounds described in paragraphs 0087 to 0131 of WO2015/199219A can also be preferably used, the contents of which are incorporated in the present specification.

In addition, the compounds which are represented as Formula (1) and Formula (2) in JP1998-062986A (JP-H10-062986A), described together with the specific examples thereof, which are obtained by adding ethylene oxide or propylene oxide to a polyfunctional alcohol and then being subjected to (meth)acrylation can be used as a radical crosslinking agent.

Further, the compounds described in paragraphs 0104 to 0131 of JP2015-187211A can also be used as the radical crosslinking agent, the content of which is incorporated in the present specification.

As the radical crosslinking agent, dipentaerythritol triacrylate (as a commercially available product, KAYARAD D-330; manufactured by Nippon Kayaku Co., Ltd.), dipentaerythritol tetraacrylate (as a commercially available product, KAYARAD D-320; Nippon Kayaku Co., Ltd., A-TMMT: manufactured by Shin-Nakamura Chemical Co., Ltd.), dipentaerythritol penta(meth)acrylate (as a commercially available product, KAYARAD D-310; manufactured by Nippon Kayaku Co., Ltd.), dipentaerythritol hexa(meth)acrylate (as a commercially available product, KAYARAD DPHA; by Nippon Kayaku Co., Ltd., A-DPH; manufactured by Shin-Nakamura Chemical Co., Ltd.), or a structure in which a (meth)acryloyl group thereof is bonded through an ethylene glycol residue or a propylene glycol residue is preferable. Oligomer types thereof can also be used.

Examples of the commercially available product of the radical crosslinking agent include SR-494 which is a tetrafunctional acrylate having four ethyleneoxy chains, manufactured by Sartomer Company Inc., SR-209, 231, and 239 which are a difunctional methacrylate having four ethyleneoxy chains, manufactured by Sartomer Company Inc., DPCA-60 which is a hexafunctional acrylate having six pentyleneoxy chains, manufactured by Nippon Kayaku Co., Ltd., TPA-330 which is a trifunctional acrylate having three isobutylene oxy chains, a urethane oligomer UAS-10, UAB-140 (manufactured by Nippon Paper Industries Co., Ltd.), NK Ester M-40G, NK Ester 4G, NK Ester M-9300, NK Ester A-9300, UA-7200 (manufactured by Shin-Nakamura Chemical Co., Ltd.), DPHA-40H (manufactured by Nippon Kayaku Co., Ltd.), UA-306H, UA-306T, UA-306I, AH-600, T-600, AI-600 (manufactured by KYOEISHA CHEMICAL Co., Ltd.), and Brenmer PME400 (manufactured by NOF Corporation).

As the radical crosslinking agent, the urethane acrylates as described in JP1973-041708B (JP-S48-041708B), JP1976-037193A (JP-S51-037193A), JP1990-032293B (JP-H02-032293B), and JP1990-016765B (JP-H02-016765B), and the urethane compounds having an ethylene oxide-based skeleton described in JP1983-049860B (JP-S58-049860B), JP1981-017654B (JP-S56-017654B), JP1987-039417B (JP-S62-039417B), and JP1987-039418B (JP-S62-039418B) are also suitable. Further, as the radical crosslinking agent, the compounds having an amino structure or a sulfide structure in a molecule as described in JP1988-277653A (JP-S63-277653A), JP1988-260909A (JP-S63-260909A), and JP1989-105238A (JP-H01-105238A) can also be used.

The radical crosslinking agent may be a radical crosslinking agent having an acid group such as a carboxy group or a phosphoric acid group. The radical crosslinking agent having an acid group is preferably an ester of an aliphatic polyhydroxy compound and an unsaturated carboxylic acid and more preferably a radical crosslinking agent obtained by reacting an unreacted hydroxy group of an aliphatic polyhydroxy compound with a non-aromatic carboxylic acid anhydride to have an acid group. The radical crosslinking agent is particularly preferably a compound in which an aliphatic polyhydroxy compound is pentaerythritol or dipentaerythritol in a radical crosslinking agent having an acid group obtained by reacting an unreacted hydroxy group of the aliphatic polyhydroxy compound with a non-aromatic carboxylic acid anhydride. Examples of the commercially available product thereof include M-510 and M-520 as polybasic acid-modified acrylic oligomers which are manufactured by Toagosei Co., Ltd.

The acid value of the radical crosslinking agent having an acid group is preferably 0.1 to 40 mgKOH/g, and particularly preferably 5 to 30 mgKOH/g. In a case where the acid value of the radical crosslinking agent is within the above-described range, excellent manufacturing handleability is exhibited, and furthermore, excellent developability is exhibited. In addition, good polymerization properties are exhibited. The acid value is measured according to the description of JIS K 0070: 1992.

In the resin composition, it is preferable to use difunctional methacrylate or acrylate from the viewpoint of pattern resolution and film elasticity.

As the specific compound, the following compound can be used; triethylene glycol diacrylate, triethylene glycol dimethacrylate, tetraethylene glycol dimethacrylate, tetraethylene glycol diacrylate, and polyethylene glycol (PEG) 200 diacrylate, PEG 200 dimethacrylate, PEG 600 diacrylate, PEG 600 dimethacrylate, polytetraethylene glycol diacrylate, polytetraethylene glycol dimethacrylate, neopentyl glycol diacrylate, neopentyl glycol dimethacrylate, 3-methyl-1, 5-pentanediol diacrylate, 1,6-hexanediol diacrylate, 1,6 hexanediol dimethacrylate, dimethylol-tricyclodecanediacrylate, dimethylol-tricyclodecanedimethacrylate, a diacrylate of an ethylene oxide (EO) adduct of bisphenol A, a dimetallilate of an EO adduct of bisphenol A, a diacrylate of a propylene oxide (PO) adduct of bisphenol A, a dimetallilate of a PO adduct of bisphenol A, 2-hydroxy-3-acryloyloxypropyl methacrylate, isocyanuric acid EO-modified diacrylate, isocyanuric acid-modified dimethacrylate, another difunctional acrylate having a urethane bond, and difunctional methacrylate having a urethane bond. As necessary, two or more of these can be mixedly used.

It is noted that, for example, the PEG 200 diacrylate refers to a polyethylene glycol diacrylate having a polyethylene glycol chain formula weight of about 200.

In the photocurable resin composition according to the embodiment of the present invention, a monofunctional radical crosslinking agent can be preferably used as the radical crosslinking agent from the viewpoint of suppressing warping associated with the control of the elastic modulus of the pattern. As the monofunctional radical crosslinking agent, (meth)acrylic acid derivatives such as n-butyl (meth)acrylate, 2-ethylhexyl (meth)acrylate, 2-hydroxyethyl (meth)acrylate, butoxyethyl (meth)acrylate, carbitol (meth)acrylate, cyclohexyl (meth)acrylate, benzyl (meth)acrylate, phenoxyethyl (meth)acrylate, N-methylol (meth)acrylamide, glycidyl (meth)acrylate, polyethylene glycol mono(meth)acrylate, and polypropylene glycol mono(meth)acrylate, N-vinyl compounds such as N-vinylpyrrolidone and N-vinylcaprolactam, allyl compounds such as allyl glycidyl ether, diallyl phthalate, and triallyl trimellitate, and the like are preferably used. As the monofunctional radical crosslinking agent, a compound having a boiling point of 100°C or higher under atmospheric pressure is also preferable in order to suppress volatilization before exposure.

In a case where a radical crosslinking agent is contained, the content thereof is preferably more than 0% by mass and 60% by mass or less with respect to the total solid content of the photocurable resin composition according to the embodiment of the present invention. The lower limit thereof is more preferably 5% by mass or more. An upper limit is more preferably 50% by mass or less and still more preferably 30% by mass or less.

One kind of radical crosslinking agent may be used alone, or two or more kinds thereof may be mixedly used. In a case where two or more kinds thereof are used in combination, the total amount thereof is preferably in the above range.

<Another crosslinking agent>

The photocurable resin composition according to the embodiment of the present invention preferably contains another crosslinking agent different from the radical crosslinking agent described above.

In the present invention, the other crosslinking agent refers to a crosslinking agent other than the above-described radical crosslinking agent, and it is preferably a compound having a plurality of groups, in the molecule, which promotes a reaction of forming a covalent bond between other compounds in the composition or reaction products thereof, by the photosensitization of the above-described photosensitive compound A or photosensitive compound B, and it is preferably a compound having a plurality of groups, in the molecule, which promotes a reaction of forming a

covalent bond between other compounds in the composition or reaction products thereof, by the action of the acid or the base.

The above acid or the above base is an acid or a base, which is generated from a photoacid generator or a photobase generator, which is the photosensitive compound A or the photosensitive compound B in the first exposure step or the second exposure step.

The other crosslinking agent is preferably a compound having at least one group selected from the group consisting of a methylol group and an alkoxymethyl group, and more preferably a compound having a structure in which at least one group selected from the group consisting of a methylol group and an alkoxymethyl group is directly bonded to a nitrogen atom.

Examples of the other crosslinking agent include a compound having a structure in which formaldehyde, or formaldehyde and alcohol are reacted with an amino group-containing compound such as melamine, glycoluril, urea, an alkylene urea, or benzoguanamine to substitute a hydrogen atom of the amino group with a methylol group or an alkoxymethyl group. The method of producing these compounds is not particularly limited, and any compound having the same structure as the compound produced by the above method may be used. In addition, oligomers formed by the self-fusion of the methylol groups of these compounds may be used.

As the above amino group-containing compound, the crosslinking agent in which melamine is used is referred to as a melamine-based crosslinking agent, the crosslinking agent in which glycoluril, urea, or an alkylene urea is used is referred to a urea-based crosslinking agent, the crosslinking agent in which an alkylene urea is used is referred to as an alkylene urea-based crosslinking agent, and the crosslinking agent in which benzoguanamine is used is referred to as a benzoguanamine-based crosslinking agent.

Among these, the photocurable resin composition according to the embodiment of the present invention preferably contains at least one compound selected from the group consisting of a urea-based crosslinking agent and a melamine-based crosslinking agent and more preferably contains at least one compound selected from the group consisting of a glycoluril-based crosslinking agent described later and a melamine-based crosslinking agent.

Examples of the compound containing at least one of the alkoxymethyl group or the acyloxymethyl group in the present invention include, as a structural example, a compound in which an alkoxymethyl group or an acyloxymethyl group is directly substituted on an aromatic group or the nitrogen atom of the following urea structure, or on triazine.

The alkoxymethyl group or acyloxymethyl group contained in the above compound preferably has 2 to 5 carbon atoms, preferably 2 or 3 carbon atoms, and preferably 2 carbon atoms.

The total number of alkoxymethyl groups and acyloxymethyl groups contained in the above compound is preferably 1 to 10, more preferably 2 to 8, and particularly preferably 3 to 6.

The molecular weight of the above compound is 1,500 or less and preferably 180 to 1,200.

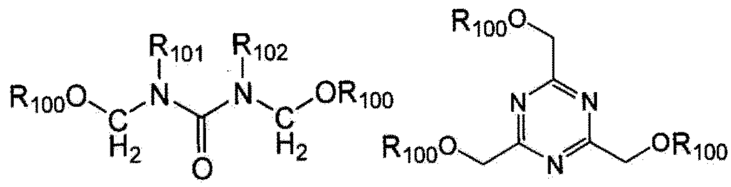

$R^{100}$ represents an alkyl group or an acyl group.

$R^{101}$ and $R^{102}$ each independently represent a monovalent organic group, and they may be bonded to each other to form a ring.

Examples of the compound in which an alkoxymethyl group or an acyloxymethyl group is directly substituted on an aromatic group include compounds such as those represented by the following general formulae.

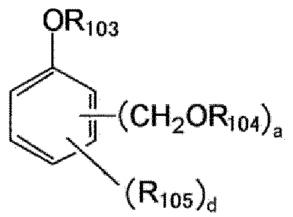

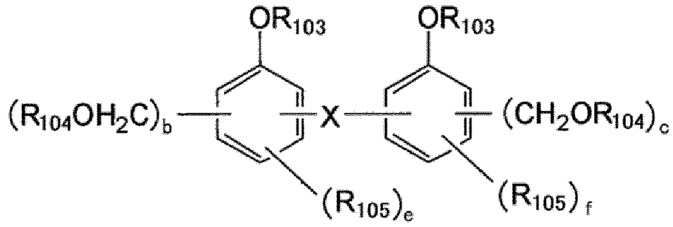

In the formula, X represents a single-bonded or divalent organic group, each $R^{104}$ independently represents an alkyl or acyl group, and $R^{103}$ represents a hydrogen atom, an alkyl group, an alkenyl group, an aryl group, an aralkyl group, or a group that decomposes under the action of acid and generates an alkali-soluble group (for example, a group

that is eliminated by under the action of acid, a group represented by $-C(R^4)_2COOR^5$ (each $R^4$ independently represents a hydrogen atom or an alkyl group having 1 to 4 carbon atoms, and $R^5$ represents a group eliminated under the action of acid)).

Each $R^{105}$ independently represents an alkyl group or an alkenyl group, a, b, and c are each independently 1 to 3, d is 0 to 4, e is 0 to 3, and f is 0 to 3, where a + d is 5 or less, b + e is 4 or less, and c + f is 4 or less.

Examples of R5 in the group that decomposes under the action of acid to generate an alkali-soluble group, a group that is eliminated under the action of acid, and a group represented by $-C(R^4)_2COOR^5$, include -C(R36)($R^{37}$)($R^{38}$), $-C(R^{36})(R^{37})(OR^{39})$, and $-C(R^{01})(R^{02})(OR^{39})$.

In the formulae, $R^{36}$ to $R^{39}$ each independently an alkyl group, a cycloalkyl group, an aryl group, an aralkyl group, or an alkenyl group. $R^{36}$ and $R^{37}$ may be bonded to each other to form a ring.

The alkyl group is preferably an alkyl group having 1 to 10 carbon atoms and more preferably an alkyl group having 1 to 5 carbon atoms.

The alkyl group may be either linear or branched.

The cycloalkyl group is preferably a cycloalkyl group having 3 to 12 carbon atoms and more preferably a cycloalkyl group having 3 to 8 carbon atoms.

The cycloalkyl group may have a monocyclic structure or a polycyclic structure such as a fused ring.

The aryl group is preferably an aromatic hydrocarbon group having 6 to 30 carbon atoms and more preferably a phenyl group.

As the aralkyl group, an aralkyl group having 7 to 20 carbon atoms is preferable, and an aralkyl group having 7 to 16 carbon atoms is more preferable.

The above-described aralkyl group is intended to be an aryl group substituted with an alkyl group, and preferred aspects of these alkyl group and aryl group are respectively the same as the above-described preferred aspects of the alkyl group and the aryl group.

The alkenyl group is preferably an alkenyl group having 3 to 20 carbon atoms and more preferably an alkenyl group having 3 to 16 carbon atoms.

Further, these groups may further have a known substituent within the scope in which the effects of the present invention are obtained.

$R^{01}$ and $R^{02}$ each independently represent a hydrogen atom, an alkyl group, a cycloalkyl group, an aryl group, an aralkyl group, or an alkenyl group.

These groups are preferably a tertiary alkyl ester group, an acetal ester group, a cumyl ester group, an enol ester group, or the like. They are more preferably a tertiary alkyl ester group or an acetal ester group.

Specific examples of the compound having an alkoxymethyl group include the following structures. Examples of the compound having an acyloxymethyl group include compounds in which the alkoxymethyl group of the following compounds is changed to an acyloxymethyl group. Examples of the compound having an alkoxymethyl group or acyloxymethyl in the molecule include, but are not limited to, the following compounds.

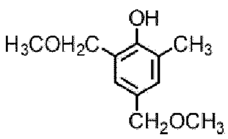
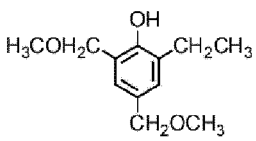
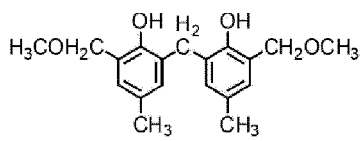

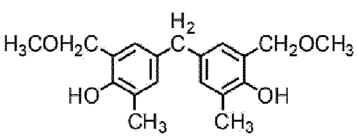
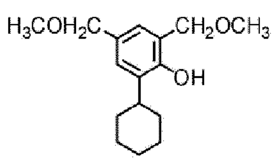
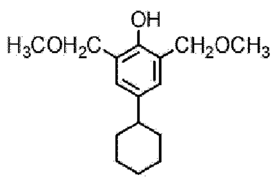

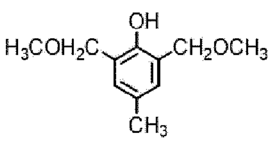
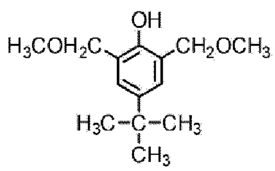
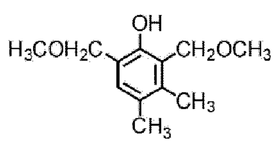

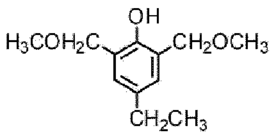
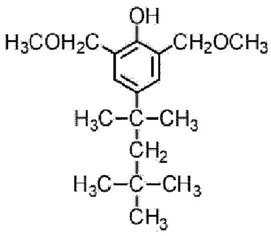
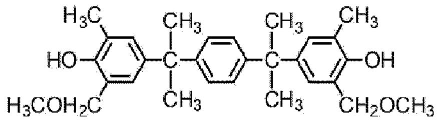

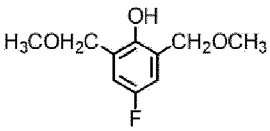
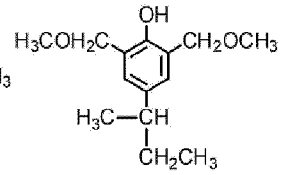
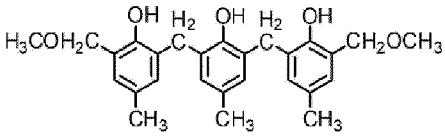

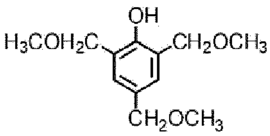
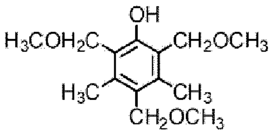
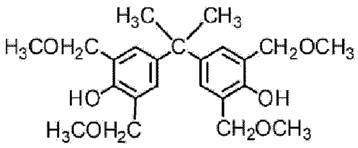

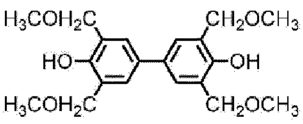
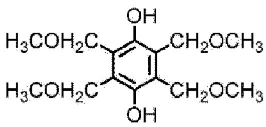
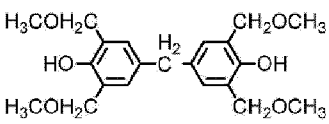

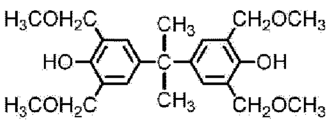
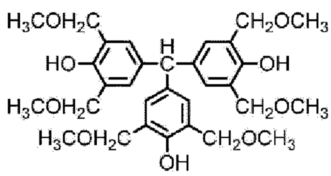
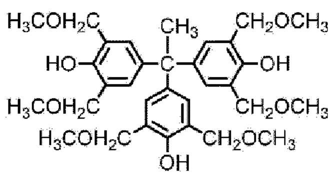

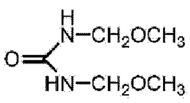
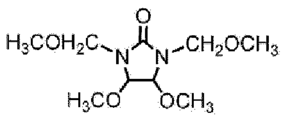
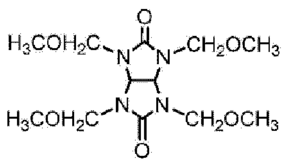

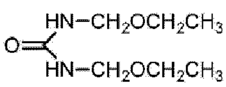
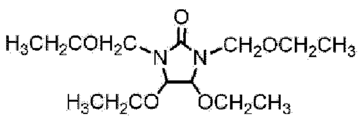
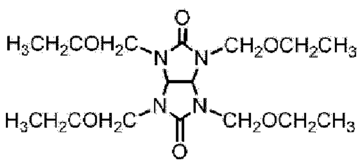

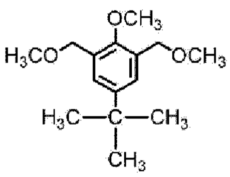
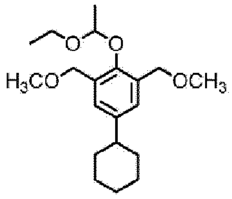
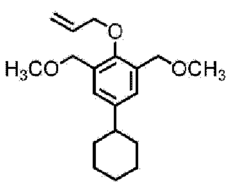
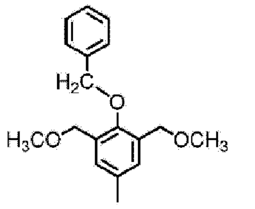

As the compound containing at least one of an alkoxymethyl group and an acyloxymethyl group, a commercially

available compound may be used, or a compound synthesized by a known method may be used.

From the viewpoint of heat resistance, a compound in which an alkoxymethyl group or an acyloxymethyl group is directly substituted on an aromatic ring or a triazine ring is preferable.

Specific examples of the melamine-based crosslinking agent include hexamethoxymethylmelamine, hexaethoxymethylmelamine, hexapropoxymethylmelamine, and hexabutoxybutylmelamine.

Specific examples of the urea-based crosslinking agent include glycoluril-based crosslinking agents such as monohydroxymethylated glycoluril, dihydroxymethylated glycoluril, trihydroxymethylated glycoluril, tetrahydroxymethylated glycoluril, monomethoxymethylated glycoluril, dimethoxymethylated glycoluril, trimethoxymethylated glycoluril, tetramethoxymethylated glycoluril, monomethoxymethylated glycoluril, dimethoxymethylated glycoluril, trimethoxymethylated glycoluril, tetraethoxymethylated glycoluril, monopropoxymethylated glycoluril, dipropoxymethylated glycoluril, tripropoxymethylated glycoluril, tetrapropoxymethylated glycoluril, monobutoxymethylated glycoluril, dibutoxymethylated glycoluril, tributoxymethylated glycoluril, and tetrabutoxymethylated glycoluril,

urea-based crosslinking agents such as bismethoxymethylurea, bisethoxymethylurea, bispropoxymethylurea, and bisbutoxymethylurea,

ethyleneurea-based crosslinking agents such as monohydroxymethylated ethylene urea or dihydroxymethylated ethylene urea, monomethoxymethylated ethylene urea, dimethoxymethylated ethylene urea, monoethoxymethylated ethylene urea, diethoxymethylated ethylene urea, monopropoxymethylated ethylene urea, dipropoxymethylated ethylene urea, monobutoxymethylated ethylene urea, and dibutoxymethylated ethylen eurea,

propylene urea-based crosslinking agents such as monohydroxymethylated propylene urea, dihydroxymethylated propylene urea, monomethoxymethylated propylene urea, dimethoxymethylated propylene urea, monodiethoxymethylated propylene urea, diethoxymethylated propylene urea, monopropoxymethylated propylene urea, dipropoxymethylated propylene urea, monobutoxymethylated propylene urea, and dibutoxymethylated propylene urea,

1,3-di(methoxymethyl) 4,5-dihydroxy-2-imidazolidinone, and 1,3-di(methoxymethyl)-4,5-dimethoxy-2-imidazolidinone.

Specific examples of the benzoguanamine-based crosslinking agent include monohydroxymethylated benzoguanamine, dihydroxymethylated benzoguanamine, trihydroxymethylated benzoguanamine, tetrahydroxymethylated benzoguanamine, monomethoxymethylated benzoguanamine, dimethoxymethylated benzoguanamine, trimethoxymethylated benzoguanamine, tetramethoxymethylated benzoguanamine, monomethoxymethylated benzoguanamine, dimethoxymethylated benzoguanamine, trimethoxymethylated benzoguanamine, tetraethoxymethylated benzoguanamine, monopropoxymethylated benzoguanamine, dipropoxymethylated benzoguanamine, tripropoxymethylated benzoguanamine, tetrapropoxymethylated benzoguanamine, monobutoxymethylated benzoguanamine, dibutoxymethylated benzoguanamine, tributoxymethylated benzoguanamine, and tetrabutoxymethylated benzoguanamine.

In addition, as the compound having at least one group selected from the group consisting of a methylol group and an alkoxymethyl group, a compound in which at least one group selected from the group consisting of a methylol group and an alkoxymethyl group is directly bonded to an aromatic ring (preferably a benzene ring) can also be suitably used.

Specific examples of such compounds include benzenedimethanol, bis(hydroxymethyl)cresol, bis(hydroxymethyl)dimethoxybenzene, bis(hydroxymethyl)diphenyl ether, bis(hydroxymethyl)benzophenone, hydroxymethylphenyl hydroxymethylbenzoate, bis(hydroxymethyl)biphenyl, dimethylbis(hydroxymethyl)biphenyl, bis(methoxymethyl)benzene, bis(methoxymethyl)cresol, bis(methoxymethyl)dimethoxybenzene, bis(methoxymethyl)diphenyl ether, bis(methoxymethyl)benzophenone, methoxymethylphenyl methoxymethylbenzoate, bis(methoxymethyl)biphenyl, dimethylbis(methoxymethyl)biphenyl, 4,4',4''-ethylidenetris[2,6-bis(methoxymethyl)phenol], 5, 5'-[2,2,2-trifluoro-1-(trifluoromethyl)ethylidene]bis[2-hydroxy-1,3-benzenedimethanol], and 3,3',5,5'-tetrakis(methoxymethyl)-1,1'-biphenyl-4,4'-diol.

As the other crosslinking agent, a commercially available product may be used, and examples of the suitable commercially available product include 46DMOC and 46DMOEP (all manufactured by ASAHI YUKIZAI Corporation), DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DMLBisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, and HMOM-TPHAP (all manufactured by Honshu Chemical Industry Co., Ltd.), and NIKALAC (registered trade name, the same applies hereinafter) MX-290, NIKALAC MX-280, NIKALAC MX-270, NIKALAC MX-279, NIKALAC MW-100LM, and NIKALAC MX-750LM (all manufactured by Sanwa Chemical Co., Ltd.).

In addition, the photocurable resin composition according to the embodiment of the present invention preferably contains, as the other crosslinking agent, at least one compound selected from the group consisting of an epoxy compound, an oxetane compound, and a benzoxazine compound.

[Epoxy compound (compound having epoxy group)]

The epoxy compound is preferably a compound having two or more epoxy groups in one molecule. Since the epoxy group undergoes a crosslinking reaction at 200°C or lower and a dehydration reaction derived from crosslinking does not occur, film shrinkage hardly occurs. Therefore, containing an epoxy compound is effective for the low-temperature curing of the photocurable resin composition and the suppression of warping.

The epoxy compound preferably contains a polyethylene oxide group. As a result, it is possible to further decrease the elastic modulus and suppress the warping. The polyethylene oxide group means a group in which the number of repeating units of ethylene oxide is 2 or higher, and the number of repeating units is preferably 2 to 15.

Examples of the epoxy compound include a bisphenol A type epoxy resin; a bisphenol F type epoxy resin; an alkylene glycol type epoxy resin or a polyhydric alcohol hydrocarbon type epoxy resin, such as propylene glycol diglycidyl ether, neopentyl glycol diglycidyl ether, ethylene glycol diglycidyl ether, butylene glycol diglycidyl ether, hexamethylene glycol diglycidyl ether, or trimethylolpropane triglycidyl ether; a polyalkylene glycol type epoxy resin such as polypropylene glycol diglycidyl ether; and an epoxy group-containing silicone such as polymethyl (glycidyloxypropyl)siloxane; however, the epoxy compound is not limited thereto. Specific examples thereof include EPICLON (registered trade name) 850-S, EPICLON (registered trade name) HP-4032, EPICLON (registered trade name) HP-7200, EPICLON (registered trade name) HP-820, EPICLON (registered trade name) HP-4700, EPICLON (registered trade name) EXA-4710, EPICLON (registered trade name) HP-4770, EPICLON (registered trade name) EXA-859CRP, EPICLON (registered trade name) EXA-1514, EPICLON (registered trade name) EXA-4880, EPICLON (registered trade name) EXA-4850-150, EPICLON EXA-4850-1000, EPICLON (registered trade name) EXA-4816, EPICLON (registered trade name) EXA-4822 (all product names, manufactured by DIC Corporation), RIKARESIN (registered trade name) BEO-60E (product name, manufactured by New Japan Chemical Co., Ltd.); EP-4003S and EP-4000S (all product names, manufactured by ADEKA Corporation); CELLOXIDE 2021P, 2081, 2000, 3000, EHPE3150, EPOLEAD GT400, SELVINERS B0134, B0177 (all product names, manufactured by Daicel Corporation); and NC-3000, NC-3000-L, NC-3000-H, NC-3000-FH-75M, NC-3100, CER-3000-L, NC-2000-L, XD-1000, NC-7000L, NC-7300L, EPPN-501H, EPPN-501HY, EPPN-502H, EOCN-1020, EOCN-102S, EOCN-103S, EOCN-104S, CER-1020, EPPN-201, BREN-S, and BREN-10S (all product names, manufactured by Nippon Kayaku Co., Ltd.).

In addition, the following compounds are also preferably used.

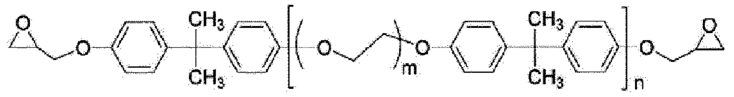

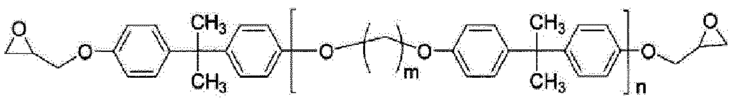

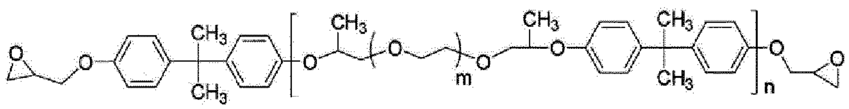

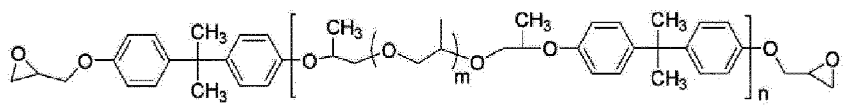

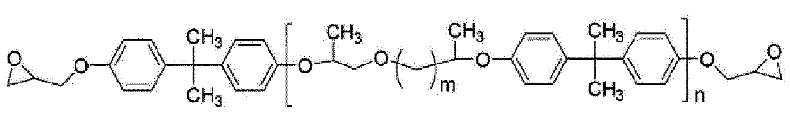

In the formulae, n is an integer of 1 to 5, and m is an integer of 1 to 20.

Among the above structures, n is preferably 1 to 2, and m is preferably 3 to 7 from the viewpoint of achieving

both heat resistance and improvement in elongation.

[Oxetane compound (compound having oxetanyl group)]

Examples of the oxetane compound include a compound having two or more oxetane rings in one molecule, 3-ethyl-3-hydroxymethyloxetane, 1,4-bis{[(3-ethyl-3-oxetanyl)methoxy]methyl} benzene, 3-ethyl-3-(2-ethylhexylmethyl)oxetane, and 1,4-benzenedicarboxylic acid-bis [(3-ethyl-3-oxetanyl)methyl] ester. As specific examples thereof, ARON OXETANE series (for example, OXT-121, OXT-221, OXT-191, OXT-223) manufactured by Toagosei Co., Ltd., can be suitably used, and these can be used alone or two or more thereof may be mixedly used.

[Benzoxazine compound (compound having benzoxazolyl group)]

Due to a crosslinking reaction derived from a ring-opening addition reaction, the benzoxazine compound does not result in degassing during curing and results in decreased thermal contraction, and thus the occurrence of warping is suppressed, which is preferable.
Preferred examples of the benzoxazine compound include B-a type benzoxazine, B-m type benzoxazine (all product names, manufactured by Shikoku Chemicals Corporation), a benzoxazine adduct of polyhydroxystyrene resin, and a phenol novolak type dihydrobenzoxazine compound. These may be used alone, or two or more thereof may be mixed and used.
The content of the other crosslinking agent is preferably 0.1% to 30% by mass, more preferably 0.1% to 20% by mass, still more preferably 0.5% to 15% by mass, and particularly preferably 1.0% to 10% by mass, with respect to the total solid content of the photocurable resin composition according to the embodiment of the present invention. One kind of the other crosslinking agent may be contained, or two or more kinds thereof may be contained. In a case where two or more kinds of the other crosslinking agents are contained, the total thereof is preferably within the above-described range.

<Thermal polymerization initiator>

The photocurable resin composition according to the embodiment of the present invention may contain a thermal polymerization initiator and particularly may contain a thermal radical polymerization initiator. The thermal radical polymerization initiator is a compound that generates a radical by heat energy and initiates or promotes a polymerization reaction of a compound having polymerization properties. In a case where a thermal radical polymerization initiator is added, the polymerization reaction of the resin and the polymerizable compound can be allowed to proceed, and thus the chemical resistance can be further improved, for example, in a case where the pattern forming method according to the embodiment of the present invention includes a heating step.
Specific examples of the thermal radical polymerization initiator include the compounds described in paragraphs 0074 to 0118 of JP2008-063554A.
In a case where thermal polymerization initiator is contained, the content thereof is preferably 0.1% to 30% by mass, with respect to the total solid content of the composition according to the embodiment of the present invention, more preferably 0.1% to 20% by mass, and still more preferably 5% to 15% by mass. Only one kind of thermal polymerization initiator may be contained, or two or more kinds thereof may be contained. In a case where two or more kinds of thermal polymerization initiators are contained, the total amount thereof is preferably within the above-described range.

<Thermal acid generator>

The photocurable resin composition according to the embodiment of the present invention may contain a thermal acid generator.
For example, in a case where the pattern forming method according to the embodiment of the present invention includes a heating step, there is an effect that thermal acid generator generates an acid by heating and promotes the crosslinking reaction of at least one compound selected from a compound having a hydroxymethyl group, an alkoxymethyl group, or an acyloxymethyl group, an epoxy compound, an oxetane compound, or a benzoxazine compound.
The thermal decomposition start temperature of the thermal acid generator is preferably 50°C to 270°C and more preferably 50°C to 250°C. Further, in a case where a thermal acid generator, which does not generate an acid when the composition is dried after being applied onto the substrate (pre-baking: about 70°C to 140°C) but generates an acid when the final heating (curing: about 100°C to 400°C) is carried out after patterning by subsequent exposure and development, is selected, it is possible to suppress a decrease in sensitivity during development, which is preferable.
The thermal decomposition start temperature is determined as the peak temperature of the exothermic peak having the lowest temperature in a case where the thermal acid generator is heated to 500°C at 5 °C/min in a pressure-resistant capsule.

Examples of the device that is used for measuring the thermal decomposition start temperature include Q2000 (manufactured by TA Instruments).

The acid generated from the thermal acid generator is preferably a strong acid, and it is preferably, for example, an aryl sulfonic acid such as p-toluene sulfonic acid or benzene sulfonic acid, an alkyl sulfonic acid such as methane sulfonic acid, ethane sulfonic acid, or butane sulfonic acid, or a haloalkyl sulfonic acid such as trifluoromethane sulfonic acid. Examples of such a thermal acid generator include those described in paragraph 0055 of JP2013-072935A.

Among them, it is preferably those that generate an alkyl sulfonic acid having 1 to 4 carbon atoms or a haloalkyl sulfonic acid having 1 to 4 carbon atoms, from the viewpoint that there are few residues in the organic film and it is difficult to deteriorate the physical properties of the organic film. The thermal acid generator is preferably (4-hydroxyphenyl)dimethylsulfonium methanesulfonate, (4-((methoxycarbonyl)oxy)phenyl)dimethylsulfonium methanesulfonate, benzyl(4-hydroxyphenyl)methylsulfonium methanesulfonatebenzyl(4-((methoxycarbonyl)oxy)phenyl)methylsulfonium methanesulfonate, (4-hydroxyphenyl)methyl((2-methylphenyl)methyl)sulfonium methanesulfonate, (4-hydroxyphenyl)dimethylsulfonium trifluoromethanesulfonate, (4-((methoxycarbonyl)oxy)phenyl)dimethylsulfonium trifluoromethanesulfonate, benzyl(4-hydroxyphenyl)methylsulfonium trifluoromethanesulfonate, benzyl(4-((methoxycarbonyl)oxy)phenyl)methylsulfonium trifluoromethanesulfonate, (4-hydroxyphenyl)methyl((2-methylphenyl)methyl)sulfonium trifluoromethanesulfonate, 3-(5-(((propylsulfonyl)oxy)imino)thiophen-2(5H)-ylidene)-2-(o-tolyl)propanenitrile, or 2,2-bis(3-(methanesulfonylamino)-4-hydroxyphenyl)hexafluoropropane.

Further, the compounds described in paragraph 0059 of JP2013-167742A are also preferable as the thermal acid generator.

The content of thermal acid generator is preferably 0.01 parts by mass or more and more preferably 0.1 part by mass or more, with respect to 100 parts by mass of the resin. In a case where 0.01 parts by mass or more of thermal acid generator is contained, the crosslinking reaction is promoted, and thus the mechanical properties and chemical resistance of the organic film can be further improved. In addition, from the viewpoint of electrical insulating properties of the organic film, the content thereof is preferably 20 parts by mass or less, more preferably 15 parts by mass or less, and still more preferably 10 parts by mass or less.

<Onium salt>

The composition according to the embodiment of the present invention preferably contains an onium salt.

In particular, in a case where the polyimide precursor is contained as the other resin, the composition preferably contains an onium salt.

The kind of onium salt is not particularly specified; however, preferred examples thereof include an ammonium salt, an iminium salt, a sulfonium salt, an iodonium salt, and a phosphonium salt.

Among these, an ammonium salt or an iminium salt is preferable from the viewpoint that heat stability is high, and a sulfonium salt, an iodonium salt, or a phosphonium salt is preferable from the viewpoint of compatibility with a polymer.

Further, the onium salt is a salt of a cation having an onium structure and an anion, and the cation and the anion may be or may not be bonded through a covalent bond.

That is, the onium salt may be an intramolecular salt having a cation moiety and an anion moiety in the same molecular structure, or may be an intermolecular salt in which a cation molecule and an anion molecule, which are separate molecules, are ionically bonded; however, an intermolecular salt is preferred. Further, in the composition according to the embodiment of the present invention, the cation moiety or the cation molecule and the anion moiety or the anion molecule may be bonded by the ionic bonding or be dissociated from each other.

The cation in the onium salt is preferably an ammonium cation, a pyridinium cation, a sulfonium cation, an iodonium cation, or a phosphonium cation, and more preferably at least one cation selected from the group consisting of a tetraalkylammonium cation, a sulfonium cation, and an iodonium cation.

The onium salt that is used in the present invention may be a thermal-base generator.

The thermal-base generator refers to a compound that generates a base by heating, and examples thereof include an acidic compound that generates a base in a case of being heated to 40°C or higher.

Examples of the onium salt include the onium salts described in paragraphs 0122 to 0138 of WO2018/043262A. In addition, an onium salt that is used in the field of polyimide precursors can be used without particular limitation.

In a case where the composition according to the embodiment of the present invention contains an onium salt, the content of the onium salt is preferably 0.1% to 50% by mass with respect to the total solid content of the composition according to the embodiment of the present invention. The lower limit thereof is more preferably 0.5% by mass or more, still more preferably 0.85% by mass or more, and even still more preferably 1% by mass or more. The upper limit thereof is more preferably 30% by mass or less, still more preferably 20% by mass or less, and even still more preferably 10% by mass or less, and may be 5% by mass or less or may be 4% by mass or less.

One kind or two or more kinds of onium salts can be used. In a case where two or more kinds thereof are used, the total amount is preferably within the above-described range.

<Thermal-base generator>

The composition according to the embodiment of the present invention may contain a thermal-base generator.
In particular, in a case where the composition contains a polyimide precursor as the other resin, the composition preferably contains a thermal-base generator.
The thermal-base generator may be a compound corresponding to the above-described onium salt or may be a thermal-base generator other than the above-described onium salt.
Examples of the base that is generated from the base generator include a secondary amine and a tertiary amine.
The base generator according to the embodiment of the present invention is not particularly limited, and a known base generator can be used. It is possible to use a known base generator, for example, a carbamoyloxime compound, a carbamoylhydroxylamine compound, a carbamic acid compound, a formamide compound, an acetoamide compound, a carbamate compound, a benzylcarbamate compound, a nitrobenzylcarbamate compound, a sulfonamide compound, an imidazole derivative compound, an amineimide compound, a pyridine derivative compound, an α-aminoacetophenone derivative compound, a quaternary ammonium salt derivative compound, a pyridinium salt, an α-lactone ring derivative compound, an amineimide compound, a phthalimide derivative compound, or an acyloxyimino compound.
Examples of the other thermal-base generator include a nonionic thermal-base generator.
Examples of the nonionic thermal-base generator include a compound represented by Formula (B1) or Formula (B2).

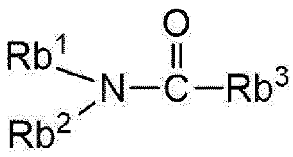 (B1) 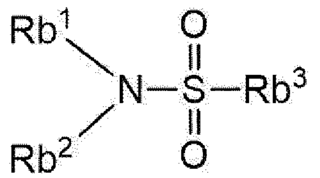 (B2)

In Formulae (B1) and (B2), $Rb^1$, $Rb^2$, and $Rb^3$ are each independently an organic group that does not have a tertiary amine structure, a halogen atom, or a hydrogen atom. However, $Rb^1$ and $Rb^2$ are not hydrogen atoms at the same time. Further, none of $Rb^1$, $Rb^2$, and $Rb^3$ have a carboxy group. In the present specification, the tertiary amine structure refers to a structure in which all three bonding sites of a trivalent nitrogen atom are covalently bonded to hydrocarbon-based carbon atoms. For this reason, this is not applied in a case where the carbon atom to which the bonding site bonded is a carbon atom forming a carbonyl group, that is, in a case where an amide group is formed by bonding together with a nitrogen atom.
In Formulae (B1) and (B2), a cyclic structure is preferably contained in at least one of $Rb^1$, $Rb^2$, or $Rb^3$ and is more preferably contained in at least two thereof. The cyclic structure may be any one of a monocyclic ring or a fused ring and is preferably a monocyclic ring or a fused ring in which two monocyclic rings are fused. The monocyclic ring is preferably a 5-membered ring or a 6-membered ring, and preferably a 6-membered ring. The monocyclic ring is preferably a cyclohexane ring or a benzene ring, and more preferably a cyclohexane ring.
More specifically, $Rb^1$ and $Rb^2$ are preferably a hydrogen atom, an alkyl group (preferably having 1 to 24 carbon atoms, more preferably having 2 to 18 carbon atoms, and still more preferably having 3 to 12 carbon atoms), an alkenyl group (preferably having 2 to 24 carbon atoms, more preferably having 2 to 18 carbon atoms, and still more preferably having 3 to 12 carbon atoms), an aryl group (preferably having 6 to 22 carbon atoms, more preferably having 6 to 18 carbon atoms, and still more preferably having 6 to 10 carbon atoms), or an arylalkyl group (preferably having 7 to 25 carbon atoms, more preferably having 7 to 19 carbon atoms, and still more preferably having 7 to 12 carbon atoms). These groups may have substituents as long as the effects of the present invention are exhibited. $Rb^1$ and $Rb^2$ may be bonded to each other to form a ring. The ring to be formed is preferably a 4- to 7-membered nitrogen-containing heterocycle. Particularly, $Rb^1$ and $Rb^2$ are preferably a linear, branched, or cyclic alkyl groups (preferably having 1 to 24 carbon atoms, more preferably 2 to 18 carbon atoms, and still more preferably having 3 to 12 carbon atoms) which may have a substituent, more preferably a cycloalkyl group (preferably having 3 to 24 carbon atoms, more preferably having 3 to 18 carbon atoms, and still more preferably having 3 to 12 carbon atoms) which may have a substituent, and still more preferably a cyclohexyl group which may have a substituent.
Examples of $Rb^3$ include an alkyl group (preferably having 1 to 24 carbon atoms, more preferably having 2 to 18 carbon atoms, and still more preferably having 3 to 12 carbon atoms), an aryl group (preferably having 6 to 22 carbon atoms, more preferably having 6 to 18 carbon atoms, and still more preferably having 6 to 10 carbon atoms), an alkenyl group (preferably having 2 to 24 carbon atoms, more preferably having 2 to 12 carbon atoms, and still more preferably

having 2 to 6 carbon atoms), an arylalkyl group (preferably having 7 to 23 carbon atoms, more preferably having 7 to 19 carbon atoms, and still more preferably having 7 to 12 carbon atoms), an arylalkenyl group (preferably having 8 to 24 carbon atoms, more preferably having 8 to 20 carbon atoms, and still more preferably having 8 to 16 carbon atoms), an alkoxy group (preferably having 1 to 24 carbon atoms, more preferably having 2 to 18 carbon atoms, and still more preferably having 3 to 12 carbon atoms), an aryloxy group (preferably having 6 to 22 carbon atoms, more preferably having 6 to 18 carbon atoms, and still more preferably having 6 to 12 carbon atoms), and an arylalkyloxy group (preferably having 7 to 23 carbon atoms, more preferably having 7 to 19 carbon atoms, and still more preferably having 7 to 12 carbon atoms). Among the above, a cycloalkyl group (preferably having 3 to 24 carbon atoms, more preferably 3 to 18 carbon atoms, and still more preferably 3 to 12 carbon atoms), an arylalkenyl group, or an arylalkyloxy group is preferable. $Rb^3$ may further have a substituent as long as the effects of the present invention are exhibited.

The compound represented by Formula (B1) is preferably a compound represented by Formula (B1-1) or Formula (B1-2).

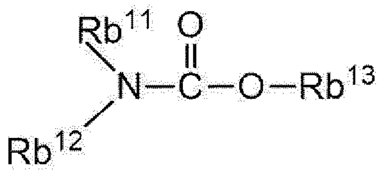 (B1-1) 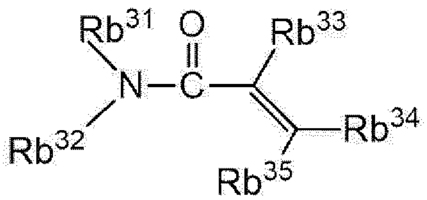 (B1-2)

In the formula, $Rb^{11}$ and $Rb^{12}$, and $Rb^{31}$ and $Rb^{32}$ are each the same as $Rb^1$ and $Rb^2$ in Formula (B1).

$Rb^{13}$ is an alkyl group (preferably having 1 to 24 carbon atoms, more preferably having 2 to 18 carbon atoms, and still more preferably having 3 to 12 carbon atoms), an alkenyl group (preferably having 2 to 24 carbon atoms, more preferably having 2 to 18 carbon atoms, and still more preferably having 3 to 12 carbon atoms), an aryl group (preferably having 6 to 22 carbon atoms, more preferably having 6 to 18 carbon atoms, and still more preferably having 6 to 12 carbon atoms), or an arylalkyl group (preferably having 7 to 23 carbon atoms, more preferably having 7 to 19 carbon atoms, and still more preferably having 7 to 12 carbon atoms), and may have a substituent as long as the effects of the present invention are exhibited. Among the above, $Rb^{13}$ is preferably an arylalkyl group.

$Rb^{33}$ and $Rb^{34}$ are each independently a hydrogen atom, an alkyl group (preferably having 1 to 12 carbon atoms, more preferably having 1 to 8 carbon atoms, and still more preferably having 1 to 3 carbon atoms), an alkenyl group (preferably having 2 to 12 carbon atoms, more preferably having 2 to 8 carbon atoms, and still more preferably having 2 or 3 carbon atoms), an aryl group (preferably having 6 to 22 carbon atoms, more preferably having 6 to 18 carbon atoms, and still more preferably having 6 to 10 carbon atoms), or an arylalkyl group (preferably having 7 to 23 carbon atoms, more preferably having 7 to 19 carbon atoms, and still more preferably having 7 to 11 carbon atoms), and preferably a hydrogen atom.

$Rb^{35}$ is an alkyl group (preferably having 1 to 24 carbon atoms, more preferably having 1 to 12 carbon atoms, and still more preferably having 3 to 8 carbon atoms), an alkenyl group (preferably having 2 to 12 carbon atoms, more preferably having 2 to 10 carbon atoms, and still more preferably having 3 to 8 carbon atoms), an aryl group (preferably having 6 to 22 carbon atoms, more preferably having 6 to 18 carbon atoms, and still more preferably having 6 to 12 carbon atoms), or an arylalkyl group (preferably having 7 to 23 carbon atoms, more preferably having 7 to 19 carbon atoms, and still more preferably having 7 to 12 carbon atoms), and is preferably an aryl group.

The compound represented by Formula (B1-1) is preferably a compound represented by Formula (B1-1a) as well.

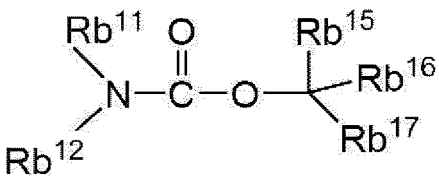 (B1-1a)

$Rb^{11}$ and $Rb^{12}$ are respectively synonymous with $Rb^{11}$ and $Rb^{12}$ in Formula (B1-1).

$Rb^{15}$ and $Rb^{16}$ are a hydrogen atom, an alkyl group (preferably having 1 to 12 carbon atoms, more preferably having 1 to 6 carbon atoms, and still more preferably having 1 to 3 carbon atoms), an alkenyl group (preferably having 2 to 12 carbon atoms, more preferably having 2 to 6 carbon atoms, and still more preferably having 2 or 3 carbon atoms), an aryl group (preferably having 6 to 22 carbon atoms, more preferably having 6 to 18 carbon atoms, and still more preferably having 6 to 10 carbon atoms), or an arylalkyl group (preferably having 7 to 23 carbon atoms, more preferably

having 7 to 19 carbon atoms, and still more preferably having 7 to 11 carbon atoms), and preferably a hydrogen atom or a methyl group.

$Rb^{17}$ is an alkyl group (preferably having 1 to 24 carbon atoms, more preferably having 1 to 12 carbon atoms, and still more preferably having 3 to 8 carbon atoms), an alkenyl group (preferably having 2 to 12 carbon atoms, more preferably having 2 to 10 carbon atoms, and still more preferably having 3 to 8 carbon atoms), an aryl group (preferably having 6 to 22 carbon atoms, more preferably having 6 to 18 carbon atoms, and still more preferably having 6 to 12 carbon atoms), or an arylalkyl group (preferably having 7 to 23 carbon atoms, more preferably having 7 to 19 carbon atoms, and still more preferably having 7 to 12 carbon atoms), and among the above, is preferably an aryl group.

The molecular weight of the nonionic thermal-base generator is preferably 800 or less, more preferably 600 or less, and still more preferably 500 or less. The lower limit thereof is preferably 100 or more, more preferably 200 or more, and still more preferably 300 or more.

Among the above-described onium salts, specific examples of the compound which is a thermal-base generator or specific examples of the other thermal-base generators include the following compounds.

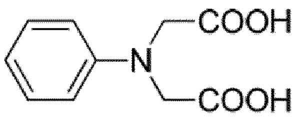

(A-1)

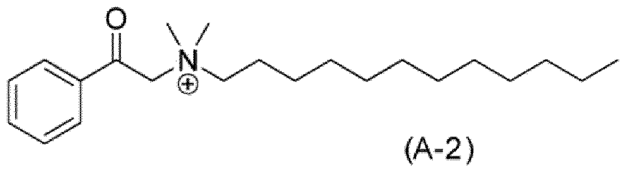

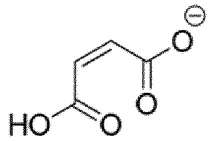

(A-2)

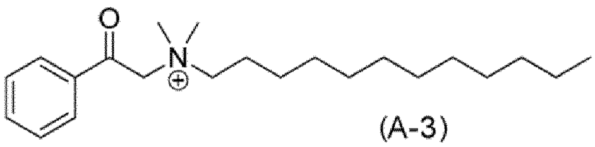

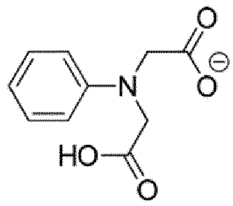

(A-3)

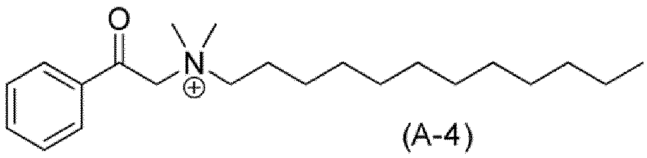

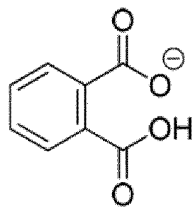

(A-4)

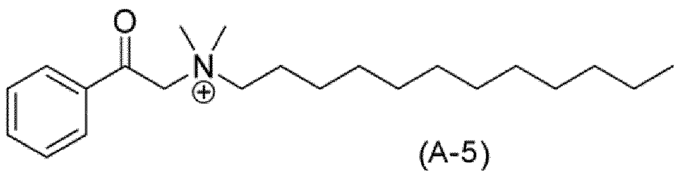

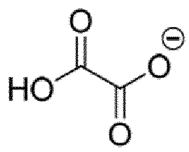

(A-5)

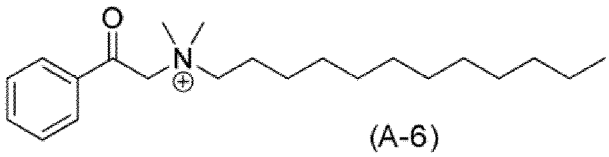

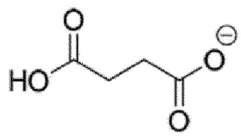

(A-6)

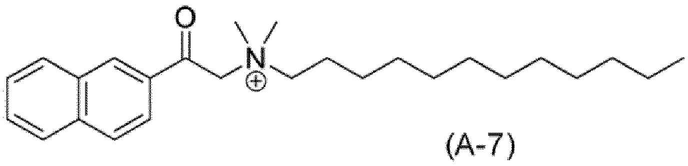
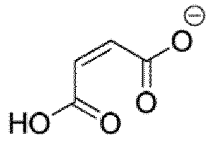

(A-7)

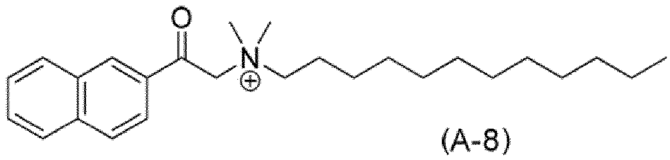
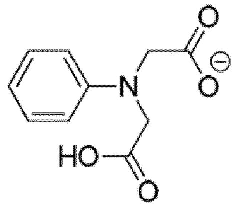

(A-8)

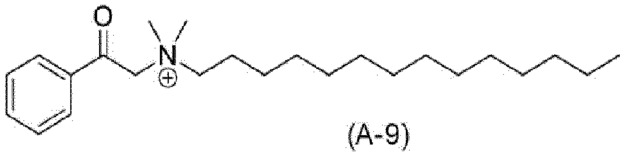
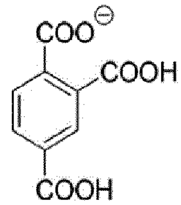

(A-9)

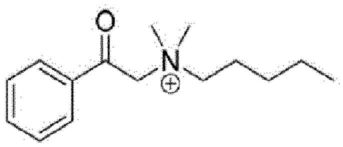
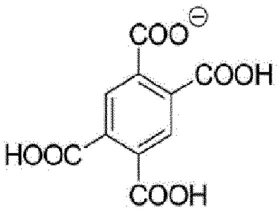

(A-10)

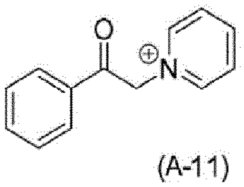
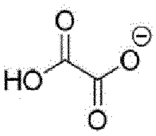

(A-11)

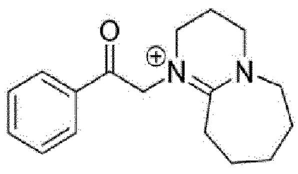
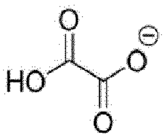

(A-12)

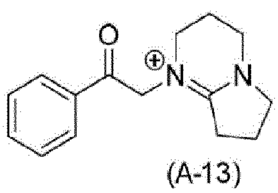
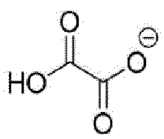

(A-13)

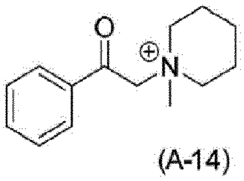
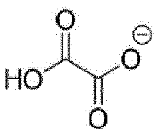

(A-14)

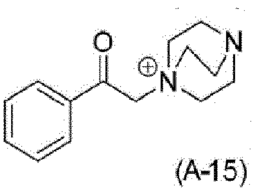
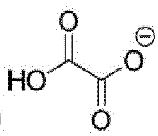

(A-15)

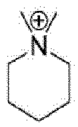
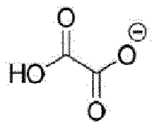

(A-16)

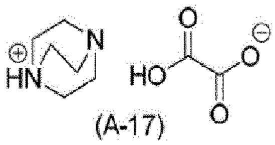
(A-17)

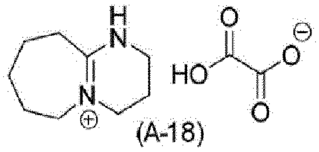
(A-18)

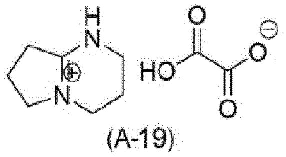
(A-19)

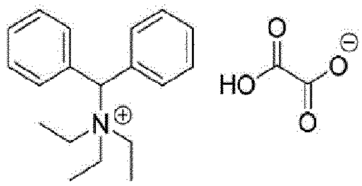
(A-20)

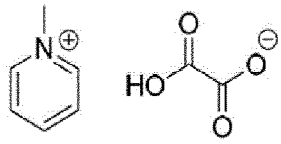
(A-21)

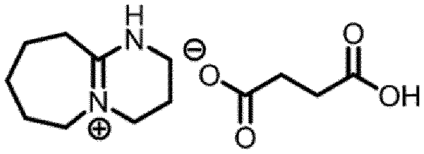
(A-22)

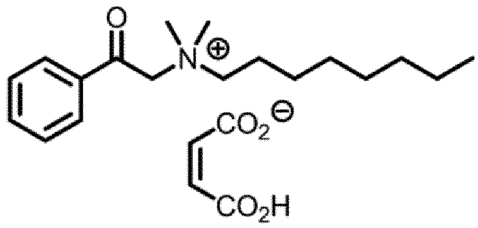
(A-23)

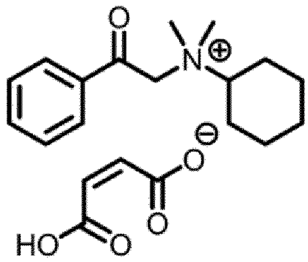
(A-24)

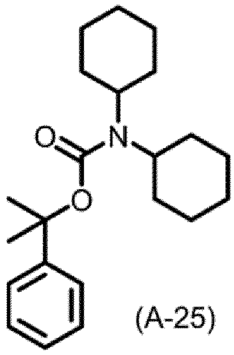
(A-25)

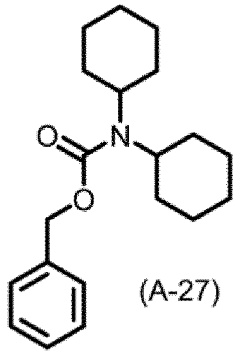
(A-27)

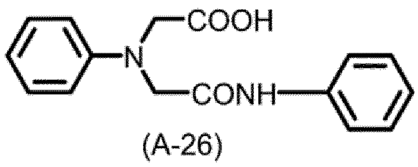
(A-26)

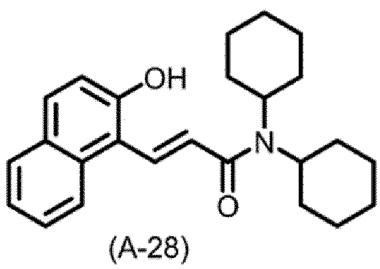
(A-28)

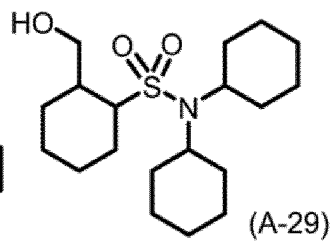
(A-29)

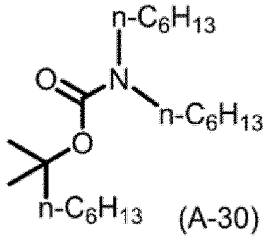
(A-30)

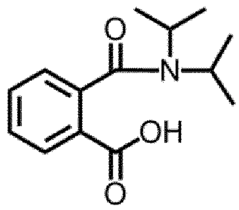

(A-31)

The content of thermal-base generator is preferably 0.1% to 50% by mass with respect to the total solid content of the according to the embodiment of the present invention. The lower limit is more preferably 0.5% by mass or more and still more preferably 1% by mass or more. The upper limit is more preferably 30% by mass or less and still more preferably 20% by mass or less. One kind or two or more kinds of thermal-base generators can be used. In a case where two or more kinds thereof are used, the total amount is preferably within the above-described range.

<Migration suppressing agent>

The photocurable resin composition according to the embodiment of the present invention preferably further contains a migration suppressing agent. In a case where a migration suppressing agent is contained, it is possible to effectively suppress metal ions derived from a metal layer (a metal wire) from being migrated into a photocurable film.

The migration suppressing agent is not particularly limited; however, examples thereof include a compound having a heterocycle (a pyrrole ring, a furan ring, a thiophene ring, an imidazole ring, an oxazole ring, a thiazole ring, a pyrazole ring, an isoxazole ring, an isothiazole ring, a tetrazole ring, a pyridine ring, a pyridazine ring, a pyrimidine ring, a pyrazine ring, a piperidine ring, a piperazine ring, a morpholine ring, a 2H-pyran ring and a 6H-pyran ring, or a triazine ring), a compound having thioureas and a sulfanyl group, a hindered phenol-based compound, a salicylic acid derivative-based compound, and a hydrazide derivative-based compound. In particular, triazole-based compounds such as 1,2,4-triazole and benzotriazole, and tetrazole-based compounds such as 1H-tetrazole and 5-phenyltetrazole can be preferably used.

Further, it is possible to preferably use a compound such as 3-amino-1,2,4-triazole, 3,5-diamino-1,2,4-triazole, or 5-amino-1H-tetrazole.

Alternatively, an ion trapping agent that captures an anion such as a halogen ion can also be used.

As other migration suppressing agents, the rust inhibitors described in paragraph 0094 of JP2013-015701A, the compounds described in paragraphs 0073 to 0076 of JP2009-283711A, the compounds described in paragraph 0052 of JP2011-059656A, the compounds described in paragraphs 0114, 0116, and 0118 of JP2012-194520A, the compounds described in paragraph 0166 of WO2015/199219A, or the like can be used.

The following compounds can be mentioned as specific examples of the migration suppressing agent.

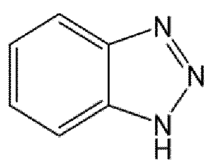

M-1

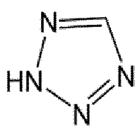

M-2

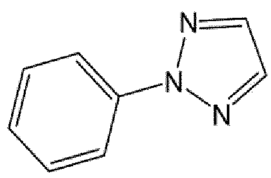

M-3

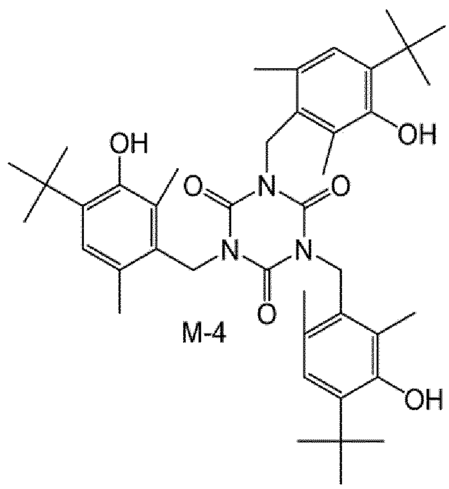

M-4

In a case where the photocurable resin composition contains the migration suppressing agent, the content of the migration suppressing agent is preferably 0.01% to 5.0% by mass, more preferably 0.05% to 2.0% by mass, and still more preferably 0.1% to 1.0% by mass, with respect to the total solid content of the photocurable resin composition.

One kind of migration suppressing agent may be used alone, or two or more kinds thereof may be used. In a

case where two or more kinds of migration suppressing agents are used, the total thereof is preferably within the above-described range.

<Polymerization Inhibitor>

The photocurable resin composition according to the embodiment of the present invention preferably contains a polymerization inhibitor.

Examples of the polymerization inhibitor include a phenol-based compound, a quinone-based compound, an amino-based compound, an N-oxyl-free radical compound-based compound, a nitro-based compound, a nitroso-based compound, a heteroaromatic ring-based compound, and a metal compound.

As the polymerization inhibitor, for example, hydroquinone, p-methoxyphenol, di-tert-butyl-p-cresol, pyrogallol, p-tert-butylcatechol, 1,4-benzoquinone, diphenyl-p-benzoquinone, 4,4'-thiobis(3-methyl-6-tert-butylphenol), 2,2'-methylenebis(4-methyl-6-tert-butylphenol), N-nitroso-N-phenylhydroxyamine aluminum salt, phenothiazine, N-nitrosodiphenylamine, N-phenyl naphthylamine, ethylenediamine tetraacetic acid, 1,2-cyclohexanediamine tetraacetic acid, glycol ether diamine tetraacetic acid, 2,6-di-tert-butyl-4-methyl phenol, 5-nitroso-8-hydroxyquinoline, 1-nitroso-2-naphtoyl, 2-nitroso-1-naphtoyl, 2-nitroso-5-(N-ethyl-N-sulfopropylamino)phenol, N-nitroso-N-(1-naphthyl)hydroxyamine ammonium salt, bis(4-hydroxy-3,5-tert-butyl)phenylmethane, and the like are suitably used. In addition, the polymerization inhibitors described in paragraph 0060 of JP2015-127817A and the compounds described in paragraphs 0031 to 0046 of WO2015/125469A can also be used.

In addition, the following compounds can be used (Me is a methyl group).

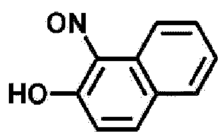
F-1

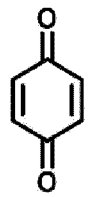
F-2

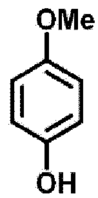
F-3

In a case where the photocurable resin composition according to the embodiment of the present invention has a polymerization inhibitor, the content of the polymerization inhibitor is preferably 0.01% to 5% by mass, more preferably 0.02% to 3% by mass, and still more preferably 0.05% to 2.5% by mass, with respect to the total solid content of the photocurable resin composition according to the embodiment of the present invention.

One kind of polymerization inhibitor may be used, or two or more kinds thereof may be used. In a case where two or more kinds of polymerization inhibitors are used, the total thereof is preferably within the above-described range.

<Metal adhesiveness improving agent>

The photocurable resin composition according to the embodiment of the present invention preferably contains a metal adhesiveness improving agent for improving adhesiveness to a metal material used for electrodes, wiring lines. Examples of the metal adhesiveness improving agent include a silane coupling agent.

More specific examples thereof include a silane coupling agent having an alkoxysilyl group, an aluminum-based auxiliary agent, a titanium-based auxiliary agent, a compound having a sulfonamide structure and a compound having a thiourea structure, a phosphoric acid derivative compound, a β-ketoester compound, and an amino compound.

Examples of the silane coupling agent include the compounds described in paragraph 0167 of WO2015/199219A, the compounds described in paragraphs 0062 to 0073 of JP2014-191002A, the compounds described in paragraphs 0063 to 0071 of WO2011/080992A, the compounds described in paragraphs 0060 and 0061 of JP2014-191252A, the compounds described in paragraphs 0045 to 0052 of JP2014-041264A, and the compounds described in paragraph 0055 of WO2014/097594A. In addition, it is also preferable to use two or more kinds of different silane coupling agents as described in paragraphs 0050 to 0058 of JP2011-128358A. In addition, as the silane coupling agent, the following compounds are also preferably used. In the following formulae, Et represents an ethyl group.

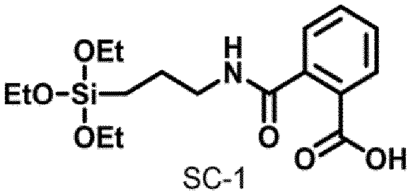

SC-1

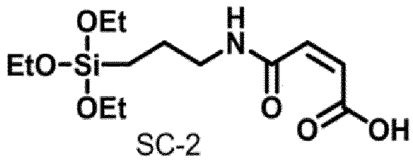

SC-2

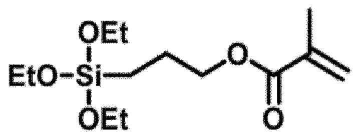

SC-3

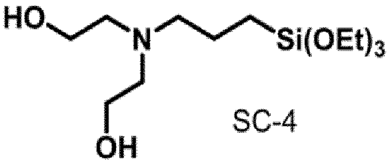

SC-4

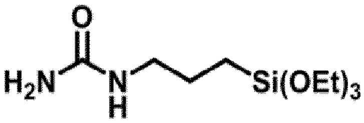

SC-5

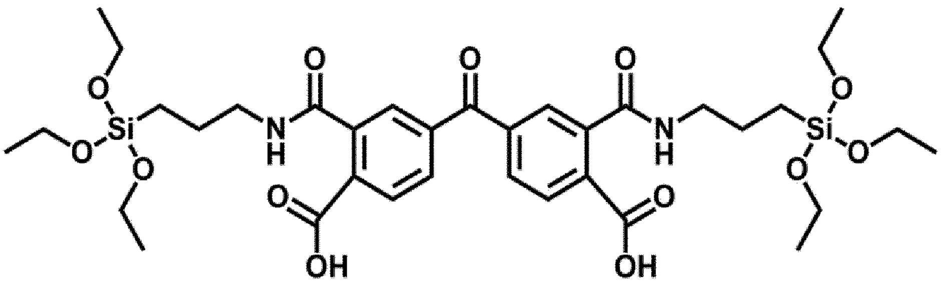

SC-6

[Aluminum-based auxiliary agent]

Examples of the aluminum-based auxiliary agent include aluminum tris(ethyl acetoacetate), aluminum tris(acetyl acetate), and ethyl acetoacetate aluminum diisopropylate.

In addition, as the metal adhesiveness improving agent, the compounds described in paragraphs 0046 to 0049 of JP2014-186186A, and the sulfide-based compounds described in paragraphs 0032 to 0043 of JP2013-072935A can also be used.

The content of the metal adhesiveness improving agent is preferably 0.1 to 30 parts by mass, more preferably in a range of 0.5 to 15 parts by mass, and still more preferably in a range of 0.5 to 5 parts by mass, with respect to 100 parts by mass of the specific resin. In a case where the content is set to be equal to or higher than the above lower limit value, good adhesiveness between a pattern and a metal layer is exhibited, and in a case where the content is set to be equal to or lower than the above upper limit value, good heat resistance of the pattern and good mechanical properties are exhibited. One kind of metal adhesiveness improving agent may be used, or two or more kinds thereof may be used. In a case where two or more kinds thereof are used, the total content thereof is preferably within the above-described range.

<Other additives>

As necessary, various additives, for example, a thermal acid generator, a sensitizing agent such as N-phenyldiethanolamine, a surfactant, a chain transfer agent, a higher fatty acid derivative, an inorganic particle, a curing agent, a curing catalyst, a filler, an antioxidant, an ultraviolet absorbing agent, and an aggregation inhibitor can be blended in the photocurable resin composition according to the embodiment of the present invention within the scope in which the effects of the present invention are obtained. In a case where these additives are blended, the total blending amount thereof is preferably 3% by mass or less of the solid content of the photocurable resin composition.

By appropriately containing these components, properties such as film properties can be adjusted. The details of the components can be found in, for example, paragraphs "0183" and later of JP2012-003225A (corresponding to paragraph "0237" of US2013/0034812A) and paragraphs "0101" to "0104" and "0107" to "0109" of JP2008-250074A, the contents of which are incorporatedi ncorporated in the present specification.

[Surfactant]

As the surfactant, various surfactants such as a fluorine-based surfactant, a silicone-based surfactant, and a hydrocarbon-based surfactant can be used. The surfactant may be a nonionic surfactant, a cationic surfactant, or an anionic surfactant.

In a case where a surfactant is contained in the photosensitive resin composition according to the embodiment of the present invention, the liquid characteristics (particularly, the fluidity) in a case of being prepared as a coating liquid are further improved, and thus the uniformity of the coating thickness and the liquid saving property can be further improved. That is, in a case where a film is formed using a coating liquid to which a composition containing a surfactant is applied, the interfacial tension between a surface to be coated and a coating liquid is reduced, the wettability to the surface to be coated is improved, and thus the coatability to the surface to be coated is improved. Therefore, a film having a uniform thickness with reduced unevenness in thickness can be formed more suitably.

Examples of the fluorine-based surfactant include MEGAFACE F171, MEGAFACE F172, MEGAFACE F173, MEGAFACE F176, MEGAFACE F177, MEGAFACE F141, MEGAFACE F142, MEGAFACE F143, MEGAFACE F144, MEGAFACE R30, MEGAFACE F437, MEGAFACE F475, MEGAFACE F479, MEGAFACE F482, MEGAFACE F554, MEGAFACE F780, RS-72-K (all manufactured by DIC Corporation); Florard FC430, Florard FC431, Florard FC171, Novec FC4430, and Novec FC4432 (all manufactured by 3M Japan Limited); Surflon S-382, Surflon SC-101, Surflon SC-103, Surflon SC-104, Surflon SC-105, Surflon SC1068, Surflon SC-381, Surflon SC-383, Surflon S393, and Surflon KH-40 (all manufactured by AGC Inc.); and PF636, PF656, PF6320, PF6520, and PF7002 (manufactured by OMNOVA Solutions Inc.). As the fluorine-based surfactant, the compounds described in paragraphs 0015 to 0158 of JP2015-117327A and the compounds described in paragraphs 0117 to 0132 of JP2011-132503A can also be used, the contents of which are incorporated in the present specification. A block polymer can also be used as the fluorine-based surfactant, and specific examples thereof include the compound described in JP2011-89090A, the content of which is incorporated in the present specification.

As the fluorine-based surfactant, a fluorine-containing polymer compound containing a repeating unit derived from a (meth)acrylate compound having a fluorine atom and a repeating unit derived from a (meth)acrylate compound having 2 or more (preferably 5 or more) alkyleneoxy groups (preferably ethyleneoxy groups or propyleneoxy groups) can also be preferably used, and examples of the fluorine-based surfactant that is used in the present invention include the following compounds as well.

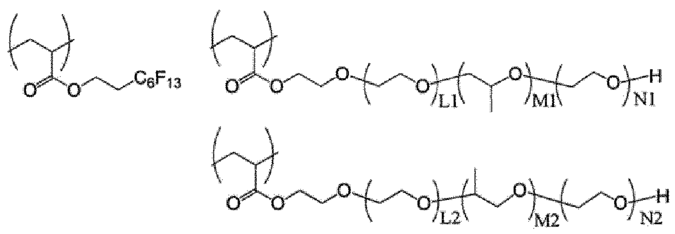

L1+N1+L2+N2=14
M1+M2=17

62% 38%

The weight-average molecular weight of the compounds is preferably 3,000 to 50,000 and more preferably 5,000 to 30,000.

Regarding the fluorine-based surfactant, a fluorine-containing polymer having an ethylenically unsaturated group in the side chain can also be used as the fluorine-based surfactant. Specification examples thereof include the compounds described in paragraphs "0050" to "0090" and "089" to "0295" of JP2010-164965A, the content of which is incorporated in the present specification. Further, examples of the commercially available product thereof include MEGAFACE RS-101, RS-102, and RS-718-K, all manufactured by DIC Corporation.

The fluorine content in the fluorine-based surfactant is preferably 3 to 40% by mass, more preferably 5 to 30% by mass, and particularly preferably 7 to 25% by mass. The fluorine-based surfactant in which the fluorine content is in the above-described range is effective from the viewpoints of the uniformity in the thickness of the coating film and liquid saving properties, and the solubility thereof in the composition is also excellent.

Examples of the silicone-based surfactant include TORAY SILICONE DC3PA, TORAY SILICONE SH7PA, TORAY SILICONE DC11PA, TORAY SILICONE SH21PA, TORAY SILICONE SH28PA, TORAY SILICONE SH29PA, TORAY SILICONE SH30PA, TORAY SILICONE SH8400 (all, manufactured by DuPont Toray Specialty Materials K.K.), TSF-4440, TSF-4300, TSF-4445, TSF-4460, TSF-4452 (all manufactured by Momentive Performance Materials Inc.), KP341, KF6001, KF6002 (all manufactured by Shin-Etsu Silicone Co., Ltd.), and BYK307, BYK323, and BYK330 (all manufactured by BYK Additives & Instruments).

Examples of the hydrocarbon-based surfactant include Pionin A-76, Newkalgen FS-3PG, Pionin B-709, Pionin

B-811-N, Pionin D-1004, Pionin D-3104, Pionin D-3605, Pionin, D-6112, Pionin D-2104-D, Pionin D-212, Pionin D-931, Pionin D-941, Pionin D-951, Pionin E-5310, Pionin P-1050-B, Pionin P-1028-P, Pionin P-4050-T (all manufactured by TAKEMOTO OIL & FAT Co., Ltd.).

Examples of the nonionic surfactant include glycerol, trimethylolpropane, and trimethylolethane, and an ethoxylate and propoxylate thereof (for example, glycerol propoxylate, glycerol ethoxylate, or the like), polyoxyethylene lauryl ether, polyoxyethylene stearyl ether, polyoxyethylene oleyl ether, polyoxyethylene octylphenyl ether, polyoxyethylene nonylphenyl ether, polyethylene glycol dilaurate, polyethylene glycol distearate, and sorbitan fatty acid ester. Examples of the commercially available product include Pluronic L10, L31, L61, L62, 10R5, 17R2, and 25R2 (manufactured by BASF SE), Tetronic 304, 701, 704, 901, 904, and 150R1 (manufactured by BASF SE), Solsperse 20000 (Lubrizol Japan Limited), NCW-101, NCW-1001, and NCW-1002 (manufactured by FUJIFILM Wako Pure Chemical Corporation), Pionin D-6112, D-6112-W, and D-6315 (manufactured by TAKEMOTO OIL & FAT Co., Ltd.), and OLFINE E1010, SURFYNOL 104, 400, and 440 (manufactured by Nissin Chemical Co., Ltd.).

Specific examples of the cationic surfactant include an organosiloxane polymer KP341 (manufactured by Shin-Etsu Chemical Co., Ltd.), a (meth)acrylic acid-based (co)polymer POLYFLOW No. 75, No. 77, No. 90, or No. 95 (manufactured by Kyoeisha Chemical Co., Ltd.), W001 (manufactured by Yusho Co., Ltd.).

Specific examples of the anionic surfactant include W004, W005, W017 (manufactured by Yusho Co., Ltd.), and SANDET BL (manufactured by Sanyo Chemical Industries, Ltd.).

Only one kind of surfactant may be used, or two or more kinds thereof may be used in combination.

The content of the surfactant is preferably 0.001% to 2.0% by mass and more preferably 0.005% to 1.0% by mass with respect to the total solid content of the composition.

[Higher fatty acid derivative]

In the composition according to the embodiment of the present invention, in order to prevent polymerization inhibition due to oxygen, a higher fatty acid derivative such as behenic acid or behenic acid amide may be added and be caused to be localized on a surface of the composition in the process of drying after coating.

In addition, as the higher fatty acid derivative, the compounds described in paragraph 0155 of WO2015/199219A can also be used, the content of which is incorporated in the present specification.

In a case where the resin composition according to the embodiment of the present invention has a higher fatty acid derivative, the content of the higher fatty acid derivative is preferably 0.1% to 10% by mass with respect to the total solid content of the composition according to the embodiment of the present invention. One kind of higher fatty acid derivative may be used, or two or more kinds thereof may be used. In a case where two or more kinds of higher fatty acid derivatives are used, the total thereof is preferably within the above-described range.

[Thermal polymerization initiator]

The resin composition according to the embodiment of the present invention may contain a thermal polymerization initiator and particularly may contain a thermal radical polymerization initiator. The thermal radical polymerization initiator is a compound that generates a radical by heat energy and initiates or promotes a polymerization reaction of a compound having polymerization properties. In a case where a thermal radical polymerization initiator is added, the polymerization reaction of the resin and the polymerizable compound can be allowed to proceed, and thus the solvent resistance can be further improved. Further, the above-described photopolymerization initiator also has a function of initiating polymerization by heat and can be added as a polymerization initiator.

Specific examples of thermal radical polymerization initiator include compounds described in paragraphs 0074 to 0118 of JP2008-063554A, the content of which is incorporated in the present specification.

In a case where thermal polymerization initiator is contained, the content thereof is preferably 0.1% to 30% by mass, with respect to the total solid content of the resin composition according to the embodiment of the present invention, more preferably 0.1% to 20% by mass, and still more preferably 0.5% to 15% by mass. Only one kind of thermal polymerization initiator may be contained, or two or more kinds thereof may be contained. In a case where two or more kinds of thermal polymerization initiators are contained, the total amount thereof is preferably within the above-described range.

[Inorganic particle]

The resin composition according to the embodiment of the present invention may contain inorganic fine particles. Specific examples of the inorganic particle include calcium carbonate, calcium phosphate, silica, kaolin, talc, titanium dioxide, alumina, barium sulfate, calcium fluoride, lithium fluoride, zeolite, molybdenum sulfide, and glass.

The average particle diameter of the inorganic particles is preferably 0.01 to 2.0 μm, more preferably 0.02 to

1.5 μm, still more preferably 0.03 to 1.0 μm, and particularly preferably 0.04 to 0.5 μm.

The average particle diameter of the fine particles is the primary particle diameter and the volume average particle diameter. The volume average particle diameter can be measured by a known measuring method. Specifically, it can be measured by a centrifugal sedimentation light transmission method, an X-ray transmission method, a laser diffraction/scattering method, or a dynamic light scattering method. The average particle diameter indicates the average value of the particle diameter distribution, and it can be measured by, for example, Nanotrac WAVE II EX-150 (manufactured by Nikkiso Co., Ltd.).

[Ultraviolet absorbing agent]

The composition according to the embodiment of the present invention may contain an ultraviolet absorbing agent. As the ultraviolet absorbing agent, an ultraviolet absorbing agent such as a salicylate-based, a benzophenone-based, a benzotriazole-based, a substituted acrylonitrile-based, or a triazine-based ultraviolet absorbing agent can be used.

Examples of the salicylate-based ultraviolet absorbing agent include phenyl salicylate, p-octylphenyl salicylate, and p-t-butylphenyl salicylate, and examples of the benzophenone-based ultraviolet absorbing agent include 2,2'-dihydroxy-4-methoxybenzophenone, 2,2'-dihydroxy-4,4'-dimethoxybenzophenone, 2,2',4,4'-tetrahydroxybenzophenone, 2-hydroxy-4-methoxybenzophenone, 2,4-dihydroxybenzophenone, and 2-hydroxy-4-octoxybenzophenone. Examples of the benzotriazole-based ultraviolet absorbing agents include 2-(2'-hydroxy-3',5'-di-tert-butylphenyl)-5-chlorobenzotriazole, 2-(2'-hydroxy-3'-tert-butyl-5'-methylphenyl)-5-chlorobenzotriazole, 2-(2'-hydroxy-3'-tert-amyl-5'-isobutylphenyl)-5-chlorobenzotriazole, 2-(2'-hydroxy-3'-isobutyl-5'-methylphenyl)-5-chlorobenzotriazole, 2-(2'-hydroxy-3'-isobutyl-5'-propylphenyl)-5-chlorobenzotriazole, 2-(2'-hydroxy-3',5'-di-tert-butylphenyl)benzotriazole, 2-(2'-hydroxy-5'-methylphenyl)benzotriazole, and 2-[2'-hydroxy-5'-(1,1,3,3 -tetramethyl)phenyl]benzotriazole.

Examples of the substituted acrylonitrile-based ultraviolet absorbing agent include ethyl 2-cyano-3,3-diphenylacrylate and 2-ethylhexyl 2-cyano-3,3-diphenylacrylate. Further, examples of the triazine-based ultraviolet absorbing agent include mono(hydroxyphenyl)triazine compounds such as 2-[4-[(2-hydroxy-3-dodecyloxypropyl)oxy]-2-hydroxyphenyl]-4,6-bis(2,4-dimethylphenyl)-1, 3,5-triazine, 2-[4-[(2-hydroxy-3-tridecyloxypropyl)oxy]-2-hydroxyphenyl]-4,6-bis(2,4-dimethylphenyl)-1, 3,5-triazine, and 2-(2,4-dihydroxyphenyl)-4,6-bis(2,4-dimethylphenyl)-1,3,5-triazine; bis(hydroxyphenyl)triazine compounds such as 2,4-bis(2-hydroxy-4-propyloxyphenyl)-6-(2,4-dimethylphenyl)-1,3,5-triazine, 2,4-bis(2-hydroxy-3-methyl)-4-propyloxyphenyl)-6-(4-methylphenyl)-1,3,5-triazine, and 2,4-bis(2-hydroxy-3-methyl-4-hexyloxyphenyl)-6-(2,4-dimethylphenyl)-1,3,5-triazine; and tris(hydroxyphenyl)triazine compounds such as 2,4-bis(2-hydroxy-4-butoxyphenyl)-6-(2,4-dibutoxyphenyl))-1,3,5-triazine, 2,4,6-tris(2-hydroxy-4-octyloxyphenyl)-1,3,5-triazine, and 2,4,6-tris[2-hydroxy-4-(3-butoxy-2-hydroxypropyloxy)phenyl]-1,3,5-triazine.

In the present invention, the above-described various ultraviolet absorbing agents may be used alone, or two or more thereof may be used in combination.

The composition according to the embodiment of the present invention may contain or may not contain an ultraviolet absorbing agent. However, in a case of containing it, the content of the ultraviolet absorbing agent is preferably 0.001% by mass or more and 1% by mass or less, and more preferably 0.01% by mass or more and 0.1% by mass or less, with respect to the total solid content mass of the composition according to the embodiment of the present invention.

[Organic titanium compound]

The resin composition of the present embodiment may contain an organic titanium compound. In a case where the resin composition contains an organic titanium compound, it is possible to form a resin layer having excellent chemical resistance even in a case where curing is carried out at a low temperature.

Examples of the usable organic titanium compound include those in which an organic group is bonded to a titanium atom through a covalent bond or an ionic bond.

Specific examples of the organic titanium compound are described in I) to VII) below.

I) Titanium chelate compounds: among them, a titanium chelate compound having two or more alkoxy groups is more preferable since the resin composition has good storage stability and a good curing pattern can be obtained. Specific examples thereof include titanium bis(triethanolamine)diisopropoxide, titanium di(n-butoxide) bis(2,4-pentanedionate, titanium diisopropoxide bis(2,4-pentanedionate), titanium diisopropoxide bis(tetramethylheptandionate), and titanium diisopropoxide bis(ethyl acetoacetate).

II) Tetraalkoxy titanium compounds: examples thereof include titanium tetra(n-butoxide), titanium tetraethoxide, titanium tetra(2-ethylhexoxide), titanium tetraisobutoxide, titanium tetraisopropoxide, titanium tetramethoxide, titanium tetramethoxypropoxide, titanium tetramethylphenoxide, titanium tetra(n-nonyloxide), titanium tetra(n-propoxide), and titanium tetrastearyloxide, titanium tetrakis[bis{2,2-(aryloxymethyl)butoxide}].

III) Titanocene compounds: examples thereof include pentamethylcyclopentadienyl titanium trimethoxide, bis(η5-2,4-cyclopentadiene-1-yl) bis(2,6-difluorophenyl)titanium, and bis(η5-2,4-cyclopentadiene-1-yl) bis(2,6-difluoro-3-(1H-pyrrole-1-yl)phenyl)titamum.

IV) Monoalkoxytitanium compounds: examples thereof include titanium tris(dioctyl phosphate)isopropoxide, and titanium tris(dodecylbenzene sulfonate)isopropoxide.

V) Titanium oxide compounds: examples thereof include titanium oxide bis(pentanedionate), titanium oxide bis(tetramethylheptandionate), and phthalocyanine titanium oxide.

VI) Titanium tetraacetylacetonate compounds: examples thereof include titanium tetraacetylacetoneate.

VII) Titanate coupling agents: examples thereof include isopropyltridodecylbenzenesulfonyl titanate.

Among them, it is preferable that the organic titanium compound is at least one compound selected from the group consisting of the above-described I) titanium chelate compound, II) tetraalkoxytitanium compound, and III) titanocene compound, from the viewpoint that better chemical resistance is exhibited. In particular, titanium diisopropoxide bis(ethyl acetoacetate), titanium tetra(n-butoxide), or bis(η5-2,4-cyclopentadiene-1-yl) bis(2,6-difluoro-3-(1H-pyrrole-1-yl)phenyl)titanium is preferable.

In a case where an organic titanium compound is blended, the blending amount thereof is preferably 0.05 to 10 parts by mass and more preferably 0.1 to 2 parts by mass with respect to 100 parts by mass of the specific resin. In a case where the blending amount is 0.05 parts by mass or more, good heat resistance and good chemical resistance are more effectively exhibited in the curing pattern to be obtained. On the other hand, in a case where it is 10 parts by mass or less, the storage stability of the composition is more excellent.

[Antioxidant]

The composition according to the embodiment of the present invention may contain an antioxidant. In a case where an antioxidant is contained as an additive, it is possible to improve the elongation characteristics of the film after curing and the adhesiveness to the metal material. Examples of the antioxidant include a phenol compound, a phosphorous acid ester compound, and a thioether compound. As the phenol compound, any phenol compound known as the phenolic antioxidant can be used. Examples of the preferred phenolic compound include a hindered phenolic compound. A compound having a substituent at a site (ortho position) adjacent to a phenolic hydroxy group is preferable. As the substituent described above, a substituted or unsubstituted alkyl group having 1 to 22 carbon atoms is preferable. In addition, as the antioxidant, a compound having a phenol group and a phosphite ester group in the same molecule is also preferable. In addition, as the antioxidant, a phosphorus-based antioxidant can also be preferably used. Examples of the phosphorus-based antioxidant include tris[2-[[2,4,8,10-tetrakis(1,1-dimethylethyl)dibenzo[d, f][1,3,2]dioxaphosphepin-6-yl]oxy]ethyl]amine, tris[2-[(4,6,9,11-tetra-tert-butyldibenzo[d, f][1,3,2]dioxaphosphepin-2-yl)oxy]ethyl]amine, and ethyl phosphite bis(2,4-di-tert-butyl-6-methylphenyl). Examples of a commercially available product of the antioxidant include ADK STAB AO-20, ADK STAB AO-30, ADK STAB AO-40, ADK STAB AO-50, ADK STAB AO-50F, ADK STAB AO-60, ADK STAB AO-60G, ADK STAB AO-80, and ADK STAB AO-330 (all of which are manufactured by ADEKA Corporation). In addition, as the antioxidant, the compounds described in paragraph numbers 0023 to 0048 of JP6268967B can also be used, the content of which is incorporated in the present specification. Further, the composition of the embodiment of the present invention may contain a potential antioxidant, as necessary. Examples of the potential antioxidant include a compound in which a portion that functions as the antioxidant is protected by a protective group and the protective group is desorbed by heating the compound at 100°C to 250°C or by heating the compound at 80°C to 200°C in the presence of an acid/a base catalyst. Examples of the latent antioxidant include the compounds disclosed in WO2014/021023A, WO2017/030005A, and JP2017-008219A, the contents of which are incorporated in the present specification. Examples of a commercially available product of the potential antioxidant include ADEKA ARKLS GPA-5001 (manufactured by ADEKA Corporation). Examples of the preferred antioxidant include 2,2-thiobis(4-methyl-6-t-butylphenol), 2,6-di-t-butylphenol, and a compound represented by Formula (3).

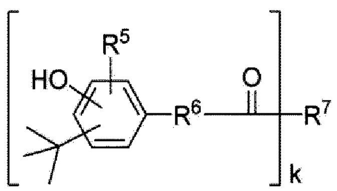

(3)

In General Formula (3), R5 represents a hydrogen atom or an alkyl group having 2 or more carbon atoms (preferably 2 to 10 carbon atoms), and R6 represents an alkylene group having 2 or more carbon atoms (preferably 2

to 10 carbon atoms). R7 represents a monovalent to tetravalent organic group containing at least any one of an alkylene group having 2 or more carbon atoms (preferably having 2 to 10 carbon atoms), an oxygen atom, or a nitrogen atom. k represents an integer of 1 to 4.

The compound represented by Formula (3) suppresses the oxidative deterioration of the aliphatic group or the phenolic hydroxyl group, contained in the resin. In addition, metal oxidation can be suppressed by the rust prevention action on the metal material.

Since the above compound can act on the resin and the metal material at the same time, k is more preferably an integer of 2 to 4. Examples of R7 include an alkyl group, a cycloalkyl group, an alkoxy group, an alkyl ether group, an alkylsilyl group, an alkoxysilyl group, an aryl group, an aryl ether group, a carboxyl group, a carbonyl group, an allyl group, a vinyl group, a heterocyclic group, -O-, -NH-, -NHNH-, and combinations thereof, and R7 may further have a substituent. Among these, an alkyl ether group or -NH- is preferably contained from the viewpoints of solubility in a developer and metal adhesiveness, and -NH-is more preferably contained from the viewpoints of the metal adhesiveness due to interaction with a resin and the metal complex formation.

Examples of the compound represented by General Formula (3) include the following compounds; however, the structure thereof is not limited to the following structure.

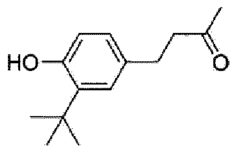
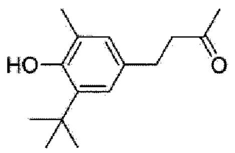
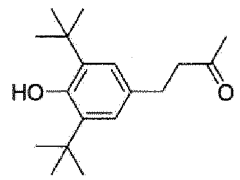

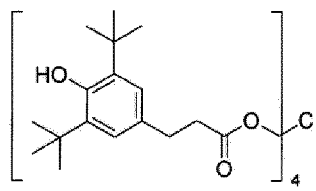
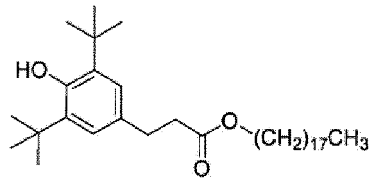

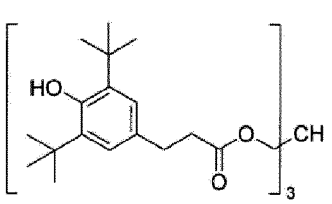
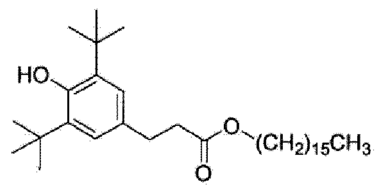

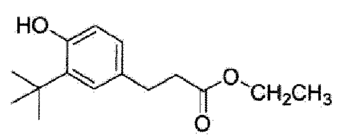
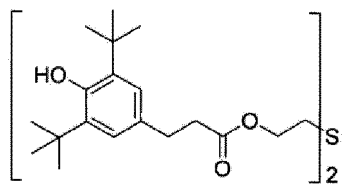

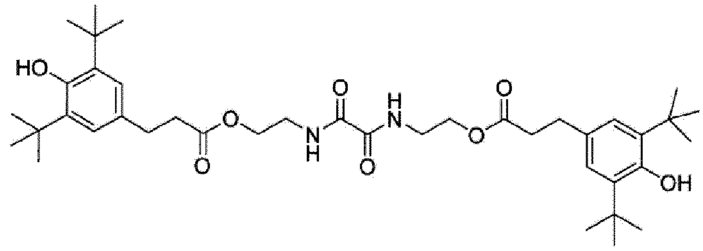

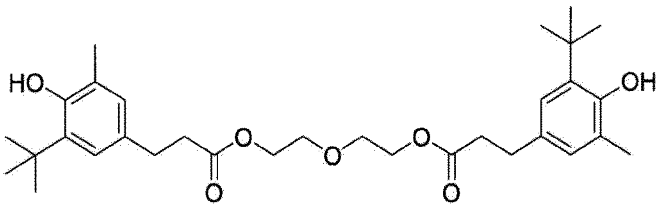

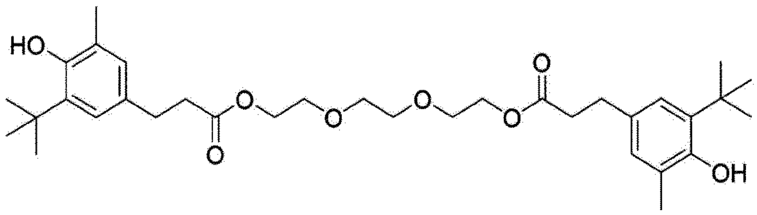

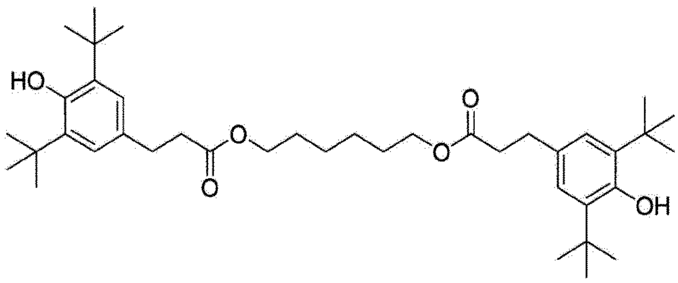

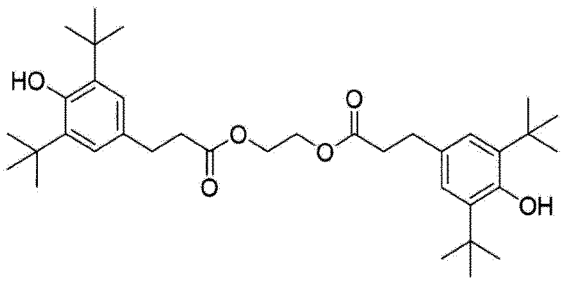

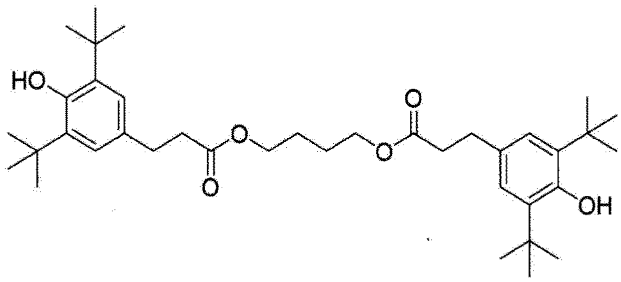

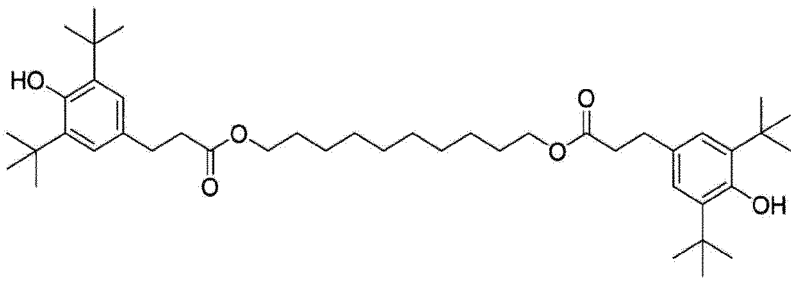

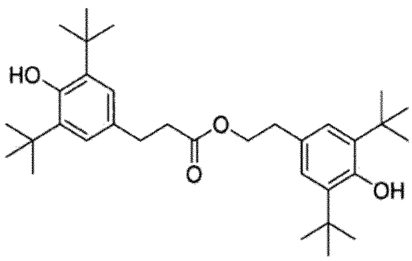

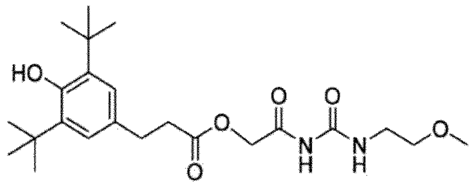

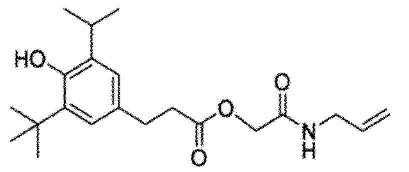

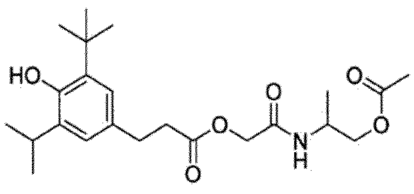

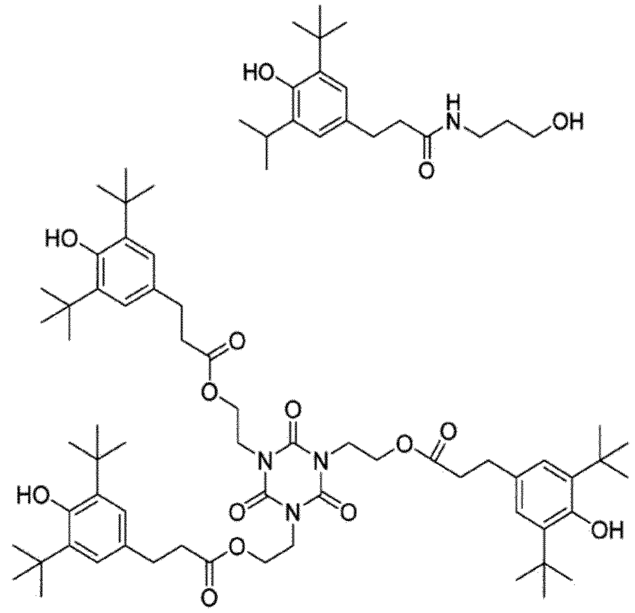

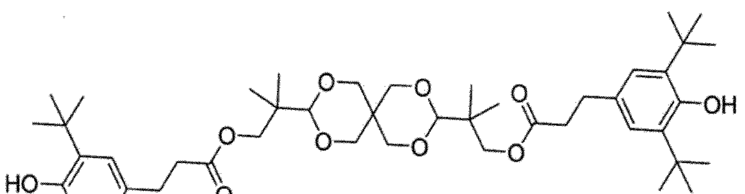

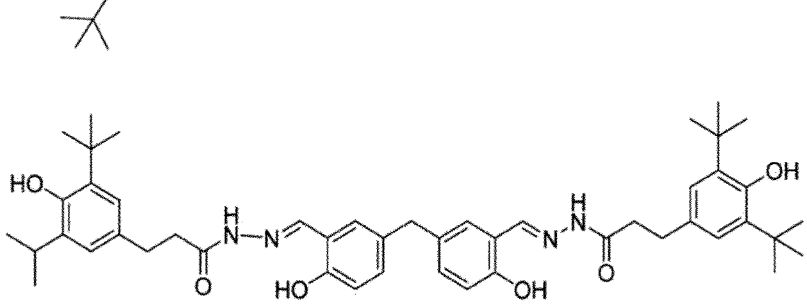

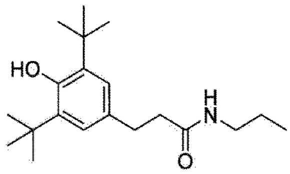

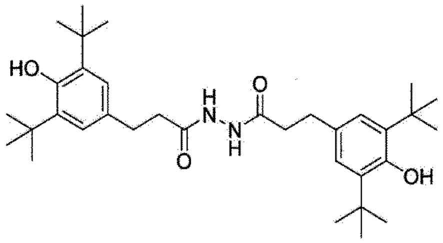

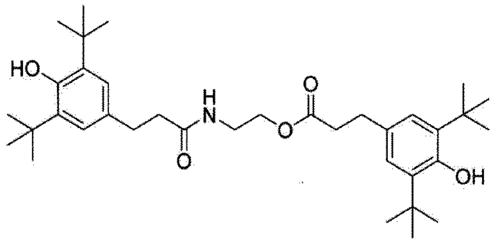

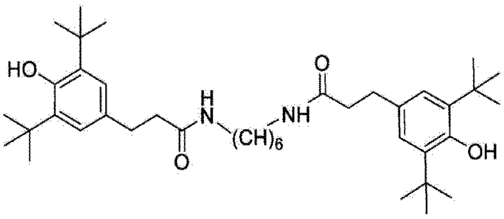

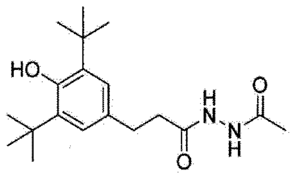

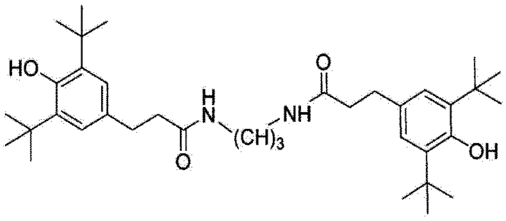

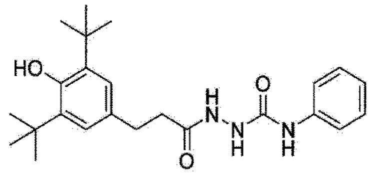

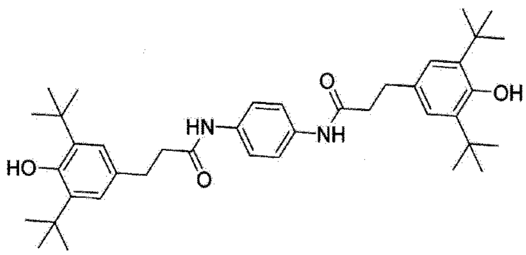

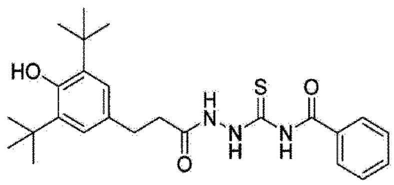

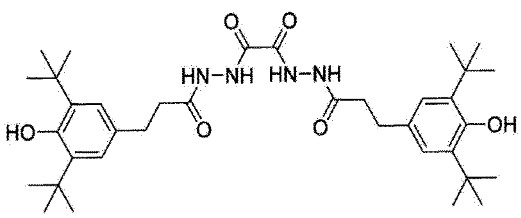

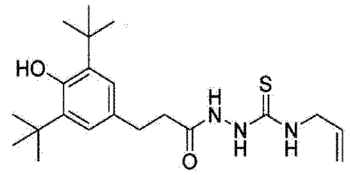

The adding amount of the antioxidant is preferably 0.1 to 10 parts by mass and more preferably 0.5 to 5 parts by mass with respect to the resin. In a case where the adding amount is set to 0.1 parts by mass or more, the effect of improving the elongation characteristics and the adhesiveness to the metal material can be easily obtained even in a high temperature and high humidity environment, and in a case where the adding amount is set to 10 parts by mass or less, the sensitivity of the resin composition is improved, for example, by the interaction with the photosensitizing agent. In the present invention, the antioxidant may be used singly or in a combination of two or more kinds thereof. In a case where two or more kinds thereof are used, the total amount thereof is preferably within the above-described range.

[Sensitizing agent]

The photocurable resin composition according to the embodiment of the present invention may contain a sensitizing agent. The sensitizing agent absorbs a specific radioactive ray to be in an electronically excited state. The sensitizing agent in the electronically excited state is brought into contact with a thermal radical polymerization initiator, a photoradical polymerization initiator, or the like, to cause actions such as electron transfer, energy transfer, and heat generation. As a result, the thermal radical polymerization initiator or the photoradical polymerization initiator undergoes a chemical change and decomposes to generate a radical, an acid, or a base.
Examples the sensitizing agent include, Michler's ketone, 4,4'-bis(diethylamino)benzophenone, 2,5-bis(4'-diethylaminobenzal)cyclopentane, 2,6-bis(4'-diethylaminobenzal)cyclohexanone, 2,6-bis(4'-diethylaminobenzal)-4-methylcyclohexanone, 4,4'-bis(dimethylamino)chalcone, 4,4'-bis(diethylamino)chalcone, p-dimethylaminocinnamylidene indanone, p-dimethylamino benzylidene indanone, 2-(p-dimethylaminophenylbiphenylene)-benzothiazole, 2-(p-dimethylaminophenylvinylene)benzothiazole, 2-(p-dimethylaminophenylvinylene)isonaphtothiazole, 1,3-bis(4'-dimethylaminobenzal)acetone, 1,3-bis(4'-diethylaminobenzal)acetone, 3,3'-carbonyl-bis(7-diethylaminocoumarin), 3-acetyl-7-dimethylaminocoumamin, 3-ethoxycarbonyl-7-dimethylaminocoumarin, 3-benzyloxycarbonyl-7-dimethylaminocoumarin, 3-methoxycarbonyl-7-diethylaminocoumamin, 3-ethoxycarbonyl-7-diethylaminocoumarin, N-phenyl-N'-ethylethanolamine, N-phenyldiethanolamine, N-p-tolyldiethanolamine, N-phenylethanolamine, 4-morpholinobenzophenone, isoamyl dimethylaminobenzoate, isoamyl diethylaminobenzoate, 2-mercaptobenzimidazole, 1-phenyl-5-mercaptotetrazole, 2-mercaptobenzothiazole, 2-(p-dimethylaminostyryl)benzoxazole, 2-(p-dimethylaminostyryl)benzothiazole, 2-(p-dimethylaminostyryl)naphtho (1,2-d)thiazole, 2-(p-dimethylaminobenzoyl)styrene, diphenylacetamide, benzanilide, N-methylacetanilide, and 3',4'-dimethylacetanilide.
In addition, a sensitizing dye may be used as the sensitizing agent.
For details of the sensitizing dye, reference can be made to the description in paragraphs 0161 to 0163 of JP2016-027357A, the content of which is incorporated in the present specification.
In a case where the photocurable resin composition according to the embodiment of the present invention contains a sensitizing agent, the content of the sensitizing agent is preferably 0.01% to 20% by mass, more preferably 0.1% to 15% by mass, and still more preferably 0.5% to 10% by mass, with respect to the total solid content of the photocurable resin composition according to the embodiment of the present invention. One kind of sensitizing agent may be used alone, or two or more kinds thereof may be used in combination.

[Chain transfer agent]

The photocurable resin composition according to the embodiment of the present invention may contain a chain transfer agent. The chain transfer agent is defined, for example, in Polymer Dictionary, 3rd Edition, pp. 683 to 684 (edited by The Society of Polymer Science, 2005). As the chain transfer agent, for example, a group of compounds having SH, PH, SiH, and GeH in the molecule is used. These can donate hydrogen to a low active radical to generate a radical or can be oxidized and then deprotonated to generate a radical. In particular, a thiol compound can be preferably used.
In addition, as the chain transfer agent, the compounds described in paragraphs 0152 and 0153 of WO2015/199219A can also be used.
In a case where the photocurable resin composition according to the embodiment of the present invention has a chain transfer agent, the content of the chain transfer agent is preferably 0.01 to 20 parts by mass, more preferably 1 to 10 parts by mass, and still more preferably 1 to 5 parts by mass, with respect to 100 parts by mass of the total solid content of the photocurable resin composition according to the embodiment of the present invention. One kind of chain transfer agent may be used, or two or more kinds thereof may be used. In a case where two or more kinds of chain transfer agents are used, the total thereof is preferably within the above-described range.

[Higher fatty acid derivative]

In the photocurable resin composition according to the embodiment of the present invention, in order to prevent polymerization inhibition due to oxygen, a higher fatty acid derivative such as behenic acid or behenic acid amide may be added and be caused to be localized on a surface of the photocurable resin composition in the process of drying after coating.
In addition, as the higher fatty acid derivative, the compounds described in paragraph 0155 of WO2015/199219A can also be used.
In a case where the photocurable resin composition according to the embodiment of the present invention has a higher fatty acid derivative, the content of the higher fatty acid derivative is preferably 0.1% to 10% by mass with respect to the total solid content of the photocurable resin composition according to the embodiment of the present invention. One kind of higher fatty acid derivative may be used, or two or more kinds thereof may be used. In a case

where two or more kinds of higher fatty acid derivatives are used, the total thereof is preferably within the above-described range.

<Restriction on other substances to be contained>

The water content of the photocurable resin composition according to the embodiment of the present invention is preferably less than 5% by mass, more preferably less than 1% by mass, and still more preferably less than 0.6% by mass, from the viewpoint of properties of a coated surface.

From the viewpoint of insulating properties, the metal content of the photocurable resin composition according to the embodiment of the present invention is preferably less than 5 parts per million (ppm) by mass, more preferably less than 1 ppm by mass, and still more preferably less than 0.5 ppm by mass. Examples of the metal include sodium, potassium, magnesium, calcium, iron, chromium, nickel. In a case where a plurality of metals are contained, the total of these metals is preferably within the above-described range.

In addition, as a method of reducing metal impurities which are unintentionally contained in the photocurable resin composition according to the embodiment of the present invention, a method of selecting a raw material containing a low metal content as the raw material that constitutes the photocurable resin composition according to the embodiment of the present invention, a method of filtering a raw material constituting the photocurable resin composition according to the embodiment of the present invention, a method of distilling under the conditions in which the inside of the device is lined with polytetrafluoroethylene or the like to suppress the contamination as little as possible, and the like can be mentioned.

In the photocurable resin composition according to the embodiment of the present invention, in a case of considering the use application as a semiconductor material, the content of halogen atoms is preferably less than 500 ppm by mass, more preferably less than 300 ppm by mass, and still more preferably less than 200 ppm by mass, from the viewpoint of the wiring line corrosiveness. Among these, in a case of being present in a halogen ion state, the content is preferably less than 5 ppm by mass, more preferably less than 1 ppm by mass, and still more preferably less than 0.5 ppm by mass. Examples of the halogen atom include a chlorine atom and a bromine atom. It is preferable that the total content of the chlorine atom and the bromine atom, or the total content of the chlorine ion and the bromine ion is within the above-described range.

As a storage container of the photocurable resin composition according to the embodiment of the present invention, a known storage container in the related art can be used. In addition, as the storage container, for the intended purpose of suppressing incorporation of impurities into the raw materials and the photocurable resin composition, a multilayer bottle in which an inner wall of a container is composed of six kinds of six layers of resin, and a bottle with six kinds of resin being made as a seven-layer structure are preferably used. Examples of such a container include the container described in JP2015-123351A.

<Use application of photocurable resin composition>

The photocurable resin composition according to the embodiment of the present invention is preferably used for forming an interlayer insulating film for a re-distribution layer.

In addition, it can also be used for forming an insulating film of an electronic device, forming a stress buffer film.

<Preparation of photocurable resin composition>

The photocurable resin composition according to the embodiment of the present invention can be prepared by mixing the above-described components. The mixing method is not particularly limited, and mixing can be carried out by methods conventionally known in the related art.

In addition, for the intended purpose of removing foreign substances such as dust and fine particles in the photocurable resin composition, it is preferable to carry out filtration using a filter. A filter pore size is preferably 1 μm or lower, more preferably 0.5 μm or lower, and still more preferably 0.1 μm or lower. The material of the filter is preferably polytetrafluoroethylene, polyethylene, or nylon. As the filter, a filter which has been washed with an organic solvent in advance may be used. In the filtration step using the filter, a plurality of kinds of filters may be connected in series or in parallel and used. In a case where a plurality of kinds of filters are used, filters having different pore sizes or different materials may be used in combination. In addition, various materials may be filtered a plurality of times. In a case of being filtered a plurality of times, circulation filtration may be used. In addition, filtration may be carried out under pressure. In a case where filtration is carried out under pressure, the pressure is preferably 0.05 MPa or more and 0.3 MPa or less.

In addition to filtration using a filter, impurity removal treatment using an adsorption material may be carried out. The filtration using a filter and the impurity removal treatment using an adsorption material may be combined. As the adsorption material, a conventionally known adsorption material can be used. Examples thereof include an inorganic

adsorption material such as silica gel and zeolite and an organic adsorption material such as activated carbon.

Examples

Hereinafter, the present invention will be described in detail using examples. Materials, using amounts, proportions, treatment details, treatment procedures, and the like shown in the following examples can be appropriately changed without departing from the gist of the present invention. Accordingly, the scope of the present invention is not limited to the following specific examples. Unless otherwise specified, "parts" and "%" are based on mass.

<Synthesis Example 1: Synthesis of polymer E>

Into 8.50 ml of N,N-dimethylacetamide (DMAc) containing 0.600 g (3.00 mmol) of oxydianiline (hereinafter abbreviated as "ODA"), 0.883 g (3.00 mmol) of 4,4'-biphenyltetracarboxylic acid dianhydride (hereinafter, abbreviated as "BPDA") was added at one time, and the resultant mixture was stirred in a room temperature environment for 12 hours to obtain a highly viscous transparent solution of a polymer E. The intrinsic viscosity of the polymer in DMAc was 0.73 dL/g at a concentration of 0.5 g/dL at 30°C. As DMAc, one purified by vacuum distillation was used, and as ODA and BPDA, those respectively recrystallized from tetrahydrofuran (THF) and acetic anhydride were used.

<Synthesis Example 2: Synthesis of polymer A-1>

155.1 g of 4,4'-oxydiphthalic acid dianhydride (ODPA) was placed in a separable flask having a volume of 2 liters, 131.2 g of 2-hydroxyethyl methacrylate (HEMA) and 400 ml of γ-butyrolactone were placed therein, and the resultant mixture was stirred at room temperature, and then 81.5 g of pyridine was added to the mixture with stirring to obtain a reaction mixture. After the heat generation due to the reaction was stopped, the mixture was allowed to cool to room temperature and left to stand for 16 hours.

Next, under ice-cooling, a solution obtained by dissolving 206.3 g of dicyclohexylcarbodiimide (DCC) in 180 ml of γ-butyrolactone was added to the reaction mixture over 40 minutes with stirring, and subsequently a suspension obtained by suspending 93.0 g of 4,4'-diaminodiphenyl ether (DADPE) in 350 ml of γ-butyrolactone was added thereto over 60 minutes with stirring. After further stirring at room temperature for 2 hours, 30 ml of ethyl alcohol was added thereto, the mixture was stirred for 1 hour, and then 400 ml of γ-butyrolactone was added thereto. The precipitate formed in the reaction mixture was removed by filtration to obtain a reaction solution.

The obtained reaction solution was added to 3 liters of ethyl alcohol to form a precipitate consisting of a crude polymer. The produced crude polymer was filtered out and dissolved in 1.5 liters of tetrahydrofuran to obtain a crude polymer solution. The obtained crude polymer solution was added dropwise to 28 liters of water to precipitate the polymer, and the obtained precipitate was filtered out and then vacuum dried to obtain a powdery polymer A-1. As a result of measuring the molecular weight of the polymer A-1 by gel permeation chromatography (in terms of standard polystyrene-equivalent value), the weight-average molecular weight (Mw) was 20,000.

<Synthesis Example 3: Synthesis of polymer B-1>

The reaction was carried out in the same manner as described in Synthesis Example 2 to obtain a polymer B-1, except that 147.1 g of 3,3',4,4'-biphenyltetracarboxylic dianhydride was used instead of 155.1 g of 4,4'-oxydiphthalic acid dianhydride Synthesis Example 2. As a result of measuring the molecular weight of the polymer B-1 by gel permeation chromatography (in terms of standard polystyrene-equivalent value), the weight-average molecular weight (Mw) was 22,000.

<Synthesis Example 4: Synthesis of polymer A-2>

20.0 g (64.5 mmol) of 4,4'-oxydiphthalic acid dianhydride (dried at 140°C for 12 hours) and 17.12 g (131.58 mmol) of 2-hydroxyethyl methacrylate (HEMA) were suspended in 50 mL of N-methylpyrrolidone and dried with a molecular sieve. The suspension was heated at 100°C for 3 hours. A clear solution was obtained a few minutes after the start of heating. The reaction mixture was cooled to room temperature, and 21.43 g (270.9 mmol) pyridine and 90 ml N-methylpyrrolidone were added thereto. Then, the reaction mixture was cooled to -10°C, and 16.12 g (135.5 mmol) of $SOCl_2$ was added thereto over 10 minutes while keeping the temperature at -10°C ± 4°C. Viscosity increased while adding $SOCl_2$. After diluting with 50 ml of N-methylpyrrolidone, the reaction mixture was stirred at room temperature for 2 hours. Then, a solution prepared by dissolving 11.75 g (58.7 mmol) of 4,4'-diaminodiphenyl ether in 100 ml of N-methylpyrrolidone was dropwise added to the reaction mixture at 20°C to 23°C over 20 minutes. The reaction mixture was then stirred overnight at room temperature. The polyimide precursor was then precipitated in 5 L of water and the

water-polyimide precursor mixture was stirred for 15 minutes at a speed of 5,000 rpm. The polyimide precursor was collected by filtration, put into 4 liters of water again, stirred for 30 minutes, and filtered again. Then, the obtained polyimide precursor was dried under reduced pressure at 45°C for 3 days to obtain polymer A-2.

<Synthesis Example 5: Synthesis of polymer B-2>

The reaction was carried out in the same manner as described in Synthesis Example 4 to obtain a polymer B-2, except that in Synthesis Example 4, 19.0 g (64.5 mmol) of 3,3',4,4'-biphenyltetracarboxylic dianhydride was instead of 20.0 g (64.5 mmol) of 4,4'-oxydiphthalic acid dianhydride.

<Synthesis Example 6: Synthesis of polymer C>

In a separable flask, 2,2-bis (3-amino-4-hydroxyphenyl) -hexafluoropropane 183.1 g (0.5 mol), N,N-dimethylacetamide (DMAc) 640.9 g, pyridine 63.3 g (0.8 mol) was mixed and stirred at room temperature (25°C) to prepare a uniform solution. To this solution, a solution obtained by dissolving 118.0 g (0.4 mol) of 4,4'-diphenyl ether dicarbonyl chloride in 354 g of diethylene glycol dimethyl ether (DMDG) was added dropwise with a dropping funnel. At this time, the separable flask was cooled in a water bath at 15°C to 20°C. The time required for the dropwise addition was 40 minutes, and the maximum temperature of the reaction solution was 30°C.

After 3 hours from the completion of the dropwise addition, 30.8 g (0.2 mol) of 1,2-cyclohexyldicarboxylic acid anhydride was added to the reaction solution, and the resultant mixture was left to stand with stirring at room temperature for 15 hours to block 99% of all amine terminal groups of the polymer chain with a carboxycyclohexylamide group. It is noted that the reaction rate at this time can be easily calculated by tracking the remaining amount of the charged 1,2-cyclohexyldicarboxylic acid anhydride with high performance liquid chromatography (HPLC). Thereafter, the above reaction solution was added dropwise to 2 L of water with high speed stirring to disperse and precipitate the polymer, which was subsequently recovered, washed with water as appropriate, dehydrated, and vacuum dried, thereby obtaining a crude polybenzoxazole precursor having a weight-average molecular weight of 9,000 (in terms of standard polystyrene-equivalent value) measured according to gel permeation chromatography (GPC).

The crude polybenzoxazole precursor obtained as described above was redissolved in γ-butyrolactone (GBL) and then treated with a cation exchange resin and an anion exchange resin. The resultant solution was put into ion exchange water, the precipitated polymer was filtered out, washed with water, and vacuum dried to obtain a purified polybenzoxazole precursor (a polymer C).

<Synthesis Example 7: synthesis of polymer D>

A polymer D was synthesized from pyromellitic acid dianhydride, 3,3',4,4'-biphenyltetracarboxylic dianhydride, and 2,2'-bis(trifluoromethyl)benzidine, according to the same method as the synthesis method for PFAA described, in H Seino et al., J. Polym. Sci., Part A: Polym. Chem., 36, 2261 (1998).

<Examples and Comparative Examples>

In each Example, components shown in Table 1 to Table 4 below were mixed to obtain each of the photocurable resin compositions. Further, in each Comparative Example, components shown in Table 4 below were mixed to obtain each of the comparative compositions.

Specifically, the contents of the components shown in Table 1 to Table 4 are indicated by numerical values in terms of parts by mass, described in Tables 1 to 4.

The obtained photocurable resin composition and the comparative composition were pressure-filtered through a filter made of polytetrafluoroethylene, having a filter pore diameter of 0.8 μm.

In addition, in Table 1 to Table 4, the description of "-" indicates that the corresponding component is not contained in the composition.

[Table 1]

| | | Example | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Resin | E | 7.5 | - | - | - | - | - | - | - | - | - | - | - |
| | A-1 | - | 13.8 | 12.8 | 13.8 | 13.8 | 13.8 | 13.8 | 13.8 | 13.8 | 13.8 | 13.8 | 13.8 |
| | B-1 | - | 13.8 | 12.8 | 13.8 | 13.8 | 13.8 | 13.8 | 13.8 | 13.8 | 13.8 | 13.8 | 13.8 |
| | A-2 | - | - | - | - | - | - | - | - | - | - | - | - |
| | B-2 | - | - | - | - | - | - | - | - | - | - | - | - |
| | C | - | - | - | - | - | - | - | - | - | - | - | - |
| | D | - | - | - | - | - | - | - | - | - | - | - | - |
| Crosslinking agent | F-1 | 2.5 | 5.5 | 5.5 | 5.5 | 5.5 | 5.5 | 5.5 | 5.5 | 5.5 | 5.5 | - | - |
| | F-2 | - | - | - | - | - | - | - | - | - | - | 5.5 | - |
| | F-3 | - | - | - | - | - | - | - | - | - | - | - | 5.5 |
| | F-4 | - | - | - | - | - | - | - | - | - | - | - | - |
| | F-5 | - | - | - | - | - | - | - | - | - | - | - | - |
| | F-6 | - | 1.7 | 1.7 | 1.7 | 1.7 | 1.7 | 1.7 | 1.7 | 1.7 | 1.7 | 1.7 | 1.7 |
| Adhesive | G-1 | - | 0.74 | 0.74 | - | 0.74 | 0.74 | 0.74 | 0.74 | 0.74 | 0.74 | 0.74 | 0.74 |
| | G-2 | - | - | - | - | - | - | - | - | - | - | - | - |
| | G-3 | - | - | - | - | - | - | - | - | - | - | - | - |
| | G-4 | - | - | - | - | - | - | - | - | - | - | - | - |
| | G-5 | - | - | - | 0.74 | - | - | - | - | - | - | - | - |
| Polymerization inhibitor | H-1 | - | - | - | - | - | - | - | - | - | - | - | - |
| | H-2 | - | - | - | - | - | - | - | - | - | - | - | - |
| | H-3 | - | 0.05 | 0.05 | 0.05 | 0.05 | 0.05 | 0.05 | 0.05 | 0.05 | 0.05 | 0.05 | 0.05 |
| Photopolymerization initiator | I-1 | - | - | - | - | 1.3 | 1.3 | 1.3 | 1.3 | 1.3 | - | 1.3 | 1.3 |
| | I-2 | - | - | - | - | - | - | - | - | - | - | - | - |
| | I-3 | - | - | - | - | - | - | - | - | - | - | - | - |
| | I-4 | - | - | - | - | - | - | - | - | - | - | - | - |
| | I-5 | - | - | - | - | - | - | - | - | - | - | - | - |
| | I-6 | 1.5 | 1.3 | 1.3 | 1.3 | - | - | - | - | - | 1.3 | - | - |
| | I-7 | - | - | - | - | - | - | - | - | - | - | - | - |
| Photoacid generator | J-1 | - | - | - | - | - | - | - | - | - | - | - | - |
| | J-2 | - | - | - | - | - | - | - | - | - | - | - | - |

(continued)

| | | Example | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Photobase generator | K-1 | 2.5 | 2.5 | 2.5 | 2.5 | - | - | - | - | - | - | - | - |
| | K-2 | - | - | - | - | - | - | - | - | - | - | - | - |
| | K-3 | - | - | - | - | - | - | - | - | - | - | - | - |
| | K-4 | - | - | - | - | 2.5 | - | - | - | - | - | 2.5 | 2.5 |
| | K-5 | - | - | - | - | - | 2.5 | - | - | - | - | - | - |
| | K-6 | - | - | - | - | - | - | 2.5 | - | - | - | - | - |
| | K-7 | - | - | - | - | - | - | - | 2.5 | - | - | - | - |
| | K-8 | - | - | - | - | - | - | - | - | 2.5 | - | - | - |
| | K-9 | - | - | - | - | - | - | - | - | - | 2.5 | - | - |
| Thermal base generator | L-1 | - | - | - | - | - | - | - | - | - | - | - | - |
| Other additives | M-1 | - | 0.05 | 0.05 | 0.05 | 0.05 | 0.05 | 0.05 | 0.05 | 0.05 | 0.05 | 0.05 | 0.05 |
| | M-2 | - | 5.0 | 5.0 | 5.0 | 5.0 | 5.0 | 5.0 | 5.0 | 5.0 | 5.0 | 5.0 | 5.0 |
| | M-3 | - | - | - | - | - | - | - | - | - | - | - | - |
| | M-4 | - | - | - | - | - | - | - | - | - | - | - | - |
| | M-5 | - | - | 2.0 | - | - | - | - | - | - | - | - | - |
| | M-6 | - | - | - | - | - | - | - | - | - | - | - | - |
| Solvent | S-1 | - | 44.5 | 44.5 | 44.5 | 44.5 | 44.5 | 44.5 | 44.5 | 44.5 | 44.5 | 44.5 | 44.5 |
| | S-2 | - | 11.1 | 11.1 | 11.1 | 11.1 | 11.1 | 11.1 | 11.1 | 11.1 | 11.1 | 11.1 | 11.1 |
| | S-3 | - | - | - | - | - | - | - | - | - | - | - | - |
| | S-4 | - | - | - | - | - | - | - | - | - | - | - | - |
| | S-5 | 86.0 | - | - | - | - | - | - | - | - | - | - | - |

[Table 2]

| | | Example | | | | | | | | | | | |
|---|---|---|---|---|---|---|---|---|---|---|---|---|---|
| | | 13 | 14 | 15 | 16 | 17 | 18 | 19 | 20 | 21 | 22 | 23 | 24 |
| Resin | E | - | - | - | - | - | - | - | - | - | - | - | - |
| | A-1 | 13.8 | 13.8 | 13.8 | 13.8 | 13.8 | 13.8 | 13.8 | 13.8 | 13.8 | 13.8 | - | - |
| | B-1 | 13.8 | 13.8 | 13.8 | 13.8 | 13.8 | 13.8 | 13.8 | 13.8 | 13.8 | 13.8 | - | - |
| | A-2 | - | - | - | - | - | - | - | - | - | - | 17.1 | 34.1 |
| | B-2 | - | - | - | - | - | - | - | - | - | - | 17.1 | - |
| | C | - | - | - | - | - | - | - | - | - | - | - | - |
| | D | - | - | - | - | - | - | - | - | - | - | - | - |

(continued)

| | | Example | | | | | | | | | | | |
|---|---|---|---|---|---|---|---|---|---|---|---|---|---|
| | | 13 | 14 | 15 | 16 | 17 | 18 | 19 | 20 | 21 | 22 | 23 | 24 |
| Crosslinking agent | F-1 | - | - | - | - | 5.5 | - | - | 5.5 | 5.5 | 5.5 | 5.5 | 5.5 |
| | F-2 | - | 5.5 | 5.5 | 5.5 | - | - | - | - | - | - | - | - |
| | F-3 | - | - | - | - | - | - | - | - | - | - | - | - |
| | F-4 | 5.5 | - | - | - | - | - | - | - | - | - | - | - |
| | F-5 | - | - | - | - | - | 5.5 | 5.5 | - | - | - | - | - |
| | F-6 | 1.7 | 1.7 | 1.7 | 1.7 | 1.7 | 1.7 | 1.7 | 1.7 | 1.7 | 1.7 | - | - |
| Adhesive | G-1 | 0.74 | - | - | - | 0.74 | 0.74 | 0.74 | 0.74 | 0.74 | 0.74 | - | - |
| | G-2 | - | 0.74 | - | - | - | - | - | - | - | - | 0.74 | 0.74 |
| | G-3 | - | - | 0.74 | - | - | - | - | - | - | - | - | - |
| | G-4 | - | - | - | 0.74 | - | - | - | - | - | - | - | - |
| | G-5 | - | - | - | - | - | - | - | - | - | - | - | - |
| Polymerization inhibitor | H-1 | | | | | | | | | | | - | - |
| | H-2 | - | - | - | - | - | - | - | - | - | - | 0.05 | 0.05 |
| | H-3 | 0.05 | 0.05 | 0.05 | 0.05 | 0.05 | 0.05 | 0.05 | 0.05 | 0.05 | 0.05 | - | - |
| Photopolymerization initiator | I-1 | 1.3 | 1.3 | 1.3 | 1.3 | 1.3 | - | - | - | - | - | - | - |
| | I-2 | - | - | - | - | - | - | - | - | - | - | - | - |
| | I-3 | - | - | - | - | - | - | - | - | - | - | 1.3 | 1.3 |
| | I-4 | - | - | - | - | - | - | - | - | - | - | - | - |
| | I-5 | - | - | - | - | - | - | - | 1.3 | 1.3 | 1.3 | - | - |
| | I-6 | - | - | - | - | - | - | - | - | - | - | - | - |
| | I-7 | - | - | - | - | - | - | - | - | - | - | - | - |
| Photoacid generator | J-1 | - | - | - | - | - | 1.3 | - | - | - | - | - | - |
| | J-2 | - | - | - | - | - | - | 1.3 | - | - | - | - | - |
| Photobase generator | K-1 | - | - | - | - | - | - | - | - | - | - | - | - |
| | K-2 | - | - | - | - | - | - | - | 2.5 | - | - | - | - |
| | K-3 | - | - | - | - | - | 2.5 | 2.5 | - | 2.5 | - | - | - |
| | K-4 | 2.5 | 2.5 | 2.5 | 2.5 | - | - | - | - | - | - | 2.5 | 2.5 |
| | K-5 | - | - | - | - | - | - | - | - | - | 2.5 | - | - |
| | K-6 | - | - | - | - | 2.5 | - | - | - | - | - | - | - |
| | K-7 | - | - | - | - | - | - | - | - | - | - | - | - |
| | K-8 | - | - | - | - | - | - | - | - | - | - | - | - |
| | K-9 | - | - | - | - | - | - | - | - | - | - | - | - |
| Thermal base generator | L-1 | - | - | - | - | - | - | - | - | - | - | - | - |

(continued)

| | | Example | | | | | | | | | | | |
|---|---|---|---|---|---|---|---|---|---|---|---|---|---|
| | | 13 | 14 | 15 | 16 | 17 | 18 | 19 | 20 | 21 | 22 | 23 | 24 |
| Other additives | M-1 | 0.05 | 0.05 | 0.05 | 0.05 | 0.05 | 0.05 | 0.05 | 0.05 | 0.05 | 0.05 | - | - |
| | M-2 | 5.0 | 5.0 | 5.0 | 5.0 | 5.0 | 5.0 | 5.0 | 5.0 | 5.0 | 5.0 | - | - |
| | M-3 | - | - | - | - | - | - | - | - | - | - | - | - |
| | M-4 | - | - | - | - | - | - | - | - | - | - | 0.2 | 0.2 |
| | M-5 | - | - | - | - | - | - | - | - | - | - | - | - |
| | M-6 | - | - | - | - | - | - | - | - | - | - | - | - |
| Solvent | S-1 | 44.5 | 44.5 | 44.5 | 44.5 | 44.5 | 44.5 | 44.5 | 44.5 | 44.5 | 44.5 | - | - |
| | S-2 | 11.1 | 11.1 | 11.1 | 11.1 | 11.1 | 11.1 | 11.1 | 11.1 | 11.1 | 11.1 | - | - |
| | S-3 | - | - | - | - | - | - | - | - | - | - | 44.5 | 44.5 |
| | S-4 | - | - | - | - | - | - | - | - | - | - | 11.1 | 11.1 |
| | S-5 | - | - | - | - | - | - | - | - | - | - | - | - |

[Table 3]

| | | Example | | | | | | | | | | | |
|---|---|---|---|---|---|---|---|---|---|---|---|---|---|
| | | 25 | 26 | 27 | 28 | 29 | 30 | 31 | 32 | 33 | 34 | 35 | 36 |
| Resin | E | - | - | - | - | - | - | - | - | - | - | - | - |
| | A-1 | - | - | - | - | - | - | - | - | - | - | - | - |
| | B-1 | - | - | - | - | - | - | - | - | - | - | - | - |
| | A-2 | - | - | - | - | - | - | - | - | - | - | - | - |
| | B-2 | 34.1 | 34.1 | 34.1 | 34.1 | 34.1 | 34.1 | 34.1 | 34.1 | 34.1 | 34.1 | 34.1 | 34.1 |
| | C | - | - | - | - | - | - | - | - | - | - | - | - |
| | D | - | - | - | - | - | - | - | - | - | - | - | - |
| Crosslinking agent | F-1 | 5.5 | 5.5 | 5.5 | 5.5 | 5.5 | 5.5 | 5.5 | 5.5 | - | - | - | 5.5 |
| | F-2 | - | - | - | - | - | - | - | - | 5.5 | - | - | - |
| | F-3 | - | - | - | - | - | - | - | - | - | 5.5 | - | - |
| | F-4 | - | - | - | - | - | - | - | - | - | - | 5.5 | - |
| | F-5 | - | - | - | - | - | - | - | - | - | - | - | - |
| | F-6 | - | - | - | - | - | - | - | - | - | - | - | - |
| Adhesive | G-1 | - | - | - | - | - | - | - | - | - | - | - | - |
| | G-2 | 0.74 | 0.74 | 0.74 | 0.74 | 0.74 | 0.74 | 0.74 | 0.74 | 0.74 | 0.74 | 0.74 | 0.74 |
| | G-3 | - | - | - | - | - | - | - | - | - | - | - | - |
| | G-4 | - | - | - | - | - | - | - | - | - | - | - | - |
| | G-5 | - | - | - | - | - | - | - | - | - | - | - | - |
| Polymerization inhibitor | H-1 | - | - | - | - | - | - | - | - | - | - | - | - |
| | H-2 | 0.05 | 0.05 | 0.05 | 0.05 | 0.05 | 0.05 | 0.05 | 0.05 | 0.05 | 0.05 | 0.05 | 0.05 |
| | H-3 | - | - | - | - | - | - | - | - | - | - | - | - |

(continued)

| | | Example | | | | | | | | | | | |
|---|---|---|---|---|---|---|---|---|---|---|---|---|---|
| | | 25 | 26 | 27 | 28 | 29 | 30 | 31 | 32 | 33 | 34 | 35 | 36 |
| Photopolymerization initiator | I-1 | - | - | - | - | - | - | - | - | - | - | - | - |
| | I-2 | - | - | - | - | - | 1.3 | - | - | - | - | - | - |
| | I-3 | 1.3 | 1.3 | 1.3 | 1.3 | 1.3 | - | - | 1.3 | 1.3 | 1.3 | 1.3 | 1.3 |
| | I-4 | - | - | - | - | - | - | 1.3 | - | - | - | - | - |
| | I-5 | - | - | - | - | - | - | - | - | - | - | - | - |
| | I-6 | - | - | - | - | - | - | - | - | - | - | - | - |
| | I-7 | - | - | - | - | - | - | - | - | - | - | - | - |
| Photoacid generator | J-1 | - | - | - | - | - | - | - | - | - | - | - | - |
| | J-2 | - | - | - | - | - | - | - | - | - | - | - | - |
| Photobase generator | K-1 | - | - | - | - | - | - | - | - | - | - | - | - |
| | K-2 | - | - | - | - | - | - | - | - | - | - | - | - |
| | K-3 | - | - | - | - | - | - | - | - | - | - | - | - |
| | K-4 | 2.5 | - | - | - | - | 2.5 | 2.5 | 2.5 | 2.5 | 2.5 | 2.5 | 2.5 |
| | K-5 | - | 2.5 | - | - | - | - | - | - | - | - | - | - |
| | K-6 | - | - | 2.5 | - | - | - | - | - | - | - | - | - |
| | K-7 | - | - | - | 2.5 | - | - | - | - | - | - | - | - |
| | K-8 | - | - | - | - | 2.5 | - | - | - | - | - | - | - |
| | K-9 | - | - | - | - | - | - | - | - | - | - | - | - |
| Thermal base generator | L-1 | - | - | - | - | - | - | - | - | - | - | - | - |
| Other additives | M-1 | - | - | - | - | - | - | - | - | - | - | - | - |
| | M-2 | - | - | - | - | - | - | - | - | - | - | - | - |
| | M-3 | - | - | - | - | - | - | - | - | - | - | - | - |
| | M-4 | 0.2 | 0.2 | 0.2 | 0.2 | 0.2 | 0.2 | 0.2 | 0.2 | 0.2 | 0.2 | 0.2 | 0.2 |
| | M-5 | - | - | - | - | - | - | - | - | - | - | - | - |
| | M-6 | - | - | - | - | - | - | - | - | - | - | - | - |
| Solvent | S-1 | - | - | - | - | - | - | - | - | - | - | - | - |
| | S-2 | - | - | - | - | - | - | - | - | - | - | - | - |
| | S-3 | 44.5 | 44.5 | 44.5 | 44.5 | 44.5 | 44.5 | 44.5 | 44.5 | 44.5 | 44.5 | 44.5 | 44.5 |
| | S-4 | 11.1 | 11.1 | 11.1 | 11.1 | 11.1 | 11.1 | 11.1 | 11.1 | 11.1 | 11.1 | 11.1 | 11.1 |
| | S-5 | - | - | - | - | - | - | - | - | - | - | - | - |

[Table 4]

| | | Example | | | | | | | | Comparative Example | |
|---|---|---|---|---|---|---|---|---|---|---|---|
| | | 37 | 38 | 39 | 40 | 41 | 42 | 43 | 44 | 1 | 2 |
| Resin | E | - | - | - | - | - | - | - | - | 7.5 | 7.5 |
| | A-1 | - | - | - | - | - | - | - | - | - | - |
| | B-1 | - | - | - | - | - | - | - | - | - | - |
| | A-2 | - | - | 17.1 | - | - | - | - | 17.1 | - | - |
| | B-2 | 34.1 | 33.1 | 17.1 | 34.1 | 34.1 | - | - | 17.1 | - | - |
| | C | - | - | - | - | - | 34.3 | - | - | - | - |
| | D | - | - | - | - | - | - | 35.1 | - | - | - |
| Crosslinking agent | F-1 | 5.5 | 5.5 | 5.5 | - | - | 5.5 | - | 5.5 | - | 2.5 |
| | F-2 | - | - | - | - | - | - | - | - | - | - |
| | F-3 | - | - | - | - | - | - | - | - | - | - |
| | F-4 | - | - | - | - | - | - | - | - | - | - |
| | F-5 | - | - | - | 5.5 | 5.5 | - | - | - | - | - |
| | F-6 | - | - | - | - | - | - | - | - | - | - |
| Adhesive | G-1 | - | - | - | - | - | - | - | - | - | - |
| | G-2 | 0.74 | 0.74 | 0.74 | 0.74 | 0.74 | 0.74 | 0.74 | 0.74 | - | - |
| | G-3 | - | - | - | - | - | - | - | - | - | - |
| | G-4 | - | - | - | - | - | - | - | - | - | - |
| | G-5 | - | - | - | - | - | - | - | - | - | - |
| Polymerization inhibitor | H-1 | - | - | - | - | - | - | - | - | - | - |
| | H-2 | 0.05 | 0.05 | 0.05 | 0.05 | 0.05 | 0.05 | 0.05 | 0.05 | - | - |
| | H-3 | - | - | - | - | - | - | - | - | - | - |
| Photopolymerization initiator | I-1 | - | - | - | - | - | - | - | - | - | - |
| | I-2 | - | - | - | - | - | - | - | - | - | - |
| | I-3 | 1.3 | - | - | - | - | 1.3 | - | 1.3 | - | 1.5 |
| | I-4 | - | - | - | - | - | - | - | - | - | - |
| | I-5 | - | 1.3 | - | - | - | - | - | - | - | - |
| | I-6 | - | - | 1.3 | - | - | - | - | - | - | - |
| | I-7 | - | - | - | - | - | - | - | - | - | - |
| Photoacid generator | J-1 | - | - | - | 1.3 | - | - | - | - | - | - |
| | J-2 | - | - | - | - | 1.3 | - | - | - | - | - |

(continued)

| | | Example | | | | | | | | Comparative Example | |
|---|---|---|---|---|---|---|---|---|---|---|---|
| | | 37 | 38 | 39 | 40 | 41 | 42 | 43 | 44 | 1 | 2 |
| Photobase generator | K-1 | - | - | - | - | - | - | - | - | 2.5 | 2.5 |
| | K-2 | - | - | 2.5 | - | - | - | - | - | - | - |
| | K-3 | - | - | - | 2.5 | 2.5 | - | - | - | - | - |
| | K-4 | 2.5 | 2.5 | - | - | - | 2.5 | 2.5 | 2.5 | - | - |
| | K-5 | - | - | - | - | - | - | - | - | - | - |
| | K-6 | - | - | - | - | - | - | - | - | - | - |
| | K-7 | - | - | - | - | - | - | - | - | - | - |
| | K-8 | - | - | - | - | - | - | - | - | - | - |
| | K-9 | - | - | - | - | - | - | - | - | - | - |
| Thermal base generator | L-1 | - | 1.0 | - | - | - | - | - | - | - | - |
| Other additives | M-1 | - | - | - | - | - | - | - | - | - | - |
| | M-2 | - | - | - | - | - | - | - | - | - | - |
| | M-3 | - | - | - | - | - | | 6.0 | | | |
| | M-4 | 0.2 | 0.2 | 0.2 | 0.2 | 0.2 | - | | - | - | - |
| | M-5 | - | - | - | - | - | - | - | - | - | - |
| | M-6 | - | - | - | - | - | - | - | 0.2 | - | - |
| Solvent | S-1 | - | - | - | - | - | - | - | - | - | - |
| | S-2 | - | - | - | - | - | - | - | - | - | - |
| | S-3 | 44.5 | 44.5 | 44.5 | 44.5 | 44.5 | 44.5 | 44.5 | 44.5 | - | - |
| | S-4 | 11.1 | 11.1 | 11.1 | 11.1 | 11.1 | 11.1 | 11.1 | 11.1 | - | - |
| | S-5 | - | - | - | - | - | - | - | - | 90.0 | 86.0 |

Details of each of the components listed in Table 1 to Table 4 are as follows.

[Resin]

• A-1, B-1, A-2, B-2, and C to E: Polymer A-1, polymer B-1, polymer A-2, polymer B-2, and polymers C to E, respectively synthesized in Synthesis Examples described above

[Crosslinking Agent]

- F-1: Tetraethylene glycol dimethacrylate
- F-2: LIGHT ESTER BP-6EM (manufactured by Kyoeisha Chemical Co., Ltd.)
- F-3: LIGHT ESTER NP (manufactured by Kyoeisha Chemical Co., Ltd.)
- F-4: LIGHT ESTER 1.6HX (manufactured by Kyoeisha Chemical Co., Ltd.)
- F-5: Daicel CELLOXIDE CEL2081 (manufactured by Daicel Corporation)
- F-6: Hexamethoxymethylmelamine

[Adhesive (silane coupling agent)]

- G-1: N-[3-(triethoxysilyl)propyl]phthalamic acid
- G-2: N-[3-(triethoxysilyl)propyl]maleic acid
- G-3-3: γ-methacryloxypropyl trimethoxy silane
- G-4: 2-(3,4-epoxycyclohexyl)ethyltrimethoxysilane
- G-5: Compound represented by Formula (G-5) In Formula (G-5), R represents an ethyl group.

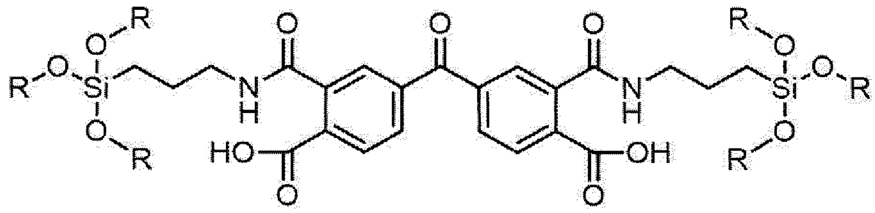

(G-5)

[Polymerization inhibitor]

- H-1: p-benzoquinone
- H-2: 4-methoxyphenol
- H-3: 2-nitroso-1-naphthol

[Photopolymerization initiator (photosensitive compound)]

- I-1: 1-phenyl-1,2-propanedione-2-(O-ethoxycarbonyl)-oxime (maximal absorption wavelength: 365 nm)
- 1-2: NCI 831 (maximal absorption wavelength: 365 nm) (manufactured by ADEKA

CORPORATION)

- 1-3: IRGACURE OXE01 (maximal absorption wavelength: 365 nm) (manufactured by BASF SE)
- 1-4: IRGACURE OXE02 (maximal absorption wavelength: 365 nm) (manufactured by BASF SE)
- 1-5: IRGACURE 784 (maximal absorption wavelength: 405 nm) (manufactured by BASF SE)
- 1-6: Omnirad 2959 (maximal absorption wavelength: 254 nm) (manufactured by BASF SE)
- 1-7: Omnirad 1173 (maximal absorption wavelength: 254 nm) (manufactured by BASF SE)

[Photoacid generator (photosensitive compound)]

- J-1: WPAG-145 (maximal absorption wavelength: 216 nm) (manufactured by FUJIFILM Wako Pure Chemical Corporation)
- J-2: WPAG-170 (maximal absorption wavelength: 214 nm) (manufactured by FUJIFILM Wako Pure Chemical Corporation)

[Photobase generator (photosensitive compound)]

- K-1: {[(4,5-dimethoxy-2-nitrobenzyl)oxy]carbonyl}-2,6-dimethylpiperidine (maximal absorption wavelength: 365 nm)
- K-2: WPBG-018 (maximal absorption wavelength: 365 nm) (manufactured by FUJIFILM Wako Pure Chemical Corporation)
- K-3: WPBG-140 (maximal absorption wavelength: 365 nm) (manufactured by FUJIFILM Wako Pure Chemical Corporation)

- K-4: WPBG-027 (maximal absorption wavelength: about 254 nm) (manufactured by FUJIFILM Wako Pure Chemical Corporation)
- K-5: WPBG-165 (maximal absorption wavelength: about 254 nm) (manufactured by FUJIFILM Wako Pure Chemical Corporation)
- K-6: WPBG-266 (maximal absorption wavelength: about 254 nm) (manufactured by FUJIFILM Wako Pure Chemical Corporation)
- K-7: WPBG-300 (maximal absorption wavelength: about 254 nm) (manufactured by FUJIFILM Wako Pure Chemical Corporation)
- K-8: WPBG-345 (maximal absorption wavelength: about 254 nm) (manufactured by FUJIFILM Wako Pure Chemical Corporation)
- K-9: O0396 (maximal absorption wavelength: 365 nm) (manufactured by Tokyo Chemical Industry Co., Ltd.)

<Thermal-base generator>

- L-1: N-cyclohexyl-N,N-dimethyl-N-phenacylammonium maleate

[Other Additives]

- M-1: 7-diethylamino-3-ethoxycarbonylcoumarin
- M-2: N-phenyldiethanolamine
- M-3: 2,3,4-tris(1-oxo-2-diazonaphthoquinon-4-ylsulfonyloxy)benzophenone
- •M-4: 1H-tetrazole
- M-5: Compound represented by Formula (M-5)
- M-6: 5-amino-1H-tetrazole

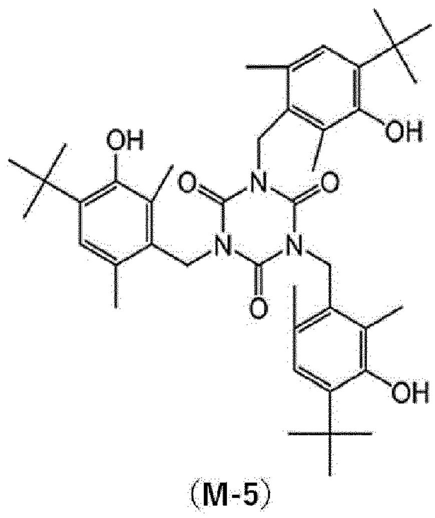

(M-5)

[Solvent]

- S-1: N-methylpyrrolidone
- •S-2: Ethyl lactate
- •S-3: γ-Butyrolactone
- •S-4: dimethyl sulfoxide
- •S-5: N,N-dimethylacetamide

<Evaluation>

[Evaluation of exposure sensitivity]

- Formation of photocurable film -

Each photocurable resin composition or comparative composition in each Example and Comparative Example was applied in a layer shape onto a silicon wafer (used for coating) by a spin coating method to form a resin composition film.

In each Example and Comparative Example, a silicon wafer onto which the obtained resin composition film was applied was dried on a hot plate at 100°C for 2 minutes, and a photocurable film having a thickness shown in the column of "Film thickness (μm)" in Table 5 or Table 6 was formed on the silicon wafer.

- First exposure step -

The first exposure step was carried out on the photocurable film by the following method.

In the example described as "K" in the column of "Light source" of "First exposure step" in Table 5 or Table 6, the photocurable film was exposed using a KrF excimer laser having a wavelength of 248 nm.

In the example described as "i" in the column of "Light source" of "First exposure step" in Table 5 or Table 6, a high-pressure mercury lamp in which wavelengths other than the wavelength of 365 nm (the i-line) are cut out by a bandpass filter was used to expose the photocurable film.

In the example described as "h" in the column of "Light source" of "First exposure step" in Table 5 or Table 6, a high-pressure mercury lamp in which wavelengths other than the wavelength of 405 nm (the h-line) are cut out by a bandpass filter was used to expose the photocurable film.

All of the above exposures were carried out through a binary mask on which a 1:1 line and space pattern having a line width of 10 μm was formed.

Further, in the evaluation of the exposure sensitivity, the exposure amount described in the column of "Exposure amount (mJ/$cm^2$)" of "First exposure step" in Table 5 or Table 6 was not taken as the exposure amount, but the exposure was carried out at a total of 10 points with an interval of 10 mJ/$cm^2$ from 10 to 100 mJ/$cm^2$.

- Development step -

The photocurable film after the first exposure step was subjected to a development step by the following method.

After the above exposure, in the example described as "A1" in the column of "Developer" of "Development step", the photocurable film after exposure was developed with a developer (40°C) obtained by mixing isopropanol (IPA) with a 3% by mass trimethylammonium hydroxide aqueous solution (TMAHaq) at a mass ratio of IPA:TMAHaq = 10:90, and rinsed with pure water for 30 seconds to obtain a developed pattern. The above development was carried out by carrying out ultrasonic treatment for 8 minutes while immersing the photocurable film in the above-described developer.

After the above exposure, in the column described as "S" in the column of "Developer" of "Development step", the photocurable film after exposure was developed using cyclopentanone (25°C) and rinsed with propylene glycol methyl ether acetate (PGMEA) for 30 seconds to obtain a developed pattern. The above development was carried out by spray development for 5 minutes.

After the above exposure, in the column described as "A2" in the column of "Developer" of "Development step", the photocurable film after exposure was developed using a 3% by mass trimethylammonium hydroxide aqueous solution (25°C) and rinsed with pure water for 30 seconds to obtain a developed pattern. The above development was carried out by spray development for 5 minutes.

- Second exposure step -

The photocurable film after the development step was subjected to a second exposure step by the following method.

After the above development, in the example described as "i" in the column of "Light source" of "Second exposure step" in Table 5 or Table 6, a high-pressure mercury lamp in which wavelengths other than the wavelength of 365 nm (the i-line) are cut out by a bandpass filter was used to subject the developed pattern to entire surface exposure. The temperature at the time of exposure was the temperature described in the column of "Temperature at time of exposure (°C)" of "Second exposure step" in Table 5 or 6. The exposure amount was the exposure amount described in the column of "Exposure amount (J/$cm^2$)" of "Second exposure step".

After the above development, in the example described as "B" in the column of "Light source" of "Second

exposure step" in Table 5 or Table 6, a high-pressure mercury lamp was used without using the bandpass filter, and the above developed pattern was subjected to entire surface exposure. The temperature at the time of exposure was the temperature described in the column of "Temperature at time of exposure (°C)" of "Second exposure step" in Table 5 or 6. The exposure amount was the exposure amount described in the column of "Exposure amount ($J/cm^2$)" of "Second exposure step".

After the above development, exposure was not carried out in the example described as "-" in the column of "Light source" of "Second exposure step" in Table 5 or Table 6.

- Heating step -

The pattern after the second exposure step was heated by the following method.

After the second exposure step, in the example described as "-" in the column of "Temperature (°C)" of "Heating step" in Table 5 or Table 6, no heating was carried out, and the developed pattern after the second exposure step was used as a pattern.

After the second exposure step, in the example in which the numerical value was described in the column of "Temperature (°C)" of "Heating step" in Table 5 or Table 6, the developed pattern after the second exposure step was heated at the temperature described in the column of "Temperature (°C)" of Heating step" for the time described in the column of "Time (min)" of "Heating step", and this developed pattern after the second exposure step was used as a pattern.

- Evaluation -

In each Example or Comparative Example, each of the patterns obtained by setting the exposure amount in the first exposure step to 20 $mJ/cm^2$ or 100 $mJ/cm^2$ was observed with an optical microscope and evaluated according to the following evaluation standards. The evaluation results are described in the column of "Evaluation of exposure sensitivity" in Table 5 or Table 6. It can be said that the smaller the exposure amount, the better the exposure sensitivity.

«Evaluation standard»

A: In a case where the exposure amount in the first exposure step was 10 $mJ/cm^2$ or 20 $mJ/cm^2$, the line and space pattern was formed with an exposure amount of at least one point.

B: In a case where the exposure amount in the first exposure step was 20 $mJ/cm^2$ or less, the line and space pattern was not formed; however, in a case where the exposure amount was 30 $mJ/cm^2$ or 100 $mJ/cm^2$, a line and space pattern was formed with an exposure amount of at least one point.

C: No line and space pattern was formed in a case where the exposure amount in the first exposure step was any of the above 10 $mJ/cm^2$ to 100 $mJ/cm^2$.

<Evaluation of chemical resistance>

- Formation of photocurable film -

In each Example and Comparative Example, a photocurable resin composition or a comparative composition was used to form a photocurable film by the same method as "Formation of photocurable film" in "Evaluation of exposure sensitivity" described above.

- First exposure step -

The photocurable film was subjected to the first exposure step by the same method as the first exposure step in "Evaluation of exposure sensitivity" described above, except that in each Example and Comparative Example, the entire surface exposure was carried out without using a mask, and the exposure amount was an exposure amount in the column of "Exposure amount ($mJ/cm^2$)" of "First exposure step" in Table 5 or Table 6.

- Second exposure step -

In each Example and Comparative Example, the photocurable film after the first exposure step was subjected to the second exposure step by the same method as the second exposure step in "Evaluation of exposure sensitivity"

described above.

The second exposure step was not carried out in the example described as "-" in the column of "Light source" of "Second exposure step" in Table 5 or Table 6.

In addition, in the evaluation of chemical resistance, development was not carried out in order to simplify the evaluation.

- Heating step -

In each Example and Comparative Example, in the example in which the numerical value was described in the column of "Temperature (°C)" of "Heating step" in Table 5 or Table 6, the photocurable film after the second exposure step was subjected to the heating step by the same method as the heating in "Evaluation of exposure sensitivity" described above, thereby obtaining a resin film.

In the example described as "-" in the column of "Temperature (°C)" of "Heating step" in Table 5 or Table 6, the heating step was not carried out, and the photocurable film after the second exposure step was used as a resin film.

- Evaluation -

The obtained resin layer was immersed in the following chemical liquid under the following conditions, and the dissolution rate was calculated.

Chemical liquid: 3% by mass tetramethylammonium hydroxide (TMAH) aqueous solution Evaluation conditions: The resin layer was immersed in the chemical liquid at 80°C for 15 minutes, the film thicknesses before and after the immersion were compared, and the rate (%) of change in film thickness was calculated according to the following expression.

Rate (%) of change in film thickness = (film thickness of resin layer before immersion - film thickness of resin layer after immersion)/film thickness of resin layer before immersion × 100

The evaluation was carried out according to the following evaluation standards, and the evaluation results are described in the column of "Evaluation of chemical resistance" of Table 5 or Table 6. It can be said that the smaller the rate of change in film thickness, the better the chemical resistance.

«Evaluation standard»

A: The rate of change in film thickness was less than 20%.
B: The rate of change in film thickness was 20% or more and less than 50%.
C: The rate of change in film thickness (%) was 50% or more.

[Evaluation of film shrinkage rate]

- Formation of photocurable film -

In each Example and Comparative Example, a photocurable resin composition or a comparative composition was used to form a photocurable film by the same method as "Formation of photocurable film" in "Evaluation of exposure sensitivity" described above.

- First exposure step -

The photocurable film was subjected to the first exposure step by the same method as the first exposure step in "Evaluation of exposure sensitivity" described above except that in each Example and Comparative Example, the exposure amount was an exposure amount in the column of "Exposure amount ($mJ/cm^2$)" of "First exposure step" in Table 5 or Table 6.

- Development step -

In each Example and Comparative Example, the photocurable film after the first exposure step was subjected to the development step by the same method as the development step in "Evaluation of exposure sensitivity" described above, thereby obtaining a developed pattern.

- Second exposure step -

In each Example and Comparative Example, the photocurable film after the development step was subjected to the second exposure step by the same method as the second exposure step in "Evaluation of exposure sensitivity" described above.
The second exposure step was not carried out in the example described as "-" in the column of "Light source" of "Second exposure step" in Table 5 or Table 6.

- Heating step -

In each Example and Comparative Example, in the example in which the numerical value was described in the column of "Temperature (°C)" of "Heating step" in Table 5 or Table 6, the photocurable film after the second exposure step was subjected to the heating step by the same method as the heating in "Evaluation of exposure sensitivity" described above, thereby obtaining a pattern.
In the example described as "-" in the column of "Temperature (°C)" of "Heating step" in Table 5 or Table 6, the heating step was not carried out, and the photocurable film after the second exposure step was used as a pattern.

- Evaluation -

Each of the film thickness (μm) of the developed pattern and the film thickness (μm) of the obtained pattern was measured, and the shrinkage rate was calculated according to the following expression.

$$\text{Shrinkage rate (\%)} = (\text{film thickness } (\mu m) \text{ of developed pattern} - \text{film thickness } (\mu m) \text{ of obtained pattern}) / \text{film thickness } (\mu m) \text{ of developed pattern} \times 100$$

The evaluation was carried out according to the following evaluation standards, and the evaluation results are described in the column of "Evaluation of film shrinkage rate" of Table 5 or Table 6. It can be said that the smaller the shrinkage rate (%) is, the more the pattern shrinkage with respect to the developed pattern is suppressed.

«Evaluation standard»

A: The shrinkage rate (%) was less than 10%.
B: The shrinkage rate (%) was 10% or more and less than 20%.
C: The shrinkage rate (%) was 20% or more.

[Evaluation of cyclization rate]

- Formation of photocurable film to heating step -

By the same method as "Evaluation of film shrinkage rate" described above, the formation of the photocurable film, the first exposure step, the development step, the second exposure step, and the heating step were carried out in order to obtain a pattern.

- Evaluation -

For each of the obtained patterns, the FTIR spectrum was measured, and the cyclization rate was calculated.
As an FTIR spectrum measuring device, an FT-210 manufactured by Horiba, Ltd. was used.
In the example using the polymer A-1, the polymer B-1, the polymer A-2, the polymer B-2, the polymer D, or

the polymer E as the resin, the C-N absorption (1376 $cm^{-1}$) of the imide group of the sample obtained by heating the photocurable film before the first exposure step used in each Example and Comparative Example at 350°C for 60 minutes was used as a reference. The heating was carried out on a hot plate. After the above measurement, the cyclization rate (%) was calculated according to the following expression.

Cyclization rate (%) = Peak intensity of peak present at 1376 $cm^{-1}$ in obtained pattern/peak intensity of peak present at 1376 $cm^{-1}$ in sample obtained by heating at 350°C for 60 minutes × 100

In the example in which the polymer C was used as a resin, the absorption peak (1,554 $cm^{-1}$) of the benzoxazole ring of the sample obtained by heating the photocurable film before the first exposure step used in each Example and Comparative Example at 350°C for 60 minutes was used as a reference. The heating was carried out on a hot plate. After the above measurement, the cyclization rate (%) was calculated according to the following expression.

Cyclization rate (%) = Peak intensity of peak present at 1,554 $cm^{-1}$ in obtained pattern/peak intensity of peak present at 1,554 $cm^{-1}$ in sample obtained by heating at 350°C for 60 minutes × 100

The evaluation was carried out according to the following evaluation standards, and the evaluation results are described in the column of "Evaluation of cyclization rate" of Table 5 or Table 6. It can be said that the larger the cyclization rate (%) is, the more the cyclization has progressed.

«Evaluation standard»

A: The cyclization rate (%) was 95% or more.

B: The cyclization rate (%) was 70% or more and less than 95%.

C: The cyclization rate (%) was less than 70%.

[Table 5]

| | | Example | | | | | | | | | | | | | | | | | | | | | | |
|---|---|---|---|---|---|---|---|---|---|---|---|---|---|---|---|---|---|---|---|---|---|---|---|---|
| | | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 |
| Film thickness (μm) | | 2.4 | 15 | 15 | 15 | 15 | 15 | 15 | 15 | 15 | 15 | 15 | 15 | 15 | 15 | 15 | 15 | 15 | 15 | 15 | 15 | 15 | 15 | 15 |
| First exposure step | Light source | K | K | K | K | i | i | i | i | i | K | i | i | i | i | i | i | i | i | i | h | h | i | i |
| | Exposure amount ($mJ/cm^2$) | 1000 | 400 | 400 | 400 | 400 | 400 | 400 | 400 | 400 | 400 | 400 | 400 | 400 | 400 | 400 | 400 | 400 | 400 | 400 | 400 | 400 | 400 | 400 |
| Development step | Developer | A1 | S | S | S | S | S | S | S | S | S | S | S | S | S | S | S | S | S | S | S | S | S | S |
| Second exposure step | Light source | i | i | i | i | B | B | B | B | B | i | B | B | B | B | B | B | B | B | B | i | i | B | B |
| | Temperature at time of exposure (°C) | 50 | 50 | 50 | 50 | 50 | 50 | 50 | 50 | 50 | 50 | 50 | 50 | 50 | 50 | 50 | 50 | 100 | 50 | 50 | 50 | 50 | 50 | 50 |
| | Exposure amount($J/cm^2$) | 10 | 10 | 10 | 10 | 10 | 10 | 10 | 10 | 10 | 10 | 10 | 10 | 10 | 10 | 10 | 10 | 10 | 10 | 10 | 10 | 10 | 10 | 10 |
| Heating step | Temperature (°C) | - | - | - | - | - | - | - | - | - | - | - | - | - | - | - | - | - | - | - | - | - | - | - |
| | Time (min) | - | - | - | - | - | - | - | - | - | - | - | - | - | - | - | - | - | - | - | - | - | - | - |
| Evaluation of exposure sensitivity | | A | A | A | A | A | A | A | A | A | A | A | A | A | A | A | A | A | B | B | A | A | A | A |
| Evaluation of chemical resistance | | B | B | B | B | B | B | B | A | A | A | A | A | A | A | B | B | A | A | A | A | A | A | B |
| Evaluation of film shrinkage rate | | A | A | A | A | A | A | A | A | A | A | B | B | B | B | B | B | B | A | A | B | B | B | A |
| Evaluation of cyclization rate | | A | A | A | A | A | A | A | A | A | A | A | A | A | A | A | A | A | A | A | A | A | A | A |

[Table 6]

| | | Example | | | | | | | | | | | | | | | | | | | | | Comparative Example | |
|---|---|---|---|---|---|---|---|---|---|---|---|---|---|---|---|---|---|---|---|---|---|---|---|---|
| | | 24 | 25 | 26 | 27 | 28 | 29 | 30 | 31 | 32 | 33 | 34 | 35 | 36 | 37 | 38 | 39 | 40 | 41 | 42 | 43 | 44 | 1 | 2 |
| Film thickness (μm) | | 15 | 15 | 15 | 15 | 15 | 15 | 15 | 15 | 15 | 15 | 15 | 15 | 15 | 15 | 15 | 15 | 15 | 15 | 15 | 15 | 15 | 2.4 | 2.4 |
| First exposure step | Light source | i | i | i | i | i | i | i | i | i | i | i | i | i | i | h | i | K | K | i | i | i | i | i |
| | Exposure amount ($mJ/cm^2$) | 400 | 400 | 400 | 400 | 400 | 400 | 400 | 400 | 400 | 400 | 400 | 400 | 400 | 400 | 400 | 400 | 400 | 400 | 400 | 400 | 400 | 1000 | 1000 |
| Development step | Developer | S | S | S | S | S | S | S | S | S | S | S | S | S | S | S | S | S | S | S | A2 | S | A1 | A1 |
| Second exposure step | Light source | B | B | B | B | B | B | B | B | B | B | B | B | B | B | B | B | B | B | B | B | B | - | - |
| | Temperature at time of exposure (°C) | 50 | 50 | 50 | 50 | 50 | 50 | 50 | 50 | 50 | 50 | 50 | 50 | 50 | 50 | 50 | 50 | 50 | 50 | 50 | 50 | 50 | - | - |
| | Exposure amount ($J/cm^2$) | 10 | 10 | 10 | 10 | 10 | 10 | 10 | 10 | 10 | 10 | 10 | 10 | 10 | 10 | 10 | 10 | 10 | 10 | 10 | 10 | 10 | - | - |
| Heating step | Temperature (°C) | - | - | - | - | - | - | - | - | - | - | - | - | 150 | 200 | - | - | - | - | - | - | - | 200 | 200 |
| | Time (min) | - | - | - | - | - | - | - | - | - | - | - | - | 10 | 10 | - | - | - | - | - | - | - | 10 | 10 |
| Evaluation of exposure sensitivity | | A | A | A | A | A | A | A | A | A | A | A | A | A | A | A | B | B | B | B | B | A | C | B |
| Evaluation of chemical resistance | | B | B | B | B | A | A | B | B | B | A | A | A | A | A | B | B | A | A | B | B | B | C | C |
| Evaluation of film shrinkage rate | | A | A | A | A | A | A | A | A | A | B | B | B | B | B | A | A | A | A | B | A | A | C | C |
| Evaluation of cyclization rate | | A | A | A | A | A | A | A | A | A | A | A | A | A | A | A | A | A | A | A | A | A | B | C |

From the above results, it can be seen that according to the pattern forming method according to the embodiment of the present invention, a pattern, in which the shrinkage of the film thickness is suppressed as compared with Comparative Example 1 or Comparative Example 2 in which cyclization is carried out by heating without carrying out the second exposure step, is formed.

<Example 101>

The photocurable resin composition used in Example 2 was applied in a layer shape onto a surface of a thin copper layer of the resin base material on the surface of which the thin copper layer was formed, by a spin coating method, dried at 100°C for 2 minutes, and after forming a photocurable film having a thickness of 15 μm, exposure was carried out at an exposure amount of 400 $mJ/cm^2$ with a high-pressure mercury lamp in which wavelengths other than the wavelength of 365 nm (the i-line) were cut out by a filter. Exposure was carried out through a mask (a binary mask in which the pattern is a pattern of 1: 1 line and space and the line width is 10 μm). After exposure, development using cyclopentanone at 25°C was carried out for 60 seconds, and rinsing with PGMEA was carried out for 20 seconds to obtain a pattern.

Next, using a high-pressure mercury lamp, the entire surface was subjected to exposure with an exposure amount of 10 $J/cm^2$ and cured to form an interlayer insulating film for a re-distribution layer. This interlayer insulating film for a re-distribution layer was excellent in insulating properties.

Further, in a case where an electronic device was manufactured using this interlayer insulating film for a re-distribution layer, it has been confirmed that the electronic device operates without any problem.

## Claims

**1.** A pattern forming method comprising:

a first exposure step of exposing a part of a photocurable film formed from a photocurable resin composition;
a development step of developing the photocurable film after the exposure with a developer to obtain a developed pattern; and
a second exposure step of exposing the developed pattern to obtain a pattern,
wherein the photocurable resin composition contains
at least one resin selected from the group consisting of a polyimide precursor and a polybenzoxazole precursor,
a photosensitive compound A having sensitivity to an exposure wavelength in the first exposure step, and
a photosensitive compound B having sensitivity to an exposure wavelength in the second exposure step,
where the photosensitive compound A is a compound that changes a solubility of the photocurable film in the developer in the first exposure step, and at least one in the group consisting of the photosensitive compound A and the photosensitive compound B is a photobase generator.

**2.** The pattern forming method according to claim 1,
wherein the photosensitive compound A is a compound that generates a radical in the first exposure step.

**3.** The pattern forming method according to claim 1 or 2,
wherein the photosensitive compound A is a compound that generates an acid in the first exposure step.

**4.** The pattern forming method according to any one of claims 1 to 3,
wherein the photosensitive compound B is a compound that generates a base in the second exposure step.

**5.** The pattern forming method according to any one of claims 1 to 4,
wherein the second exposure step includes exposure with light including light having a wavelength different from a wavelength of light used in the first exposure step.

**6.** The pattern forming method according to any one of claims 1 to 5,
wherein a temperature in the second exposure step is 50°C to 200°C.

**7.** A photocurable resin composition, wherein the photocurable resin composition is used in the pattern forming method according to any one of claims 1 to 6.

**8.** A photocurable resin composition comprising:

at least one resin selected from the group consisting of a polyimide precursor and a polybenzoxazole precursor;
a photosensitive compound A; and
a photosensitive compound B,
wherein the photosensitive compound A is a compound capable of changing a solubility of the resin by photosensitization,
at least one in the group consisting of the photosensitive compound A and the photosensitive compound B is a photobase generator, and
a difference between a maximal absorption wavelength of the photosensitive compound A and a maximal absorption wavelength of the photosensitive compound B is 100 nm or more.

**9.** A method of manufacturing a laminate, comprising the pattern forming method according to any one of claims 1 to 6.

**10.** A method of manufacturing an electronic device, comprising:

the pattern forming method according to any one of claims 1 to 6; or
the method of manufacturing a laminate according to claim 9.

## INTERNATIONAL SEARCH REPORT

International application No. PCT/JP2020/043021

A. CLASSIFICATION OF SUBJECT MATTER

G03F 7/004(2006.01)i; G03F 7/027(2006.01)i; G03F 7/028(2006.01)i; G03F 7/038(2006.01)i; G03F 7/20(2006.01)i; G03F 7/40(2006.01)i

FI: G03F7/40 501; G03F7/038 504; G03F7/038; G03F7/004 503; G03F7/028; G03F7/20 521; G03F7/027 514

According to International Patent Classification (IPC) or to both national classification and IPC

B. FIELDS SEARCHED

Minimum documentation searched (classification system followed by classification symbols)

G03F7/004; G03F7/027; G03F7/028; G03F7/038; G03F7/20; G03F7/40

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2018-92062 A (TOPPAN PRINTING CO., LTD.) 14 June 2018 (2018-06-14) claims | 1-10 |
| A | WO 2018/123836 A1 (FUJIFILM CORPORATION) 05 July 2018 (2018-07-05) claims, example 1, etc. | 1-10 |
| A | WO 2019/146778 A1 (FUJIFILM CORPORATION) 01 August 2019 (2019-08-01) claims, example 1, etc. | 1-10 |
| A | JP 2010-211109 A (ASAHI KASEI E-MATERIALS CORP.) 24 September 2010 (2010-09-24) claims | 1-10 |

☐ Further documents are listed in the continuation of Box C.

☒ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 07 January 2021 (07.01.2021) | 26 January 2021 (26.01.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2020/043021

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:
See extra sheet

1. ☐ As all required additional search fees were timely paid by the applicant, this international search report covers all searchable claims.
2. ☒ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (January 2015)

**INTERNATIONAL SEARCH REPORT**
Information on patent family members

International application No.
PCT/JP2020/043021

| Patent Documents referred in the Report | Publication Date | Patent Family | Publication Date |
|---|---|---|---|
| JP 2018-92062 A | 14 Jun. 2018 | (Family: none) | |
| WO 2018/123836 A1 | 05 Jul. 2018 | TW 201833182 A | |
| WO 2019/146778 A1 | 01 Aug. 2019 | TW 201937284 A | |
| JP 2010-211109 A | 24 Sep. 2010 | (Family: none) | |

Form PCT/ISA/210 (patent family annex) (January 2015)

**INTERNATIONAL SEARCH REPORT**

International application No.
PCT/JP2020/043021

<Continuation of Box No. III>

(Invention 1) Claims 1-7 and 9-10

Claims 1-7 have the special technical feature of the pattern forming method set forth in claim 1, and are thus classified as invention 1.

(Invention 2) Claim 8

Claim 8 shares, with claim 1 classified as invention 1, the common technical feature of a "photocurable resin composition comprising: at least one resin selected from the group consisting of a polyimide precursor and a polybenzoxazole precursor; a photosensitive compound A; and a photosensitive compound B, wherein the photosensitive compound A is a compound capable of changing the solubility of the resin by exposure, at least one selected from the group consisting of the photosensitive compound A and the photosensitive compound B is a photobase generator, and the difference between the maximum absorption wavelength of the photosensitive compound A and the maximum absorption wavelength of the photosensitive compound B is at least 100 nm".

However, said technical feature does not make a contribution over the prior art in light of the disclosures of documents 1-3, and thus cannot be said to be a special technical feature. Moreover, there do not exist other identical or corresponding special technical features between these inventions.

Further, claim 8 is not dependent on claim 1. Furthermore, claim 8 is not substantially identical or equivalent to any of the claims classified as invention 1.

Therefore, claim 8 cannot be classified as invention 1.

In addition, claim 8 has the special technical feature of the photocurable resin composition set forth in claim 8, and is thus classified as invention 2.

Document 1: JP 2018-92062 A (TOPPAN PRINTING CO., LTD.) 14 June 2018 (2018-06-14) claims (Family: none)

Document 2: WO 2018/123836 A1 (FUJIFILM CORPORATION) 05 July 2018 (2018-07-05) claims, example 1, etc. & TW 201833182 A

Document 3: WO 2019/146778 A1 (FUJIFILM CORPORATION) 01 August 2019 (2019-08-01) claims, example 1, etc. & TW 201937284 A

Form PCT/ISA/210 (extra sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006189591 A
- JP 2006023696 A
- JP 2006047592 A
- US 9159547 B
- JP 2007157879 A
- JP 2001521288 A
- JP 2004214501 A
- JP 2004101850 A
- JP 2016027357 A
- WO 2017038598 A
- WO 2015199219 A
- JP 2015087611 A
- JP 10291969 A
- JP H10291969 A
- JP 4225898 B
- JP 2009191179 A
- JP 2001233842 A
- JP 2000080068 A
- JP 2006342166 A
- JP 2012014052 A
- JP 2010262028 A
- JP 2014500852 A
- JP 2013164471 A
- JP 2007269779 A
- JP 2009191061 A
- WO 2015125469 A
- JP 2008013646 A
- JP 2009080452 A
- WO 2009123122 A
- JP 2008247747 A
- JP 2007249013 A
- JP 2008003581 A
- JP 2012093746 A
- JP 2013194205 A
- JP 2013204019 A
- WO 2010064631 A
- JP 48041708 B
- JP S48041708 B
- JP 50006034 B
- JP S50006034 B
- JP 51037193 A
- JP S51037193 A
- JP 48064183 A
- JP S48064183 A
- JP 49043191 B
- JP S49043191 B
- JP 52030490 B
- JP S52030490 B
- JP 2008292970 A
- JP 2010160418 A
- JP 2010129825 A
- JP 4364216 B
- JP 46043946 B
- JP S46043946 B
- JP 1040337 B
- JP H01040337 B
- JP 1040336 B
- JP H01040336 B
- JP 2025493 A
- JP H02025493 A
- JP 61022048 A
- JP S61022048 A
- JP 2015034964 A
- JP 10062986 A
- JP H10062986 A
- JP 2015187211 A
- JP 2032293 B
- JP H02032293 B
- JP 2016765 B
- JP H02016765 B
- JP 58049860 B
- JP S58049860 B
- JP 56017654 B
- JP S56017654 B
- JP 62039417 B
- JP S62039417 B
- JP 62039418 B
- JP S62039418 B
- JP 63277653 A
- JP S63277653 A
- JP 63260909 A
- JP S63260909 A
- JP 1105238 A
- JP H01105238 A
- JP 2008063554 A
- JP 2013072935 A
- JP 2013167742 A
- WO 2018043262 A
- JP 2013015701 A
- JP 2009283711 A
- JP 2011059656 A
- JP 2012194520 A
- JP 2015127817 A
- JP 2014191002 A
- WO 2011080992 A
- JP 2014191252 A
- JP 2014041264 A

- WO 2014097594 A
- JP 2011128358 A
- JP 2014186186 A
- JP 2012003225 A
- US 20130034812 A
- JP 2008250074 A
- JP 2015117327 A
- JP 2011132503 A
- JP 2011089090 A
- JP 2010164965 A
- JP 6268967 B
- WO 2014021023 A
- WO 2017030005 A
- JP 2017008219 A
- JP 2015123351 A

**Non-patent literature cited in the description**


- High functionality and applied technology of polyimide. Science & Technology Co., Ltd, April 2008
- **MASAAKI KAKIMOTO.** Basics and development of polyimide materials. CMC Technical library, November 2011
- Latest Polyimide Basics and Applications. Japan Polyimide & Aromatic Polymers Study Group, NTS Inc, August 2010
- **M. SHIRAI ; M. TSUNOOKA.** *Prog. Polym. Sci.,* 1996, vol. 21, 1
- **MASAHIRO TSUNOOKA.** *Polymer application,* 1997, vol. 46, 2
- **C. KUTAL.** *Coord. Chem. Rev.,* 2001, vol. 211, 353
- **Y. KANEKO ; A. SARKER ; D. NECKERS.** *Chem. Mater.,* 1999, vol. 11, 170
- **H. TACHI ; M. SHIRAI ; M. TSUNOOKA.** *J. Photopolym. Sci. Technol.,* 2000, vol. 13, 153
- **M. WINKLE ; K. GRAZIANO.** *J. Photopolym. Sci. Technol.,* 1990, vol. 3, 419
- **M. TSUNOOKA ; H. TACHI ; S. YOSHITAKA.** *J. Photopolym. Sci. Technol,* 1996, vol. 9, 13
- **K. SUYAMA ; H. ARAKI ; M. SHIRAI.** *J. Photopolym. Sci. Technol,* 2006, vol. 19, 81
- **BROWN, H. C ; MCDANIEL, D. H. ; HAFLIGER, O. ; NACHOD, F. C.** Determination of Organic Structures. Academic Press, 1955
- **DAWSON, R. M. C. et al.** Data for Biochemical Research. Clarendon Press, 1959
- *Journal of the Adhesion Society of Japan,* 1984, vol. 20 (7), 300-308
- Polymer Dictionary. The Society of Polymer Science, 2005, 683-684
- **H SEINO et al.** Polym. Chem. *J. Polym. Sci.,* 1998, vol. 36, 2261